# EUROPEAN PATENT APPLICATION

(11) **EP 4 836 630 A1**
(43) Date of publication of application: **04.11.2026**
(21) Application number: 24913119.4
(22) Date of filing: 27.12.2024
(51) Int. Cl.: H10D 30/66, H10D 12/00, H10D 62/10

(54) **SEMICONDUCTOR DEVICE**

(30) Priority: 27.12.2023 JP 2023221770
(71) Applicant: Rohm Co., Ltd., Kyoto-shi, Kyoto 615-8585 (JP)
(72) Inventor: MORI, Seigo, Kyoto-shi, Kyoto 615-8585 (JP); NAKANO, Yuki, Kyoto-shi, Kyoto 615-8585 (JP)
(74) Representative: Witte, Weller & Partner Patentanwälte mbB
(86) International application number: PCT/JP2024/046433
(87) International publication number: WO 2025/143233

(57) **Abstract**

A semiconductor device includes a chip having a main surface, and a gate structure of a trench electrode type formed in the main surface, wherein the gate structure includes a trench formed in the main surface, an insulating film including a first film portion that covers a wall surface of an inner portion of the trench, and a second film portion that covers a wall surface of an end portion of the trench and has a thickness greater than a thickness of the first film portion, and an embedded electrode embedded in the trench across the insulating film.

## Description

### Technical Field

The present application corresponds to Japanese Patent Application No. 2023-221770 filed on December 27, 2023 in the Japan Patent Office, and the entire disclosure of this application is incorporated herein by reference. The present disclosure relates to a semiconductor device.

### Background Art

Patent Literature 1 (US 2003/0227051 A1) discloses a semiconductor device including an active groove formed in a semiconductor layer of an n-type. An embedded region of a p-type is arranged on the bottom portion side of the active groove, and a gate electrode is arranged on the opening side of the active groove via a gate insulating film.

### Citation List

### Patent Literature

Patent Literature 1: United States Patent Application Publication No. 2003/0227051

### [Summary]

The present disclosure provides a semiconductor device having a novel layout.

The present disclosure provides a semiconductor device including a chip having a main surface, and a gate structure of a trench electrode type formed in the main surface, wherein the gate structure includes a trench formed in the main surface, an insulating film including a first film portion that covers a wall surface of an inner portion of the trench, and a second film portion that covers a wall surface of an end portion of the trench and has a thickness greater than a thickness of the first film portion, and an embedded electrode embedded in the trench across the insulating film.

The present disclosure provides a semiconductor device including a chip having a main surface, a gate structure of a trench electrode type formed in the main surface, and a surface insulating film including a first surface film portion that covers a periphery of the gate structure on the main surface, and a second surface film portion that covers a periphery of the first surface film portion on the main surface and has a thickness greater than a thickness of the first surface film portion.

The present disclosure provides a semiconductor device including a chip having a main surface, a gate structure of a trench electrode type formed in the main surface, a gate wiring electrically connected to an end portion of the gate structure on the main surface, an interlayer film having insulating properties and covering the gate structure and the gate wiring, a pad electrode arranged on the interlayer film and opposing the gate structure and the gate wiring across the interlayer film, a gate finger electrode arranged on the interlayer film at an interval from the pad electrode and opposing the gate wiring across the interlayer film, and a slit portion that is defined in a region between the pad electrode and the gate finger electrode and overlaps the main surface in a lamination direction.

The aforementioned as well as yet other objects, features, and effects will be made clear by a detailed description made with reference to the attached drawings.

### Brief Description of the Drawings

[FIG. 1] FIG. 1 is a plan view illustrating a semiconductor device according to a specific embodiment.
[FIG. 2] FIG. 2 is a sectional view taken along line II-II shown in FIG. 1.
[FIG. 3] FIG. 3 is a plan view illustrating a layout example of a first main surface.
[FIG. 4] FIG. 4 is an enlarged plan view illustrating one main portion of an active region.
[FIG. 5] FIG. 5 is a sectional view taken along line V-V shown in FIG. 4.
[FIG. 6] FIG. 6 is a sectional view taken along line VI-VI shown in FIG. 4.
[FIG. 7] FIG. 7 is a sectional view taken along line VII-VII shown in FIG. 4.
[FIG. 8] FIG. 8 is a cross-sectional view taken along line VIII-VIII illustrated in FIG. 4.
[FIG. 9] FIG. 9 is a cross-sectional view taken along line IX-IX illustrated in FIG. 4.
[FIG. 10] FIG. 10 is an enlarged cross-sectional view illustrating one main portion of the active region.
[FIG. 11] FIG. 11 is an enlarged cross-sectional view illustrating one main portion of the active region.
[FIG. 12] FIG. 12 is a cross-sectional perspective view illustrating one main portion of the active region.
[FIG. 13] FIG. 13 is a cross-sectional perspective view illustrating one main portion of the active region.
[FIG. 14] FIG. 14 is a cross-sectional view illustrating an outer peripheral region.
[FIG. 15] FIG. 15 is a cross-sectional perspective view illustrating a first modification example of the semiconductor device.
[FIG. 16] FIG. 16 is a cross-sectional view illustrating a second modification example of the semiconductor device.
[FIG. 17] FIG. 17 is a cross-sectional view illustrating a third modification example of the semiconductor device.
[FIG. 18] FIG. 18 is a cross-sectional view illustrating a fourth modification example of the semiconductor device.
[FIG. 19] FIG. 19 is a cross-sectional view illustrating a fifth modification example of the semiconductor device.
[FIG. 20] FIG. 20 is a cross-sectional view illustrating a sixth modification example of the semiconductor device.

### [Detailed Description]

Hereinafter, specific embodiments shall be described in detail with reference to attached drawings. The attached drawings are all schematic views and are not strictly illustrated, and relative positional relationships, scales, proportions, angles and the like thereof do not always match. Identical reference signs are given to corresponding structures among the attached drawings, and duplicate descriptions thereof shall be omitted or simplified. For the structures whose description have been omitted or simplified, the description given before the omission or simplification shall apply.

In this specification, open languages such as "including" and "having" are described as concepts that encompass closed languages such as "consisting of." When the wording "substantially equal" is used in this description, the wording includes a numerical value (shape) equal to a numerical value (shape) of a comparison target and also includes numerical errors (shape errors) in a range of ±10% on a basis of the numerical value (shape) of the comparison target.

In this specification, although the wordings "first," "second," "third," and the like are used in the following description, these are symbols attached to names of respective structures in order to clarify the order of description and are not attached with an intention of restricting the names of the respective structures.

In the following description, a conductivity type of a semiconductor (an impurity) is indicated using "p-type" or "n-type" and the "p-type" may be referred to as a "first conductivity type" and the "n-type" may be referred to as a "second conductivity type." The "n-type" may be referred to as the "first conductivity type," and the "p-type" may be referred to as the "second conductivity type."

The "p-type" is a conductivity type due to a trivalent element and the "n-type" is a conductivity type due to a pentavalent element. The trivalent element is at least one type among boron, aluminum, gallium, and indium. The pentavalent element is at least one type among nitrogen, phosphorus, arsenic, antimony, and bismuth.

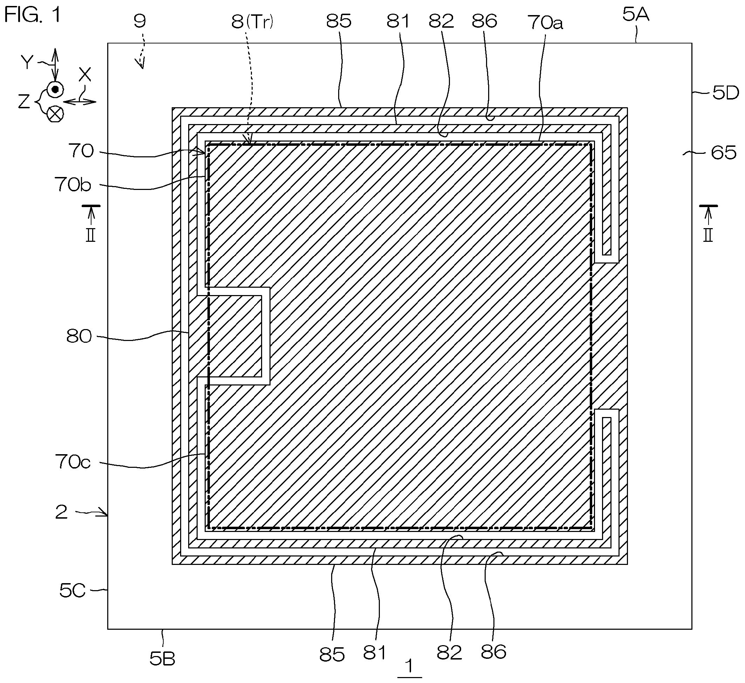

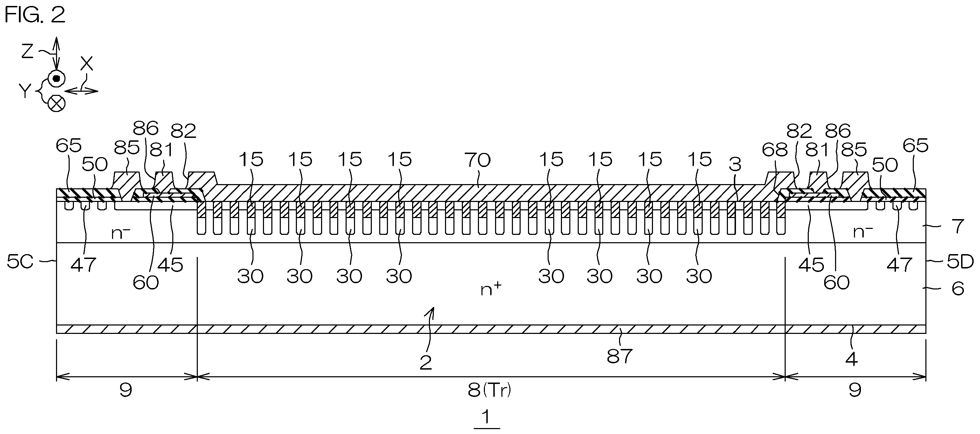

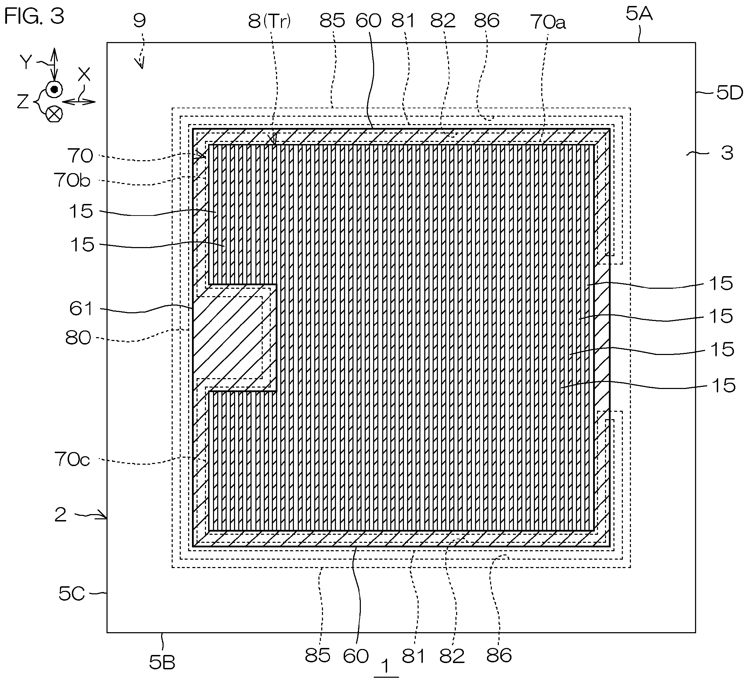

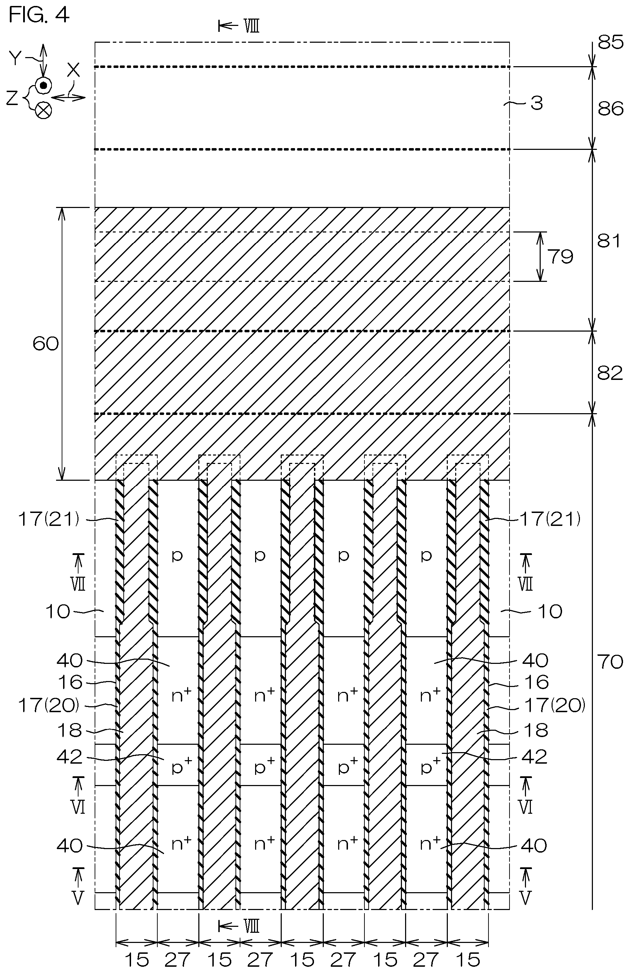

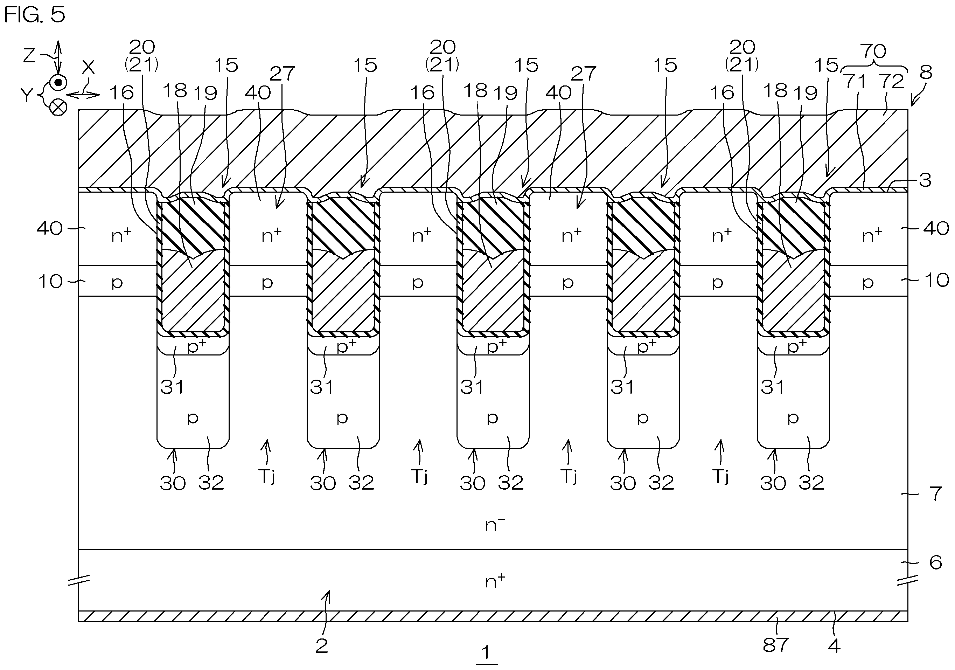

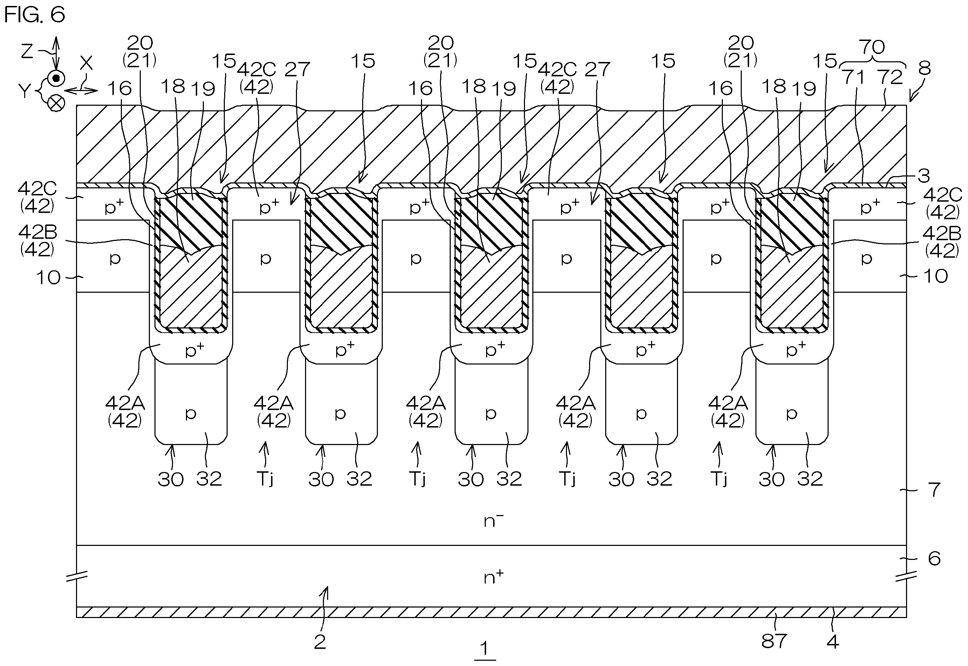

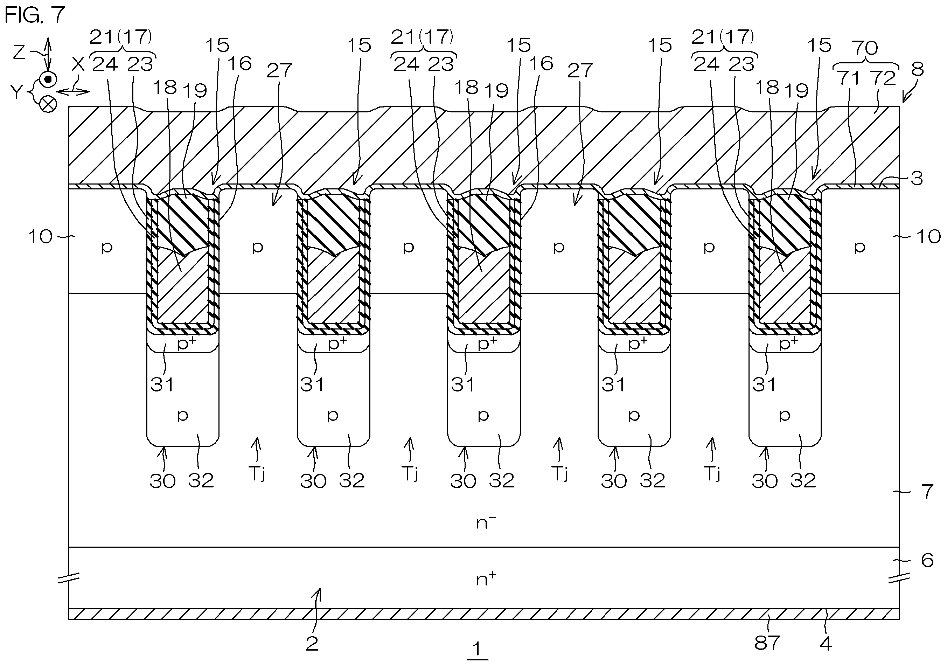

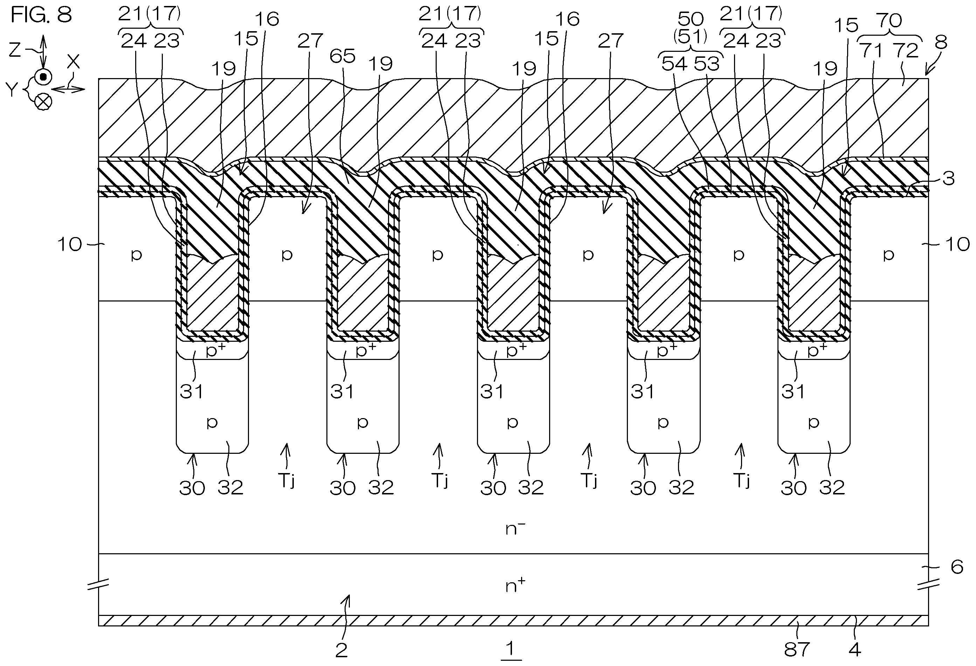

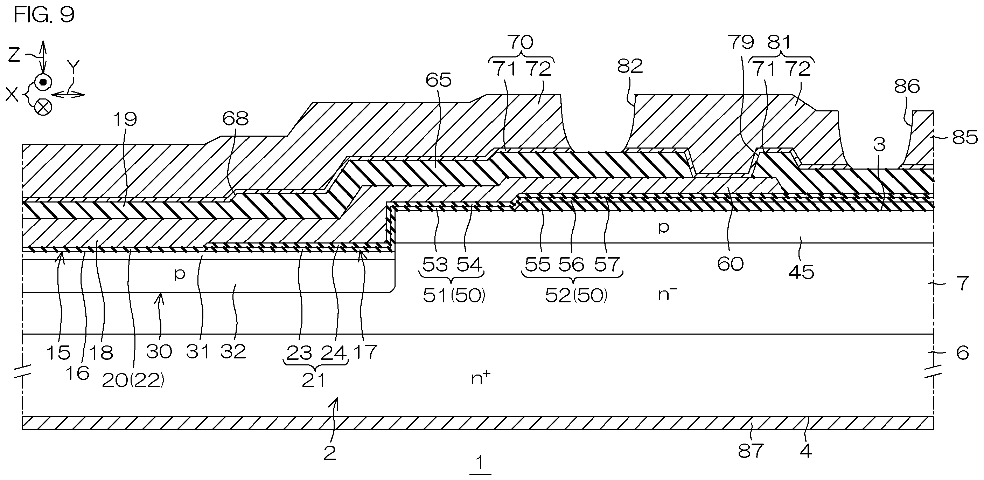

FIG. 1 is a plan view illustrating a semiconductor device 1 according to a specific embodiment. FIG. 2 is a sectional view taken along line II-II shown in FIG. 1. FIG. 3 is a plan view illustrating a layout example of a first main surface 3. FIG. 4 is an enlarged plan view illustrating one main portion of an active region 8. FIG. 5 is a sectional view taken along line V-V shown in FIG. 4. FIG. 6 is a sectional view taken along line VI-VI shown in FIG. 4. FIG. 7 is a sectional view taken along line VII-VII shown in FIG. 4. FIG. 8 is a cross-sectional view taken along line VIII-VIII illustrated in FIG. 4. FIG. 9 is a cross-sectional view taken along line IX-IX illustrated in FIG. 4.

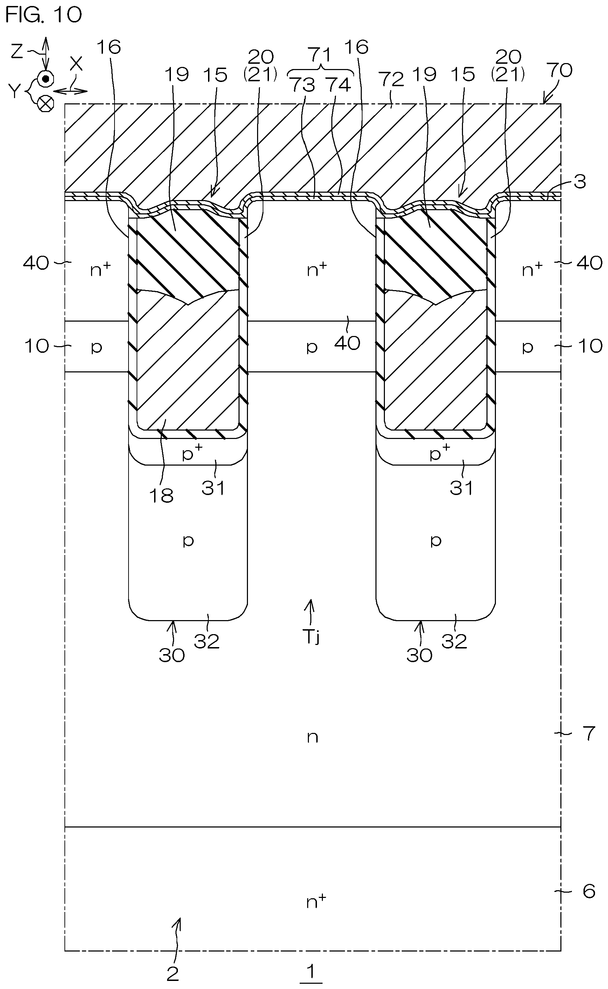

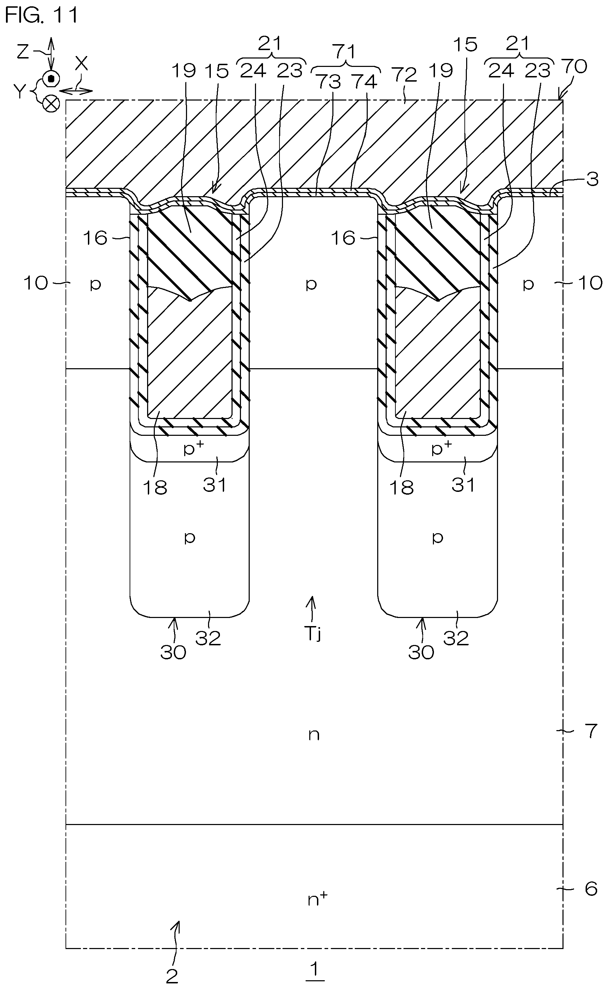

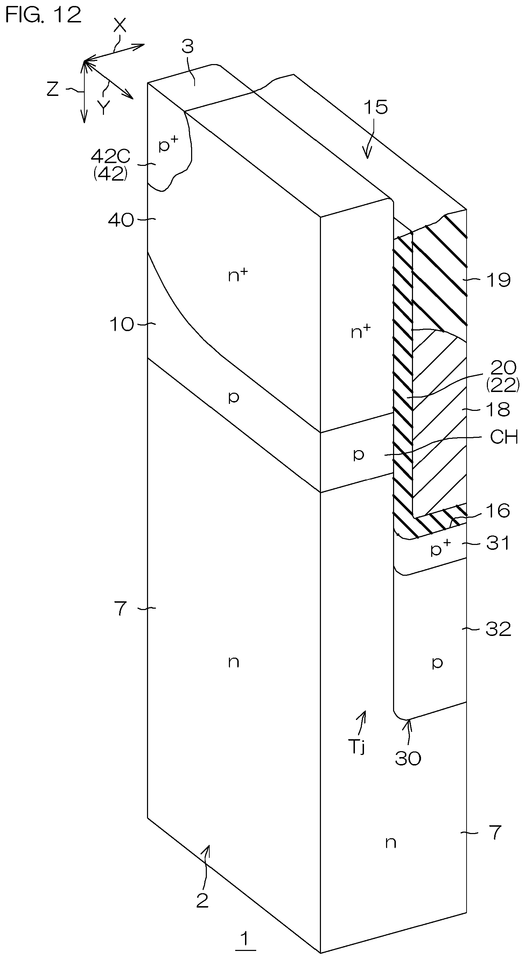

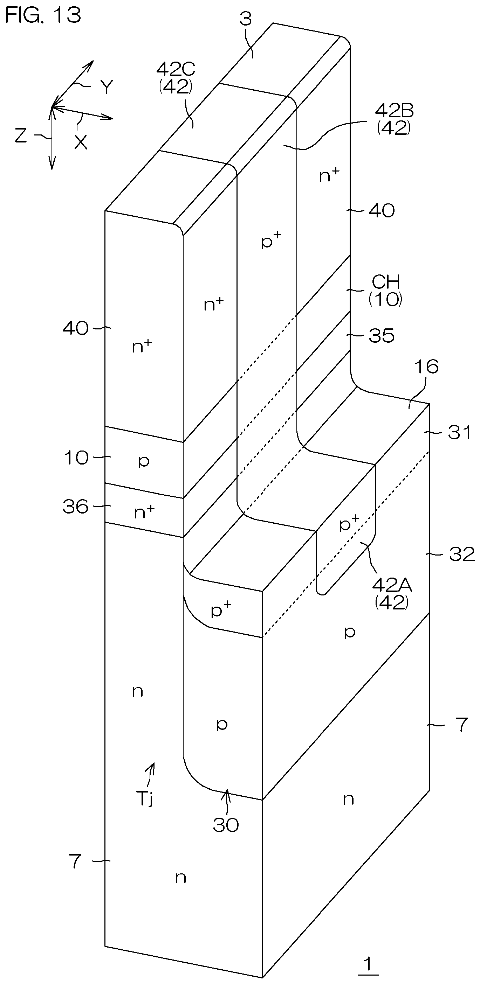

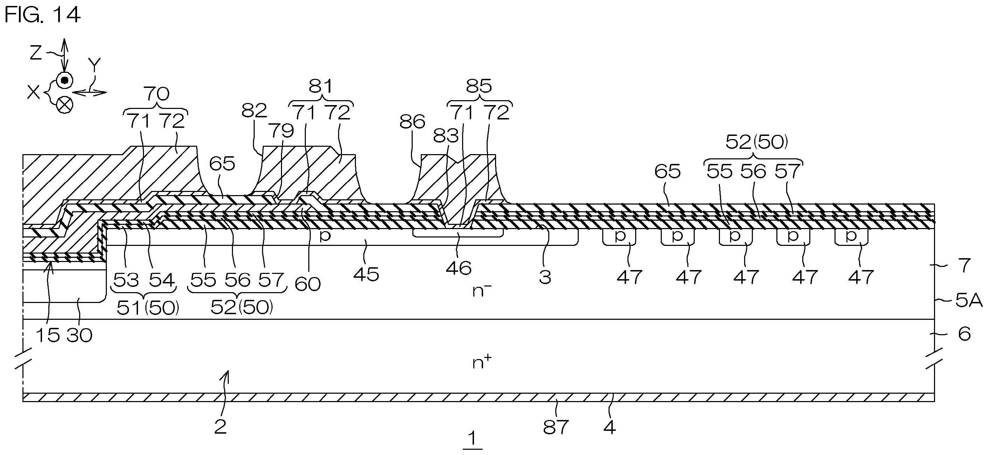

FIG. 10 is an enlarged cross-sectional view illustrating one main portion of the active region 8. FIG. 11 is an enlarged cross-sectional view illustrating one main portion of the active region 8. FIG. 12 is a cross-sectional perspective view illustrating one main portion of the active region 8. FIG. 13 is a cross-sectional perspective view illustrating one main portion of the active region 8. FIG. 14 is a cross-sectional view illustrating an outer peripheral region 9.

With reference to FIGS. 1 to 14, the semiconductor device 1 is a semiconductor switching device having a transistor structure Tr of an insulated gate type as an example of a device structure. The transistor structure Tr has a trench gate type vertical structure.

The semiconductor device 1 includes a chip 2 formed in a hexahedron shape (specifically, a rectangular parallelepiped shape). In this embodiment, the chip 2 includes a monocrystal of a wide band gap semiconductor. That is, the semiconductor device 1 is a "wide bandgap semiconductor device." The chip 2 may also be referred to as a "semiconductor chip" or a "wide bandgap semiconductor chip," etc.

The wide bandgap semiconductor is a semiconductor that has a bandgap exceeding a bandgap of Si (silicon). GaN (gallium nitride), SiC (silicon carbide), C (diamond), etc., can be given as examples of the wide bandgap semiconductor. In this embodiment, the chip 2 is an "SiC chip" that includes, as an example of the wide bandgap semiconductor, an SiC monocrystal that is a hexagonal crystal. That is, the semiconductor device 1 is an "SiC semiconductor device."

The SiC monocrystal that is a hexagonal crystal has multiple polytypes including a 2H (hexagonal)-SiC monocrystal, a 4H-SiC monocrystal, a 6H-SiC monocrystal, etc. In this embodiment, an example in which the chip 2 includes the 4H-SiC monocrystal is given, but the chip 2 may include another polytype.

The chip 2 has a first main surface 3 on one side, a second main surface 4 on the other side, and first to fourth side surfaces 5A to 5D connected to the first main surface 3 and the second main surface 4. In a plan view as viewed from a vertical direction Z (hereinafter referred to simply as "plan view"), the first main surface 3 and the second main surface 4 are formed in quadrangular shapes. The vertical direction Z is also a thickness direction of the chip 2.

The first main surface 3 and the second main surface 4 are preferably formed by c-planes of the SiC monocrystal. In this case, preferably, the first main surface 3 is formed by a silicon plane (a (0001) plane) of the SiC monocrystal and the second main surface 4 is formed by a carbon plane (a (000-1) plane) of the SiC monocrystal.

The first side surface 5A and the second side surface 5B extend in a first direction X oriented along the first main surface 3 and are opposed in a second direction Y that intersects the first direction X along the first main surface 3. Specifically, the second direction Y is orthogonal to the first direction X. The third side surface 5C and the fourth side surface 5D extend in the second direction Y and are opposed in the first direction X.

In this embodiment, the first direction X is an m-axis direction (a [1-100] direction) of the SiC monocrystal and the second direction Y is an a-axis direction (a [11-20] direction) of the SiC monocrystal. The first direction X may be the a-axis direction of the SiC monocrystal, and the second direction Y may be the m-axis direction of the SiC monocrystal. In the following, directions extending along the first main surface 3 are expressed at times as "horizontal directions." The horizontal directions are also an XY plane (horizontal plane) formed by the first direction X and the second direction Y and are orthogonal to the vertical direction Z.

The chip 2 (the first main surface 3 and the second main surface 4) has the off angle inclined at a predetermined angle in a predetermined off direction with respect to the c-plane of the SiC monocrystal. That is, the c-axis ((0001) axis) of the SiC monocrystal is inclined by the off angle from a vertical line along the vertical direction Z toward the off direction. Also, the c-plane of the SiC monocrystal is inclined by just the off angle with respect to the horizontal plane.

The off direction is preferably the a-axis direction (in this embodiment, the second direction Y) of the SiC monocrystal. The off angle may exceed 0° and be not more than 10°. The off angle may have a value belonging to at least one range among exceeding 0° and being not more than 1°, being not less than 1° and not more than 2.5°, being not less than 2.5° and not more than 5°, being not less than 5° and not more than 7.5°, and being not less than 7.5° and not more than 10°.

The off angle is preferably not more than 5°. The off angle is particularly preferably not less than 2° and not more than 4.5°. The off angle is typically set in a range of 4°±0.1°. This Description does not exclude an embodiment in which the off angle is 0° (that is, an embodiment in which the first main surface 3 is a just surface with respect to the c-plane).

The semiconductor device 1 includes a first semiconductor layer 6 of an n-type formed in a surface layer portion of the second main surface 4. A drain potential is to be applied as a first potential (high potential) to the first semiconductor layer 6. The first semiconductor layer 6 may be referred to as a "semiconductor region (layer)," a "base region (layer)," a "drain region (layer)," or the like.

The first semiconductor layer 6 extends in a layer shape along the second main surface 4 and forms the second main surface 4 and the first to fourth side surfaces 5A to 5D. In this embodiment, the first semiconductor layer 6 is consisting of a semiconductor layer of the n-type. Specifically, the first semiconductor layer 6 is consisting of a substrate (SiC substrate) including SiC monocrystal (semiconductor monocrystal), and has the second main surface 4 and the first to fourth side surfaces 5A to 5D. The first semiconductor layer 6 (substrate) has the off direction and the off angle described above. The first semiconductor layer 6 may have a substantially uniform n-type impurity concentration (a substantially constant n-type impurity concentration) in the thickness direction.

The first semiconductor layer 6 may have a thickness of not less than 10 µm and not more than 500 µm. The thickness of the first semiconductor layer 6 may have a value belonging to at least one range among not less than 10 µm and not more than 50 µm, not less than 50 µm and not more than 100 µm, not less than 100 µm and not more than 150 µm, not less than 150 µm and not more than 200 µm, not less than 200 µm and not more than 300 µm, not less than 300 µm and not more than 400 µm, and not less than 400 µm and not more than 500 µm.

The semiconductor device 1 includes a second semiconductor layer 7 of the n-type formed in a surface layer portion of the first main surface 3. The second semiconductor layer 7 may be referred to as a "semiconductor region (layer)," a "drift region (layer)," or the like. The second semiconductor layer 7 has an n-type impurity concentration lower than the n-type impurity concentration of the first semiconductor layer 6. The second semiconductor layer 7 may have a substantially uniform n-type impurity concentration (a substantially constant n-type impurity concentration) in the thickness direction. The n-type impurity concentration of the second semiconductor layer 7 may increase from the bottom portion toward the first main surface 3 side.

The second semiconductor layer 7 is formed in a region on the first main surface 3 side with respect to the first semiconductor layer 6 in sectional view, and is electrically connected to the first semiconductor layer 6. The second semiconductor layer 7 extends in a layer shape along the first main surface 3, and forms the first main surface 3 and the first to fourth side surfaces 5A to 5D. In this embodiment, the second semiconductor layer 7 is consisting of a semiconductor layer of the n-type.

Specifically, the second semiconductor layer 7 is consisting of an epitaxial layer (SiC epitaxial layer) including SiC monocrystal (semiconductor monocrystal), and has the first main surface 3 and the first to fourth side surfaces 5A to 5D. The second semiconductor layer 7 (epitaxial layer) has the off direction and the off angle described above. The second semiconductor layer 7 preferably has a thickness less than the thickness of the first semiconductor layer 6. The thickness of the second semiconductor layer 7 may be greater than the thickness of the first semiconductor layer 6.

The thickness of the second semiconductor layer 7 may be not less than 5 µm and not more than 15 µm. The thickness of the second semiconductor layer 7 may have a value belonging to at least one range among not less than 5 µm and not more than 7.5 µm, not less than 7.5 µm and not more than 10 µm, not less than 10 µm and not more than 12.5 µm, and not less than 12.5 µm and not more than 15 µm.

The semiconductor device 1 includes an active region 8 set in the chip 2. The active region 8 is a region that includes a device structure (transistor structure Tr) and is a region in which an output current (drain current) is to be generated. The active region 8 is set in the inner portion of the chip 2 at an interval from the peripheral edge (first to fourth side surfaces 5A to 5D) of the first main surface 3.

The active region 8 is set in a polygonal shape (in this embodiment, a quadrangular shape) having four sides parallel to the peripheral edges of the chip 2 in plan view. The active region 8 has a portion recessed in a quadrangular shape toward the fourth side surface 5D side at a portion along a central portion of the third side surface 5C. A ratio (area ratio) of a planar area of the active region 8 with respect to a planar area of the first main surface 3 may be not less than 0.5 and not more than 0.95. The area ratio may be not less than 0.5 and not more than 0.6, not less than 0.6 and not more than 0.7, not less than 0.7 and not more than 0.8, not less than 0.8 and not more than 0.9, or not less than 0.9 and not more than 0.95.

The semiconductor device 1 includes an outer peripheral region 9 set outside the active region 8 in the chip 2. The outer peripheral region 9 is a region not including the device structure (transistor structure Tr). The outer peripheral region 9 is set in a peripheral edge portion of the chip 2. That is, the outer peripheral region 9 is provided in a region between a peripheral edge of the chip 2 and the active region 8 in plan view. The outer peripheral region 9 extends as a band along the active region 8 and is set to a polygonal annular shape (in this embodiment, a quadrilateral annular shape) that surrounds the active region 8 in plan view.

The semiconductor device 1 includes the transistor structure Tr formed in the active region 8. Hereinafter, a configuration in the active region 8 as a configuration of the transistor structure Tr will be described.

The semiconductor device 1 includes a body region 10 of a p-type formed in a surface layer portion of the first main surface 3 in the active region 8 (an inner portion of the first main surface 3). The body region 10 may be referred to as a "channel region" or the like. A source potential may be applied to the body region 10. The source potential may be a reference potential serving as a reference of circuit operation. The reference potential may be a ground potential.

The body region 10 has a p-type impurity concentration higher than the n-type impurity concentration of the second semiconductor layer 7. The body region 10 is formed in the inner portion of the first main surface 3 at an interval from the peripheral edge (first to fourth side surfaces 5A to 5D) of the first main surface 3, and is not formed in the outer peripheral region 9. In this embodiment, the body region 10 is formed over the entire active region 8. The body region 10 is formed in a surface layer portion of the second semiconductor layer 7, and extends in a layer shape along the first main surface 3.

The body region 10 is formed at an interval from a bottom portion of the second semiconductor layer 7 (first semiconductor layer 6) toward the first main surface 3 side, and opposes the first semiconductor layer 6 across a part of the second semiconductor layer 7. The body region 10 is formed at an interval from a depth position of an intermediate portion of the second semiconductor layer 7 toward the first main surface 3 side.

The body region 10 is formed in a region on the first main surface 3 side with respect to the second semiconductor layer 7 in sectional view, and is electrically connected to the second semiconductor layer 7. The body region 10 forms a pn-junction portion (body diode) with the second semiconductor layer 7. The body region 10 expands a depletion layer in the second semiconductor layer 7 when a reverse bias voltage is applied. The depletion layer having the body region 10 as a starting point spreads in the horizontal direction and the thickness direction within the second semiconductor layer 7.

The semiconductor device 1 includes a plurality of gate structures 15 of a trench type (trench electrode type) formed in an inner portion of the first main surface 3. The gate structure 15 may be referred to as a "trench structure," a "trench gate structure," or the like. A gate potential (gate signal) as a control potential is to be applied to the plurality of gate structures 15. The plurality of gate structures 15 control an inversion and a non-inversion of a channel CH in the body region 10 in response to the gate potential (refer to FIG 10).

The plurality of gate structures 15 are formed in the inner portion of the first main surface 3 at intervals from the peripheral edge (first to fourth side surfaces 5A to 5D) of the first main surface 3, and are not formed in the outer peripheral region 9. The plurality of gate structures 15 are aligned at intervals in the first direction X (= m-axis direction) in plan view, and each extend in a band shape in the second direction Y (= a-axis direction). The plurality of gate structures 15 are aligned in a stripe shape extending in the second direction Y in plan view.

An extension direction of the plurality of gate structures 15 coincides with the off direction of the SiC monocrystal. In the second direction Y, both end portions of the plurality of gate structures 15 are positioned inward of the peripheral edge of the body region 10. Both end portions of the plurality of gate structures 15 may be positioned outside the peripheral edge of the body region 10. The plurality of gate structures 15 may be aligned at intervals in the second direction Y in plan view, and each may extend in a band shape in the first direction X.

The plurality of gate structures 15 penetrate the body region 10 so as to reach the second semiconductor layer 7. The plurality of gate structures 15 are formed at intervals from the depth position of the bottom portion of the second semiconductor layer 7 toward the first main surface 3 side, and oppose the first semiconductor layer 6 across a part of the second semiconductor layer 7.

The plurality of gate structures 15 may be formed at intervals from the depth position of the intermediate portion of the second semiconductor layer 7 toward the first main surface 3 side, or may be positioned on the bottom portion side (second main surface 4 side) of the second semiconductor layer 7 with respect to the depth position of the intermediate portion of the second semiconductor layer 7. The plurality of gate structures 15 are formed substantially perpendicular to the first main surface 3. The plurality of gate structures 15 may be formed in a shape tapering toward the bottom portion of the second semiconductor layer 7.

The side walls (long sides) of the plurality of gate structures 15 are formed by an m-plane ((1-100) plane) of SiC monocrystal. The side walls (long sides) of the plurality of gate structures 15 may be formed by the a-plane ((11-20) plane) of the SiC monocrystal in accordance with the extension direction of the gate structure 15. The side walls of the plurality of gate structures 15 define opening ends curved in an arc shape (arcuate shape) together with the first main surface 3.

Bottom walls of the plurality of gate structures 15 are formed by a c-plane (Si plane) of SiC monocrystal. The bottom walls of the plurality of gate structures 15 preferably extend substantially flat along the horizontal direction. The bottom walls of the plurality of gate structures 15 may be curved in an arcuate shape toward the second main surface 4 side.

An inclination angle (absolute value) of a side wall (long side) of the gate structure 15 with respect to the vertical line may be not less than 85° and not more than 95°. The inclination angle may have a value belonging to at least one range among not less than 85° and not more than 87.5°, not less than 87.5° and not more than 90°, not less than 90° and not more than 92.5°, and not less than 92.5° and not more than 95°. The inclination angle is preferably not less than 87° and not more than 93°.

The gate structure 15 may have a width of not less than 0.1 µm and not more than 2 µm. The width of the gate structure 15 may have a value belonging to at least one range among not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.25 µm, not less than 1.25 µm and not more than 1.5 µm, not less than 1.5 µm and not more than 1.75 µm, and not less than 1.75 µm and not more than 2 µm. The width of the gate structure 15 is preferably not more than 1 µm.

The gate structure 15 may have a depth of not less than 0.1 µm and not more than 3 µm. The depth of the gate structure 15 is a depth with respect to the first main surface 3. The depth of the gate structure 15 may have a value belonging to at least one range among not less than 0.1 µm and not more than 0.5 µm, not less than 0.5 µm and not more than 1 µm, not less than 1 µm and not more than 1.5 µm, not less than 1.5 µm and not more than 2 µm, not less than 2 µm and not more than 2.5 µm, and not less than 2.5 µm and not more than 3 µm. The depth of the gate structure 15 is preferably not less than 0.5 µm and not more than 1.5 µm.

The gate structure 15 may have an aspect ratio of not less than 1 and not more than 3. The aspect ratio of the gate structure 15 is a ratio of the depth of the gate structure 15 with respect to the width of the gate structure 15. The aspect ratio may have a value belonging to at least one range among not less than 1 and not more than 1.25, not less than 1.25 and not more than 1.5, not less than 1.5 and not more than 1.75, not less than 1.75 and not more than 2, not less than 2 and not more than 2.25, not less than 2.25 and not more than 2.5, not less than 2.5 and not more than 2.75, and not less than 2.75 and not more than 3. The aspect ratio is preferably not less than 1.5 and not more than 2.5.

The plurality of gate structures 15 may be aligned at an interval of not less than 0.1 µm and not more than 2 µm. The interval between the gate structures 15 is a distance in the horizontal direction (first direction X) between the plurality of gate structures 15. The interval between the gate structures 15 may have a value belonging to at least one range among not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.25 µm, not less than 1.25 µm and not more than 1.5 µm, not less than 1.5 µm and not more than 1.75 µm, and not less than 1.75 µm and not more than 2 µm. The interval between the gate structures 15 is preferably not more than 1 µm.

Each of the plurality of gate structures 15 includes a trench 16, an insulating film 17, an embedded electrode 18, and an embedded insulator 19. The trench 16 may be referred to as a "gate trench," the insulating film 17 may be referred to as a "gate insulating film," the embedded electrode 18 may be referred to as a "gate electrode," and the embedded insulator 19 may be referred to as a "cap insulator (film)." The trench 16 is formed in the first main surface 3 and defines the wall surface (the side wall and the bottom wall) of the gate structure 15.

The insulating film 17 covers the wall surface of the trench 16. In this embodiment, the insulating film 17 has an upper end portion positioned on the bottom wall side of the trench 16 with respect to a height position of the first main surface 3, and exposes a part of the chip 2 from the wall surface of the opening end of the trench 16. The upper end portion of the insulating film 17 is preferably positioned on the opening side of the trench 16 with respect to the depth position of an intermediate portion of the trench 16.

The insulating film 17 includes a first film portion 20 and a second film portion 21. The first film portion 20 has a relatively small first thickness and covers the wall surface of an inner portion of the trench 16. The first film portion 20 is formed as a main body portion of the insulating film 17 (gate insulating film). The first film portion 20 covers the wall surface of the inner portion of the trench 16 at an interval inward from the end portion (in this embodiment, both end portions) in the longitudinal direction of the trench 16. The first film portion 20 covers the side wall and the bottom wall of the trench 16.

A ratio of the coverage area (hidden area) of the first film portion 20 with respect to a surface area of the wall surface of the trench 16 may be not less than 0.5 and less than 1. The ratio of the first film portion 20 may have a value belonging to at least one range among not less than 0.5 and not more than 0.6, not less than 0.6 and not more than 0.7, not less than 0.7 and not more than 0.8, not less than 0.8 and not more than 0.9, and not less than 0.9 and less than 1.

In this embodiment, the first film portion 20 has an upper end portion positioned on the bottom wall side of the trench 16 with respect to the height position of the first main surface 3, and exposes a part of the chip 2 from the wall surface of the opening end of the trench 16. The upper end portion of the first film portion 20 forms the upper end portion of the insulating film 17 in the inner portion of the trench 16. The upper end portion of the first film portion 20 is preferably positioned on an opening side of the trench 16 with respect to the depth position of the intermediate portion of the trench 16.

The first film portion 20 has a single layer structure consisting of the first insulating film 22. The first insulating film 22 directly covers the wall surface of the trench 16 in a film shape. The first insulating film 22 may include at least one of a silicon oxide film, a silicon nitride film, and a silicon oxynitride film.

In this embodiment, the first insulating film 22 has a single layer structure consisting of a silicon oxide film. The silicon oxide film may consist of a silicon oxide film to which no impurities are added, a silicon oxide film containing phosphorus, or a silicon oxide film containing both phosphorus and boron.

The silicon oxide film to which no impurities are added may be referred to as a nondoped silicate glass film (NSG film), the silicon oxide film containing phosphorus may be referred to as a phosphorus silicon glass film (PSG film), and the silicon oxide film containing both phosphorus and boron may be referred to as a boron phosphorus silicon glass film (BPSG film).

The first film portion 20 preferably includes an oxide other than the oxide of the chip 2. In this embodiment, the first insulating film 22 is consisting of an NSG film. As a matter of course, the first film portion 20 (first insulating film 22) may consist of a silicon oxide film consisting of an oxide of the chip 2.

The first thickness of the first film portion 20 (that is, the thickness of the first insulating film 22) may be not less than 10 nm and not more than 250 nm. The first thickness may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

The second film portion 21 has a second thickness different from the first thickness of the first film portion 20, and covers the wall surface of an end portion (in this embodiment, both end portions) of the trench 16. The second film portion 21 covers a region outside the first film portion 20 on the wall surface on the end portion side of the trench 16 and is continuous with the first film portion 20. The second film portion 21 covers the side wall and the bottom wall of the trench 16.

A ratio of the coverage area (hidden area) of the second film portion 21 with respect to the surface area of the wall surface of the trench 16 is less than the ratio of the coverage area (hidden area) of the first film portion 20 with respect to the surface area of the wall surface of the trench 16. The ratio of the second film portion 21 may be greater than 0 and less than 0.5. The ratio of the second film portion 21 may have a value belonging to at least one range among greater than 0 and not more than 0.1, not less than 0.1 and not more than 0.2, not less than 0.2 and not more than 0.3, not less than 0.3 and not more than 0.4, and not less than 0.4 and less than 0.5.

In this embodiment, the second film portion 21 has an upper end portion positioned on the bottom wall side of the trench 16 with respect to the height position of the first main surface 3, and exposes a part of the chip 2 from the wall surface of the opening end of the trench 16. The upper end portion of the second film portion 21 forms the upper end portion of the insulating film 17 at the end portion of the trench 16. The upper end portion of the second film portion 21 is preferably positioned on the opening side of the trench 16 with respect to the depth position of the intermediate portion of the trench 16.

The second film portion 21 has a laminated structure including a second insulating film 23 and a third insulating film 24 laminated in this order from the bottom wall side of the trench 16. That is, the second film portion 21 has the number of laminated layers different from the number of laminated layers of the first film portion 20. The number of laminated layers of the second film portion 21 is greater than the number of layers of the first film portion 20. The second insulating film 23 directly covers the wall surface of the trench 16 in a film shape at the end portion of the trench 16. The second insulating film 23 covers the side wall and the bottom wall of the trench 16 in a film shape.

The second insulating film 23 is formed in an end shape in the trench 16 and defines an end portion of the second film portion 21. That is, the second insulating film 23 has end portions on the side wall and the bottom wall of the trench 16. The end portion of the second insulating film 23 may have an inclined portion inclined obliquely with respect to the wall surface of the trench 16.

The second insulating film 23 may include at least one of a silicon oxide film, a silicon nitride film, and a silicon oxynitride film. The second insulating film 23 may include an insulator that is the same as or different from the first insulating film 22. In this embodiment, the second insulating film 23 has a single layer structure consisting of a silicon oxide film.

The silicon oxide film may consist of an NSG film, a PSG film, or a BPSG film. The second film portion 21 preferably includes an oxide other than the oxide of the chip 2. In this embodiment, the second insulating film 23 is consisting of an NSG film. A thickness of the second insulating film 23 may be greater than or less than the first thickness of the first insulating film 22 (first film portion 20). The thickness of the second insulating film 23 may be substantially equal to the first thickness of the first insulating film 22 (first film portion 20).

The thickness of the second insulating film 23 may be not less than 10 nm and not more than 250 nm. The thickness of the second insulating film 23 may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

The third insulating film 24 directly covers the second insulating film 23 in a film shape in the trench 16. The third insulating film 24 covers the side wall and the bottom wall of the trench 16 across the second insulating film 23. The third insulating film 24 has a covering portion with respect to the end portion of the second insulating film 23, and is connected to the first insulating film 22 at the end portion of the second insulating film 23.

The third insulating film 24 may include at least one of a silicon oxide film, a silicon nitride film, and a silicon oxynitride film. The third insulating film 24 may include an insulator that is the same as or different from the first insulating film 22. The third insulating film 24 may include an insulator that is the same as or different from the second insulating film 23.

In this embodiment, the third insulating film 24 has a single layer structure consisting of a silicon oxide film. The silicon oxide film may consist of an NSG film, a PSG film, or a BPSG film. In this embodiment, the third insulating film 24 is consisting of an NSG film.

In this embodiment, the third insulating film 24 is consisting of the same insulating film as the first insulating film 22, and is integrally formed with the first insulating film 22. That is, the third insulating film 24 is formed by a covering portion of the first insulating film 22 with respect to the second insulating film 23. In other words, the first insulating film 22 overlaps onto the second insulating film 23 as the third insulating film 24 from the wall surface of the trench 16, and covers the second insulating film 23 in a film shape.

A thickness of the third insulating film 24 is substantially equal to the first thickness of the first insulating film 22 (first film portion 20). The thickness of the third insulating film 24 may be greater than or less than the thickness of the first insulating film 22. The thickness of the third insulating film 24 may be greater than or less than the thickness of the second insulating film 23. The thickness of the third insulating film 24 may be substantially equal to the thickness of the second insulating film 23.

The thickness of the third insulating film 24 may be not less than 10 nm and not more than 250 nm. The thickness of the third insulating film 24 may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

The second thickness of the second film portion 21 (that is, a total thickness of the second insulating film 23 and the third insulating film 24) may be not less than 20 nm and not more than 500 nm. The second thickness may have a value belonging to at least one range among not less than 20 nm and not more than 50 nm, not less than 50 nm and not more than 100 nm, not less than 100 nm and not more than 150 nm, not less than 150 nm and not more than 200 nm, not less than 200 nm and not more than 250 nm, not less than 250 nm and not more than 300 nm, not less than 300 nm and not more than 350 nm, not less than 350 nm and not more than 400 nm, not less than 400 nm and not more than 450 nm, and not less than 450 nm and not more than 500 nm.

The embedded electrode 18 may contain either or both of a conductive polysilicon of the p-type and a conductive polysilicon of the n-type. The embedded electrode 18 is preferably consisting of the conductive polysilicon of the n-type. The embedded electrode 18 is embedded in the trench 16 across the insulating film 17, and opposes the second semiconductor layer 7 and the body region 10 across the insulating film 17.

Specifically, the embedded electrode 18 is embedded in the trench 16 across the first film portion 20 and the second film portion 21, and is in contact with the first film portion 20 and the second film portion 21 in the trench 16. That is, the embedded electrode 18 is in contact with the first insulating film 22 and the third insulating film 24. The embedded electrode 18 has a portion in contact with a step portion defined between the first film portion 20 and the second film portion 21.

The embedded electrode 18 opposes the second semiconductor layer 7 and the body region 10 across the first film portion 20 at the inner portion of the trench 16, and opposes the second semiconductor layer 7 and the body region 10 across the second film portion 21 at the end portion of the trench 16.

The embedded electrode 18 has an electrode surface exposed from the trench 16. The electrode surface is positioned on the bottom wall side of the trench 16 at an interval from the height position of the first main surface 3. The electrode surface is positioned on the first main surface 3 side with respect to the depth position of the intermediate portion of the trench 16. The electrode surface may be positioned on the bottom wall side of the trench 16 with respect to the depth position of the intermediate portion of the trench 16.

The electrode surface is positioned closer to the bottom wall side of the trench 16 than the upper end portion of the insulating film 17, and exposes a portion of the insulating film 17 covering the side wall on the opening side of the trench 16. The electrode surface may be positioned closer to the first main surface 3 side than the upper end portion of the insulating film 17. The electrode surface defines a recess space with the side wall of the trench 16 in the trench 16.

The electrode surface is positioned closer to the bottom wall side of the trench 16 than the upper end portion of the first film portion 20 in the inner portion of the trench 16. The electrode surface may be positioned closer to the first main surface 3 side than the upper end portion of the first film portion 20. The electrode surface is positioned closer to the bottom wall side of the trench 16 than the upper end portion of the second film portion 21 at the end portion of the trench 16. The electrode surface may be positioned closer to the first main surface 3 side than the upper end portion of the second film portion 21.

The embedded insulator 19 may include at least one of a silicon oxide film, a silicon nitride film, and a silicon oxynitride film. The embedded insulator 19 may have a single layer structure including a single silicon oxide film or a laminated structure including a plurality of silicon oxide films. The single or plurality of silicon oxide films may include at least one of an NSG film, a PSG film, and a BPSG film.

The embedded insulator 19 is embedded on the embedded electrode 18 in the trench 16 and covers the embedded electrode 18. In this embodiment, the embedded insulator 19 is embedded in the trench 16 across the insulating film 17, and is in contact with the insulating film 17 and the embedded electrode 18 in the trench 16. The embedded insulator 19 has a portion opposing the chip 2 in the horizontal direction across the insulating film 17, and exposes the first main surface 3.

Specifically, the embedded insulator 19 is embedded in the trench 16 across the first film portion 20 and the second film portion 21, and is in contact with the first film portion 20 and the second film portion 21 in the trench 16. That is, the embedded insulator 19 is in contact with the first insulating film 22 and the third insulating film 24. The embedded insulator 19 has a portion in contact with the step portion defined between the first film portion 20 and the second film portion 21.

The embedded insulator 19 opposes the second semiconductor layer 7 and the body region 10 across the first film portion 20 at the inner portion of the trench 16, and opposes the second semiconductor layer 7 and the body region 10 across the second film portion 21 at the end portion of the trench 16. The embedded insulator 19 is embedded in the trench 16 at an interval from the height position of the first main surface 3 to the bottom wall side of the trench 16, and exposes a part of the chip 2 from the opening end of the trench 16.

The embedded insulator 19 has an insulating surface exposed from the trench 16. The insulating surface is positioned on the bottom wall side of the trench 16 with respect to the height position of the first main surface 3. The insulating surface is positioned on the opening side of the trench 16 with respect to the depth position of the intermediate portion of the trench 16. The insulating surface may be positioned on the bottom wall side of the trench 16 with respect to the depth position of the intermediate portion of the trench 16.

The insulating surface exposes the upper end portion of the insulating film 17. In this embodiment, the insulating surface is flat and continuous with the upper end portion of the insulating film 17. That is, the insulating surface is formed to be flush with the upper end portion of the insulating film 17. The insulating surface may be formed to be flush with the first main surface 3 together with the upper end portion of the insulating film 17. The insulating surface may be positioned closer to the first main surface 3 side or the bottom wall side of the trench 16 than the upper end portion of the insulating film 17.

In this embodiment, the insulating surface has a raised portion raised from the side wall of the trench 16 toward the inside of the trench 16. The raised portion of the insulating surface is positioned on the bottom wall side of the trench 16 with respect to the height position of the first main surface 3. The raised portion of the insulating surface may protrude upward than the height position of the first main surface 3. The insulating surface may have a recess sinking from the side wall of the trench 16 toward the inside of the trench 16 instead of the raised portion. The insulating surface may be formed to be flush with the first main surface 3.

In this embodiment, the embedded insulator 19 has a thickness greater than the thickness of the insulating film 17 in the depth direction of the trench 16. The thickness of the embedded insulator 19 is preferably greater than the second thickness of the second film portion 21. The thickness of the embedded insulator 19 is preferably less than the thickness of the embedded electrode 18.

A ratio of the thickness of the embedded insulator 19 to the depth of the trench 16 may exceed 0 and be not more than 0.5. The ratio of the thickness may have a value belonging to at least one range among exceeding 0 and not more than 0.1, not less than 0.1 and not more than 0.2, not less than 0.2 and not more than 0.3, not less than 0.3 and not more than 0.4, and not less than 0.4 and not more than 0.5.

The semiconductor device 1 includes a plurality of mesa portions 27 defined in the first main surface 3 in the active region 8. The plurality of mesa portions 27 are respectively defined in regions between the plurality of adjacent gate structures 15. The plurality of mesa portions 27 are defined at intervals in the first direction X following the layout of the plurality of gate structures 15, and each extend in a band shape in the second direction Y. The plurality of mesa portions 27 extend in a stripe shape in the second direction Y. A width of each mesa portion 27 corresponds to the interval between the plurality of gate structures 15.

The semiconductor device 1 includes a plurality of well regions 30 of the p-type formed in the chip 2 (second semiconductor layer 7). The plurality of well regions 30 have a p-type impurity concentration higher than the n-type impurity concentration of the second semiconductor layer 7, and replace the conductivity type of the second semiconductor layer 7 to the p-type from the n-type. The source potential is to be applied to the plurality of well regions 30.

The plurality of well regions 30 are respectively formed in regions below (specifically, immediately below) the plurality of gate structures 15 at an interval in the horizontal direction (first direction X) in the second semiconductor layer 7. The plurality of well regions 30 are respectively formed in a thickness range between the bottom portion of the second semiconductor layer 7 and the bottom walls of the plurality of gate structures 15, and overlap the plurality of gate structures 15 in a one-to-one correspondence in the thickness direction.

Each of the plurality of well regions 30 extends in a band shape in the second direction Y following the extension direction of the corresponding gate structure 15 in plan view. The plurality of well regions 30 are aligned in a stripe shape extending in the second direction Y in plan view. The extension direction of the plurality of well regions 30 coincides with the off direction of the SiC monocrystal.

In the second direction Y, both end portions of the plurality of well regions 30 may be positioned on the inner side of the plurality of gate structures 15 with respect to both end portions of the plurality of gate structures 15, or may be positioned on the peripheral edge side of the active region 8. The plurality of well regions 30 may extend in the first direction X in accordance with the extension direction of the plurality of gate structures 15. In this case, the plurality of well regions 30 intersect (specifically, are orthogonal to) the off direction.

The plurality of well regions 30 are formed at intervals from the bottom portion of the second semiconductor layer 7 toward the bottom wall side of the plurality of gate structures 15, and oppose the first semiconductor layer 6 across a part of the second semiconductor layer 7. Each of the plurality of well regions 30 has an upper end portion positioned on the bottom wall side of the corresponding gate structure 15 and a bottom portion positioned on the bottom portion side of the second semiconductor layer 7.

The upper end portions of the plurality of well regions 30 are formed at intervals from a bottom portion of the body region 10 toward the bottom wall side of the corresponding gate structure 15. The upper end portions of the plurality of well regions 30 are connected to the bottom wall of the corresponding gate structure 15, and oppose the embedded electrode 18 via the insulating film 17.

In this embodiment, each of the plurality of well regions 30 has a portion along the first film portion 20 and a portion along the second film portion 21. That is, the plurality of well regions 30 have a portion opposing the embedded electrode 18 across the first film portion 20 and a portion opposing the embedded electrode 18 across the second film portion 21.

The upper end portions of the plurality of well regions 30 may have a portion along the side wall of the corresponding gate structure 15. That is, each of the plurality of well regions 30 may have a portion along the first film portion 20 and a portion along the second film portion 21 in the side wall of the corresponding gate structure 15. The upper end portions of the plurality of well regions 30 may be formed at intervals from the bottom wall of the corresponding gate structure 15 toward the bottom portion side of the second semiconductor layer 7.

The bottom portions of the plurality of well regions 30 may be positioned on the bottom wall side of the plurality of gate structures 15 or the bottom portion side (second main surface 4 side) of the second semiconductor layer 7 with respect to the depth position of the intermediate portion of the second semiconductor layer 7. The bottom portions of the plurality of well regions 30 are directly connected to the second semiconductor layer 7. The plurality of well regions 30 form a JFET region Tj (Junction Field-Effect Transistor region) together with the second semiconductor layer 7 in a region below the gate structure 15.

In this embodiment, a depth of the well region with reference to the bottom wall of the gate structure 15 is less than the depth of the gate structure 15 with reference to the first main surface 3. The depth of the well region 30 may be greater than the depth of the gate structure 15 with reference to the first main surface 3.

The depth of the well region 30 may be not less than 0.5 µm and not more than 5 µm. The depth of the well region 30 may have a value belonging to at least one range among not less than 0.5 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Each of the plurality of well regions 30 includes a first well region 31 positioned on the bottom wall side of the gate structure 15 and a second well region 32 positioned on the bottom portion side of the second semiconductor layer 7. The first well region 31 is positioned on the bottom wall side of the gate structure 15 with respect to the depth position of the intermediate portion of the well region 30, and forms the upper end portion of the well region 30.

In the second direction Y, both end portions of the first well region 31 may be positioned on the inner side of the gate structure 15 with respect to both end portions of the gate structure 15, or may be positioned on the peripheral edge side of the active region 8. The first well region 31 may oppose the embedded electrode 18 via the insulating film 17. The first well region 31 may have a portion opposing the embedded electrode 18 across the first film portion 20 and a portion opposing the embedded electrode 18 across the second film portion 21.

In this embodiment, each of the first well regions 31 has a portion along the first film portion 20 and a portion along the second film portion 21. That is, the first well region 31 has a portion opposing the embedded electrode 18 across the first film portion 20 and a portion opposing the embedded electrode 18 across the second film portion 21.

The first well region 31 may have a portion along the side wall of the gate structure 15. That is, each of the first well regions 31 may have a portion along the first film portion 20 and a portion along the second film portion 21 in the side wall of the gate structure 15. The first well region 31 may be formed at an interval from the bottom wall of the gate structure 15 toward the bottom portion side of the second semiconductor layer 7.

A ratio of a depth of the first well region 31 with respect to the depth of the well region 30 (first depth ratio) may be greater than 0 and not more than 0.5. The first depth ratio may have a value belonging to at least one range among greater than 0 and not more than 0.1, not less than 0.1 and not more than 0.2, not less than 0.2 and not more than 0.3, not less than 0.3 and not more than 0.4, and not less than 0.4 and not more than 0.5. The first depth ratio is preferably less than 0.5.

The depth of the first well region 31 is less than the depth of the gate structure 15. The depth of the first well region 31 may be greater than 0 µm and not more than 1 µm. The depth of the first well region 31 may have a value belonging to at least one range among greater than 0 µm and not more than 0.1 µm, not less than 0.1 µm and not more than 0.2 µm, not less than 0.2 µm and not more than 0.3 µm, not less than 0.3 µm and not more than 0.4 µm, not less than 0.5 µm and not more than 0.6 µm, not less than 0.6 µm and not more than 0.7 µm, not less than 0.7 µm and not more than 0.8 µm, not less than 0.8 µm and not more than 0.9 µm, and not less than 0.9 µm and not more than 1 µm. The depth of the first well region 31 is preferably not more than 0.5 µm.

The second well region 32 is positioned on the bottom portion side of the second semiconductor layer 7 with respect to the first well region 31, and forms the bottom portion of the well region 30. The second well region 32 extends in a band shape in the second direction Y following the extension direction of the gate structure 15. In the second direction Y, both end portions of the second well region 32 may be positioned on the inner side of the gate structure 15 with respect to both end portions of the gate structure 15, or may be positioned on the peripheral edge side of the active region 8.

In this embodiment, the second well region 32 has a portion positioned on the bottom wall side of the gate structure 15 corresponding to the depth position of the intermediate portion of the well region 30 and a portion positioned on the bottom portion side of the second semiconductor layer 7 with respect to the depth position of the intermediate portion of the well region 30.

In this embodiment, each of the second well regions 32 has a portion along the first film portion 20 and a portion along the second film portion 21. That is, the second well region 32 has a portion opposing the first film portion 20 across the first well region 31 and a portion opposing the second film portion 21 across the first well region 31.

A depth of the second well region 32 is obtained by subtracting the depth of the first well region 31 from the depth of the well region 30. The depth of the second well region 32 is a depth based on the bottom portion of the first well region 31. A ratio of the depth of the second well region 32 to the depth of the well region 30 (second depth ratio) is calculated by "1 - the first depth ratio."

The second depth ratio is preferably not less than 0.5. The second depth ratio is particularly preferably greater than 0.5. In this embodiment, the depth of the second well region 32 is less than the depth of the gate structure 15. The depth of the second well region 32 may be greater than the depth of the gate structure 15.

The depth of the second well region 32 may be not less than 0.5 µm and not more than 5 µm. The depth of the second well region 32 may have a value belonging to at least one range among not less than 0.5 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The semiconductor device 1 includes a plurality of source regions 40 of the n-type formed in the body region 10 in the active region 8. The source region 40 has an n-type impurity concentration higher than the p-type impurity concentration of the body region 10, and replaces the conductivity type of the body region 10 to the n-type from the p-type. The n-type impurity concentration of the source region 40 is higher than the n-type impurity concentration of the second semiconductor layer 7.

The plurality of source regions 40 are respectively formed in the plurality of mesa portions 27 in the surface layer portion of the body region 10. In this embodiment, the plurality of source regions 40 are formed at intervals in the second direction Y in a multiple-to-one correspondence with respect to the plurality of mesa portions 27, and are adjacent to the corresponding two gate structures 15 in the first direction X. In this embodiment, each of the plurality of source regions 40 extends in a band shape in the second direction Y following the extension direction of the plurality of gate structures 15 in plan view.

The plurality of source regions 40 on one side in the first direction X respectively oppose the plurality of source regions 40 on the other side in the first direction X across corresponding one gate structure 15. That is, the plurality of source regions 40 are aligned in a line in the first direction X in plan view. In this embodiment, the plurality of source regions 40 are aligned in a matrix pattern at intervals in the first direction X and the second direction Y in plan view.

The plurality of source regions 40 on one side in the first direction X may respectively oppose regions between the plurality of source regions 40 on the other side in the first direction X across corresponding one gate structure 15. That is, the plurality of source regions 40 may be aligned in a staggered manner at intervals in the first direction X and the second direction Y in plan view.

The plurality of source regions 40 each have a thickness (depth) less than a thickness (depth) of the body region 10, and are formed at intervals from the bottom portion of the body region 10 toward the first main surface 3 side. The plurality of source regions 40 oppose the second semiconductor layer 7 across a part (bottom portion) of the body region 10.

Each of the plurality of source regions 40 has a bottom portion positioned on the bottom portion side of the body region 10 with respect to the height position of the electrode surface of the plurality of embedded electrodes 18. Specifically, the plurality of source regions 40 each have a portion positioned on the bottom wall side of the plurality of trenches 16 with respect to the electrode surfaces of the plurality of embedded electrodes 18, and a portion positioned on the first main surface 3 side with respect to the electrode surfaces of the plurality of embedded electrodes 18.

The plurality of source regions 40 each have a portion opposing the corresponding embedded electrode 18 in the horizontal direction across the corresponding insulating film 17, and a portion opposing the embedded insulator 19 in the horizontal direction across the corresponding insulating film 17. The plurality of source regions 40 each have a portion opposing the embedded electrode 18 across the corresponding first film portion 20, and a portion opposing the embedded insulator 19 across the corresponding first film portion 20.

In this embodiment, the plurality of source regions 40 are formed in a portion along the first film portion 20 at intervals inward from the second film portion 21. That is, in this embodiment, the plurality of source regions 40 positioned on an outermost side are respectively formed at intervals inward from the second film portion 21, and do not have a portion along the second film portion 21. As a matter of course, the one or more source regions 40 positioned at the outermost may have a portion opposing the embedded electrode 18 across the corresponding second film portion 21 and a portion opposing the embedded insulator 19 across the corresponding second film portion 21.

The plurality of source regions 40 each have a portion positioned on the bottom wall side of the plurality of trenches 16 with respect to the insulating surfaces of the plurality of embedded insulators 19, and a portion positioned on the first main surface 3 side with respect to the insulating surfaces of the plurality of embedded insulators 19. In this embodiment, the plurality of source regions 40 each have a portion exposed from the opening end of the corresponding trench 16.

The source region 40 has the thickness (depth) greater than a thickness between the bottom portion of the body region 10 and the bottom portion of the source region 40. The thickness of the source region 40 may be less than the thickness between the bottom portion of the body region 10 and the bottom portion of the source region 40. The thickness (depth) of the peripheral edge portion of the plurality of source regions 40 gradually decreases from the bottom portion side of the body region 10 toward the first main surface 3 side along the second direction Y. The plurality of source regions 40 define a channel CH serving as a current path on the bottom portion side of the body region 10 together with the second semiconductor layer 7 (refer to FIG. 10).

The channel CH may have a channel length of greater than 0 nm and not more than 300 nm. The channel length is the shortest distance between the bottom portion of the body region 10 and the bottom portion of the source region 40. The channel length may have a value belonging to at least one range among greater than 0 nm and not more than 50 nm, not less than 50 nm and not more than 100 nm, not less than 100 nm and not more than 150 nm, not less than 150 nm and not more than 200 nm, not less than 200 nm and not more than 250 nm, and not less than 250 nm and not more than 300 nm.

The semiconductor device 1 includes a plurality of contact regions 42 formed in the chip 2 (second semiconductor layer 7) in the active region 8. The source potential is to be applied to the contact region 42. The contact region 42 has a p-type impurity concentration higher than the n-type impurity concentration of the second semiconductor layer 7. The p-type impurity concentration of the contact region 42 is higher than the p-type impurity concentration of the body region 10.

The p-type impurity concentration of the contact region 42 is higher than the p-type impurity concentration of the second well region 32. The p-type impurity concentration of the contact region 42 may be higher than or lower than the p-type impurity concentration of the first well region 31. The p-type impurity concentration of the contact region 42 may be higher than or lower than the n-type impurity concentration of the source region 40.

The plurality of contact regions 42 are respectively formed in regions along the plurality of gate structures 15. The plurality of contact regions 42 are formed at intervals in the second direction Y in a multiple-to-one correspondence with respect to the plurality of gate structures 15. In this embodiment, the plurality of contact regions 42 are formed in a portion along the first film portion 20 at intervals inward from the second film portion 21.

Specifically, each of the plurality of contact regions 42 is interposed in a region between the plurality of source regions 40. The plurality of contact regions 42 may be connected to the plurality of source regions 40 in the second direction Y. The plurality of contact regions 42 may be formed at intervals in the second direction Y from the plurality of source regions 40. In this case, the plurality of contact regions 42 may oppose the plurality of source regions 40 across a part of the body region 10.

With respect to one and the other gate structures 15, the plurality of contact regions 42 along one gate structure 15 oppose the plurality of contact regions 42 along the other gate structure 15 in the first direction X in plan view. That is, the plurality of contact regions 42 are aligned in a matrix pattern at intervals in the first direction X and the second direction Y as a whole in plan view.

One of the plurality of contact regions 42 may oppose a region between the other of the plurality of contact regions 42 in the first direction X in plan view. That is, the plurality of contact regions 42 may be aligned in a staggered manner at intervals in the first direction X and the second direction Y as a whole in plan view.

The plurality of contact regions 42 may extend in a band shape in the second direction Y following the extension direction of the plurality of gate structures 15 in plan view. Lengths of the plurality of contact regions 42 in the second direction Y may be equal to each other or may be different from each other. The lengths of the plurality of contact regions 42 in the second direction Y are adjusted in accordance with a channel area to be formed.

The channel area is a total area of the portions of the plurality of source regions 40 exposed from the region between the plurality of gate structures 15. That is, the channel area decreases and increases in accordance with the increase and decrease of a ratio of a total planar area of the plurality of contact regions 42. The total planar area of the plurality of contact regions 42 is preferably less than the channel area. That is, a total planar area of the plurality of contact regions 42 is preferably less than the planar area of the plurality of source regions 40 in the region between the plurality of gate structures 15.

The length of the contact region 42 may be greater than or less than the width of the gate structure 15. The length of the contact region 42 may be greater than or less than the interval of the plurality of gate structures 15 (the width of the mesa portion 27). The interval between the plurality of contact regions 42 may be greater than or less than the width of the gate structure 15. The interval of the contact regions 42 may be greater than or less than the interval of the plurality of gate structures 15.

Each of the plurality of contact regions 42 includes a first region 42A, a second region 42B, and a third region 42C. The first region 42A is a portion extending along the bottom wall of the corresponding gate structure 15. The first region 42A is interposed in regions between the bottom wall of the corresponding gate structure 15 and the bottom portion of the corresponding well region 30, and is connected to the bottom wall of the corresponding gate structure 15 and the corresponding well region 30.

The first region 42A opposes the embedded electrode 18 via the insulating film 17. In this embodiment, the first region 42A opposes the embedded electrode 18 across the first film portion 20. As a matter of course, when the contact region 42 is formed in a portion along the second film portion 21, the first region 42A may oppose the embedded electrode 18 across the second film portion 21.

The first region 42A has a thickness greater than the thickness of the first well region 31, and has a bottom portion positioned on the bottom portion side of the second well region 32 with respect to a depth position of the lower end portion (bottom portion) of the first well region 31. The thickness of the first region 42A is a thickness of the first region 42A in the vertical direction Z with reference to the bottom wall of the gate structure 15.

The bottom portion of the first region 42A is formed at an interval from the bottom portion of the second well region 32 toward the bottom wall side of the gate structure 15, and opposes the second semiconductor layer 7 across a part of the second well region 32. The bottom portion of the first region 42A may be positioned on the bottom wall side of the gate structure 15 with respect to a depth position of the intermediate portion of the second well region 32. The bottom portion of the first region 42A may be positioned on the bottom portion side of the second well region 32 with respect to the depth position of the intermediate portion of the second well region 32.

The first region 42A has a width greater than the width of the gate structure 15, and protrudes in the horizontal direction from a region immediately below the corresponding gate structure 15 to both sides of the corresponding gate structure 15. The first region 42A is connected to the first well region 31 and the second well region 32, and increases the p-type impurity concentration of the first well region 31 and the p-type impurity concentration of the second well region 32.

The first region 42A may have a thickness less than the thickness of the first well region 31, and may be formed at an interval from the depth position of the lower end portion of the first well region 31 toward the bottom wall side of the gate structure 15. In this case, the first region 42A may oppose the second well region 32 across a part of the first well region 31.

The second region 42B is a portion extending along the side wall of the gate structure 15. In this embodiment, the second region 42B opposes the embedded electrode 18 across the first film portion 20. As a matter of course, when the contact region 42 is formed in a portion along the second film portion 21, the second region 42B may oppose the embedded electrode 18 across the second film portion 21.

The second region 42B has a thickness less than the thickness of the first region 42A. The thickness of the second region 42B is a thickness of the second region 42B in the horizontal direction with reference to the side wall of the gate structure 15. The second region 42B is connected to the first region 42A on the bottom wall side of the gate structure 15, and is connected to the body region 10 on the first main surface 3 side.

That is, the second region 42B electrically connects the corresponding well region 30 to the body region 10. Accordingly, the well region 30 is suppressed from becoming an electrically floating state, and the electrical response characteristics of the well region 30 are improved.

The third region 42C is a portion extending in a layer shape along the first main surface 3 in the surface layer portion of the first main surface 3 and exposed from the first main surface 3. That is, the third region 42C forms an upper end portion of the contact region 42. In this embodiment, the upper end portion of the third region 42C is exposed from the side wall of the trench 16 at the opening end of the trench 16.

The third region 42C is integrally formed with the third region 42C of the adjacent contact region 42. That is, the plurality of contact regions 42 are electrically connected to each other via the plurality of third regions 42C. The third region 42C has a thickness (depth) less than the thickness (depth) of the body region 10, and opposes the second semiconductor layer 7 across a part (bottom portion) of the body region 10. The thickness of the third region 42C is a thickness of the third region 42C in the vertical direction Z with reference to the first main surface 3.

The third region 42C has a bottom portion positioned on the bottom portion side of the body region 10 with respect to the height position of the electrode surface of the plurality of embedded electrodes 18. Specifically, the third region 42C has a portion positioned on the bottom wall side of the plurality of trenches 16 with respect to the electrode surfaces of the plurality of embedded electrodes 18, and a portion positioned on the first main surface 3 side with respect to the electrode surfaces of the plurality of embedded electrodes 18.

The third region 42C has a portion opposing the corresponding embedded electrode 18 across the corresponding insulating film 17, and a portion opposing the embedded insulator 19 across the corresponding insulating film 17. The third region 42C has a portion opposing the embedded electrode 18 across the corresponding first film portion 20, and a portion opposing the embedded insulator 19 across the corresponding first film portion 20.

As a matter of course, when the contact region 42 is formed in the portion along the second film portion 21, the third region 42C may have a portion opposing the embedded electrode 18 across the corresponding second film portion 21 and a portion opposing the embedded insulator 19 across the corresponding second film portion 21.

The third region 42C has a portion positioned on the bottom wall side of the plurality of trenches 16 with respect to the insulating surfaces of the plurality of embedded insulators 19, and a portion positioned on the first main surface 3 side with respect to the insulating surfaces of the plurality of embedded insulators 19. In this embodiment, the third regions 42C each have a portion exposed from the opening end of the corresponding trench 16.

The thickness of the third region 42C is greater than the thickness of the second region 42B. The thickness of the third region 42C may be substantially equal to the thickness of the first region 42A. The thickness of the third region 42C may be greater than or less than the thickness of the first region 42A. The thickness of the third region 42C is less than the thickness (depth) of the source region 40. The third region 42C has a bottom portion positioned on the first main surface 3 side with respect to the bottom portion of the source region 40.

The thickness of the third region 42C may be greater than the thickness of the source region 40. The thickness of third region 42C is less than the thickness between the bottom portion of the body region 10 and the bottom portion of the third region 42C. The thickness of third region 42C may be less than the thickness between the bottom portion of the body region 10 and the bottom portion of the third region 42C.

With reference to FIG. 9 and FIG. 14, the semiconductor device 1 includes an outer well region 45 of the p-type that is formed in the surface layer portion of the first main surface 3 in the outer peripheral region 9 (the peripheral edge portion of the first main surface 3). The source potential is to be applied to the outer well region 45. The outer well region 45 has a p-type impurity concentration higher than the n-type impurity concentration of the second semiconductor layer 7. The p-type impurity concentration of the outer well region 45 may be higher than or lower than the p-type impurity concentration of the body region 10.

The p-type impurity concentration of the outer well region 45 is lower than the p-type impurity concentration of the contact region 42. The p-type impurity concentration of the outer well region 45 is lower than the p-type impurity concentration of the first well region 31. The p-type impurity concentration of the outer well region 45 may be higher than or lower than the p-type impurity concentration of the second well region 32.

The outer well region 45 is formed in a surface layer portion of the second semiconductor layer 7. The outer well region 45 extends in a layer shape along the first main surface 3. The outer well region 45 is formed at an interval from the peripheral edge (first to fourth side surfaces 5A to 5D) of the first main surface 3 toward the plurality of gate structures 15 side. The outer well region 45 extends in a band shape along the peripheral edge of the first main surface 3 (the peripheral edge of the active region 8) in plan view.

In this embodiment, the outer well region 45 is formed in a polygonal annular shape (in this embodiment, a quadrilateral annular shape) having four sides parallel to the peripheral edge of the chip 2 in plan view, and surrounds the inner portion (active region 8) of the first main surface 3. That is, the outer well region 45 collectively surrounds the plurality of gate structures 15.

The outer well region 45 may have an edge portion connecting a portion extending in the first direction X and a portion extending in the second direction Y in an arcuate shape (preferably, a quarter arcuate shape). The outer well region 45 has an inner edge portion on the plurality of gate structures 15 side and an outer edge portion on the peripheral edge side of the first main surface 3. The inner edge portion of the outer well region 45 defines a boundary portion between the active region 8 and the outer peripheral region 9.

The inner edge portion of the outer well region 45 is connected to the end portions of the plurality of gate structures 15 in a portion extending in the first direction X. The inner edge portion of the outer well region 45 opposes the embedded electrode 18 across the insulating film 17. The outer well region 45 has a portion along the second film portion 21 and opposes the embedded electrode 18 across the second film portion 21.

The inner edge portion of the outer well region 45 may be positioned closer to the inner portion side of the plurality of gate structures 15 than the end portions of the plurality of gate structures 15. The inner edge portion of the outer well region 45 may have a portion positioned in a region between the plurality of gate structures 15 and be connected to the body region 10. The outer edge portion of the outer well region 45 is formed at an interval inward from the peripheral edge of the chip 2 and extends substantially parallel to the inner edge portion of the outer well region 45.

The outer well region 45 may have a width of greater than 0 µm and not more than 300 µm. The width of the outer well region 45 may have a value belonging to at least one range among greater than 0 µm and not more than 25 µm, not less than 25 µm and not more than 50 µm, not less than 50 µm and not more than 75 µm, not less than 75 µm and not more than 100 µm, not less than 100 µm and not more than 125 µm, not less than 125 µm and not more than 150 µm, not less than 150 µm and not more than 175 µm, not less than 175 µm and not more than 200 µm, not less than 200 µm and not more than 225 µm, not less than 225 µm and not more than 250 µm, not less than 250 µm and not more than 275 µm, and not less than 275 µm and not more than 300 µm.

The outer well region 45 is formed at an interval from the bottom portion of the second semiconductor layer 7 toward the first main surface 3 side, and opposes the first semiconductor layer 6 across a part of the second semiconductor layer 7. The outer well region 45 may be formed at an interval from the depth position of the intermediate portion of the second semiconductor layer 7 toward the first main surface 3 side, or may be positioned on the bottom portion side (second main surface 4 side) of the second semiconductor layer 7 with respect to the depth position of the intermediate portion of the second semiconductor layer 7.

In this embodiment, the outer well region 45 is formed at an interval from the depth position of the bottom wall of the plurality of gate structures 15 toward the first main surface 3 side. The depth of the outer well region 45 may be greater than or less than the depth of the body region 10.

The outer well region 45 may have a portion positioned on the bottom portion side of the second semiconductor layer 7 with respect to the depth position of the bottom wall of the plurality of gate structures 15. In this case, the outer well region 45 may be connected to one or both of the first well region 31 and the second well region 32.

The outer well region 45 forms a pn-junction portion with the second semiconductor layer 7. The outer well region 45 expands a depletion layer in the second semiconductor layer 7 when a reverse bias voltage is applied. The depletion layer of the outer well region 45 spreads in the horizontal direction and the thickness direction, and is integrated with the depletion layer spreading from the body region 10 and the well region 30. The outer well region 45 expands the depletion layer spreading from the body region 10 and the well region 30 toward the peripheral edge side of the first main surface 3, and relaxes the electric field strength (concentration of electric field) in the peripheral edge portion (outer peripheral region 9) of the first main surface 3.

The semiconductor device 1 includes an outer contact region 46 of the p-type formed in a surface layer portion of the outer well region 45. The outer contact region 46 has a p-type impurity concentration higher than the p-type impurity concentration of the outer well region 45. The p-type impurity concentration of the outer contact region 46 is higher than the p-type impurity concentration of the body region 10.

The p-type impurity concentration of the outer contact region 46 may be substantially equal to the p-type impurity concentration of the contact region 42. The p-type impurity concentration of the outer contact region 46 may be higher than or lower than the p-type impurity concentration of the contact region 42.

The outer contact region 46 is formed at an interval from the bottom portion of the outer well region 45 toward the first main surface 3 side, and opposes the second semiconductor layer 7 across a part of the outer well region 45. The outer contact region 46 extends in a band shape along the outer well region 45 (active region 8) in plan view.

In this embodiment, the outer contact region 46 is formed in a polygonal annular shape (in this embodiment, a quadrilateral annular shape) having four sides parallel to the peripheral edge of the chip 2 in plan view, and surrounds the plurality of gate structures 15 (active region 8). The outer contact region 46 may have an edge portion connecting a portion extending in the first direction X and a portion extending in the second direction Y in an arcuate shape (preferably, a quarter arcuate shape).

The semiconductor device 1 may include a plurality of outer contact regions 46 aligned at intervals following the extension direction of the outer well region 45 so as to surround the plurality of gate structures 15. In this case, each of the plurality of outer contact regions 46 may extend in a band shape along the extension direction of the outer well region 45.

The outer contact region 46 has a width less than the width of the outer well region 45, and is formed in the outer well region 45. The outer contact region 46 is formed in the inner portion of the outer well region 45 at an interval from both edge portions of the outer well region 45. The outer contact region 46 is shifted to the outer edge portion side of the outer well region 45 with respect to the intermediate portion of the outer well region 45. The outer contact region 46 may be formed in an intermediate portion of the outer well region 45.

The semiconductor device 1 includes at least one (in this embodiment, a plurality) of field regions 47 of the p-type formed in the surface layer portion of the first main surface 3 in the outer peripheral region 9 (a peripheral edge portion of the first main surface 3). The plurality of field regions 47 may be formed in an electrically floating state. The plurality of field regions 47 may be fixed to the source potential.

The number of the field regions 47 is arbitrary. The number of the field regions 47 may be not less than 1 and not more than 20. The number of field regions 47 may have a value belonging to at least one range among not less than 1 and not more than 5, not less than 5 and not more than 10, not less than 10 and not more than 15, and not less than 15 and not more than 20. The number of the field regions 47 is typically not less than 1 and not more than 8. In this embodiment, the semiconductor device 1 includes five field regions 47.

The plurality of field regions 47 are formed at intervals from each other in the surface layer portion of the second semiconductor layer 7. The plurality of field regions 47 are formed in a region between the peripheral edge of the first main surface 3 and the plurality of gate structures 15 (active region 8) at an interval inward from the peripheral edge of the first main surface 3. Specifically, the plurality of field regions 47 are formed in a region between the peripheral edge of the first main surface 3 and the outer well region 45.

The plurality of field regions 47 extend in a band shape along the plurality of gate structures 15 (active region 8) in plan view. Specifically, the plurality of field regions 47 extend in a band shape along the outer well region 45. The plurality of field regions 47 each have portions extending in a band shape in the first direction X and portions extending in a band shape in the second direction Y.

In this embodiment, the plurality of field regions 47 are formed in a polygonal annular shape (in this embodiment, a quadrilateral annular shape) surrounding the plurality of gate structures 15 (active region 8) in plan view. The plurality of field regions 47 may have an edge portion connecting a portion extending in the first direction X and a portion extending in the second direction Y in an arcuate shape (preferably, a quarter arcuate shape).

The plurality of field regions 47 are formed at intervals from the bottom portion of the second semiconductor layer 7 toward the first main surface 3 side, and opposes the first semiconductor layer 6 across a part of the second semiconductor layer 7. The plurality of field regions 47 may be formed at intervals from the depth position of the intermediate portion of the second semiconductor layer 7 toward the first main surface 3 side, or may be positioned on the bottom portion side (second main surface 4 side) of the second semiconductor layer 7 with respect to the depth position of the intermediate portion of the second semiconductor layer 7.

In this embodiment, the plurality of field regions 47 are formed at intervals from the depth position of the bottom wall of the plurality of gate structures 15 toward the first main surface 3 side. The depths of the plurality of field regions 47 may be greater than or less than the depth of the body region 10. The plurality of field regions 47 may have a portion positioned on the bottom portion side of the second semiconductor layer 7 with respect to the depth position of the bottom wall of the plurality of gate structures 15.

The plurality of field regions 47 form a pn-junction portion with the second semiconductor layer 7. The plurality of field regions 47 expand a depletion layer in the second semiconductor layer 7 when a reverse bias voltage is applied. The depletion layer of the plurality of field regions 47 spreads in the horizontal direction and the thickness direction, and is integrated with the depletion layer spreading from the body region 10 and the outer well region 45.

The plurality of field regions 47 expand the depletion layer spreading from the body region 10 and the outer well region 45 toward the peripheral edge side of the first main surface 3, and relax the electric field strength (concentration of electric field) in the peripheral edge portion (outer peripheral region 9) of the first main surface 3.

Widths, depths, intervals, p-type impurity concentrations, and the like of the plurality of field regions 47 are arbitrary and can take on various values in accordance with the electric field to be relaxed. The widths of the plurality of field regions 47 may be substantially constant or non-uniform. The widths of the plurality of field regions 47 may gradually increase toward the peripheral edge side of the first main surface 3. The widths of the plurality of field regions 47 may gradually decrease toward the peripheral edge side of the first main surface 3.

The depths of the plurality of field regions 47 may be substantially constant or non-uniform. The depths of the plurality of field regions 47 may gradually increase toward the peripheral edge side of the first main surface 3. The depths of the plurality of field regions 47 may gradually decrease toward the peripheral edge side of the first main surface 3. As a matter of course, the plurality of field regions 47 may have a relatively-shallow shallow portion and a deep portion deeper than the shallow portion. The shallow portion may be formed on the inner side, and the deep portion may be formed on the peripheral edge side. The shallow portion may be formed on the peripheral edge side, and the deep portion may be formed on the inner side.

The intervals between the plurality of field regions 47 may be substantially constant or non-uniform. The intervals between the plurality of field regions 47 may increase gradually toward the peripheral edge side of the first main surface 3. The interval between the plurality of field regions 47 may gradually decrease toward the peripheral edge side of the first main surface 3.

The p-type impurity concentration of the plurality of field regions 47 may be substantially constant or non-uniform. The p-type impurity concentration of the plurality of field regions 47 may gradually increase toward the peripheral edge side of the first main surface 3. The p-type impurity concentration of the plurality of field regions 47 may gradually decrease toward the peripheral edge side of the first main surface 3.

The plurality of field regions 47 may have a p-type impurity concentration substantially equal to the p-type impurity concentration of the plurality of body regions 10. The p-type impurity concentration of the plurality of field regions 47 may be higher than or lower than the p-type impurity concentration of the plurality of body regions 10.

The plurality of field regions 47 may have a p-type impurity concentration substantially equal to the p-type impurity concentration of the contact region 42. The p-type impurity concentration of the plurality of field regions 47 may be higher than or lower than the p-type impurity concentration of the contact region 42.

The plurality of field regions 47 may have a p-type impurity concentration substantially equal to the p-type impurity concentration of the outer well region 45. The p-type impurity concentration of the plurality of field regions 47 may be higher than or lower than the p-type impurity concentration of the outer well region 45.

The semiconductor device 1 includes a surface insulating film 50 selectively covering the first main surface 3. The surface insulating film 50 may be referred to as a "main surface insulating film," an "outer surface insulating film," or the like. The surface insulating film 50 covers the first main surface 3 in a film shape in the outer peripheral region 9.

Specifically, the surface insulating film 50 covers the outer well region 45, the outer contact region 46, and the plurality of field regions 47 in the outer peripheral region 9. The surface insulating film 50 is continuous with the first to fourth side surfaces 5A to 5D. The surface insulating film 50 may be formed at an interval inward from the first to fourth side surfaces 5A to 5D, and may expose the peripheral edge portion of the first main surface 3.

The surface insulating film 50 is led out to the active region 8 from the outer peripheral region 9, and covers a periphery of the end portions of the plurality of gate structures 15 in the active region 8. The surface insulating film 50 is connected to the insulating films 17 of the plurality of gate structures 15 and exposes the embedded electrode 18 and the embedded insulator 19. The surface insulating film 50 has a portion positioned in the region between the plurality of gate structures 15. The surface insulating film 50 is connected to the insulating film 17 in both the portion extending in the first direction X and the portion extending in the second direction Y among the end portions of the plurality of gate structures 15.

The surface insulating film 50 includes a first surface film portion 51 and a second surface film portion 52. The first surface film portion 51 has a relatively-small third thickness and covers the periphery of the end portions of the plurality of gate structures 15. The first surface film portion 51 may have a portion extending in a band shape in the first direction X and a portion extending in a band shape in the second direction Y. The first surface film portion 51 may be formed in a polygonal annular shape (quadrilateral annular shape) surrounding the plurality of gate structures 15 (active region 8) in plan view.

The first surface film portion 51 is connected to the second film portion 21 of the insulating film 17 at the end portions of the plurality of gate structures 15, and exposes the embedded electrode 18 and the embedded insulator 19. The first surface film portion 51 has a portion positioned in the region between the plurality of gate structures 15, and covers one or both of the body region 10 and the outer well region 45.

The first surface film portion 51 is connected to the second film portion 21 in both the portion extending in the first direction X and the portion extending in the second direction Y among the end portions of the plurality of gate structures 15. The first surface film portion 51 may be connected to first film portion 20 or may not be connected to first film portion 20.

The first surface film portion 51 is formed in a region between the end portions of the plurality of gate structures 15 and the plurality of field regions 47, and covers the outer well region 45. The first surface film portion 51 covers a region closer to the inner portion side of the first main surface 3 than the outer edge portion of the outer well region 45. The first surface film portion 51 covers a region between the end portions of the plurality of gate structures 15 and the inner edge portion of the outer contact region 46. The first surface film portion 51 is formed at an interval from the inner edge portion of the outer contact region 46 toward the end portion side of the plurality of gate structures 15.

The first surface film portion 51 has a width greater than the width of the gate structure 15. As a matter of course, the width of the first surface film portion 51 may be less than the width of the gate structure 15. The width of the first surface film portion 51 is a width from the end portion of the gate structure 15 toward the peripheral edge of the first main surface 3.

The width of the first surface film portion 51 may be greater than 0 µm and not more than 5 µm. The width of the first surface film portion 51 may have a value belonging to at least one range among greater than 0 µm and not more than 0.5 µm, not less than 0.5 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4 µm and not more than 5 µm.

The first surface film portion 51 has a laminated structure including a first surface insulating film 53 and a second surface insulating film 54 laminated in this order from the first main surface 3 side. That is, the first surface film portion 51 has the number of laminated layers different from the number of laminated layers of the first film portion 20. The number of laminated layers of the first surface film portion 51 is greater than the number of laminated layers of the first film portion 20. The number of laminated layers of the first surface film portion 51 is equal to the number of laminated layers of the second film portion 21.

The first surface insulating film 53 covers the periphery of the end portions of the plurality of gate structures 15. The first surface insulating film 53 may have a portion extending in a band shape in the first direction X and a portion extending in a band shape in the second direction Y. The first surface insulating film 53 may be formed in a polygonal annular shape (quadrilateral annular shape) surrounding the plurality of gate structures 15 (active region 8) in plan view.

The first surface insulating film 53 is connected to the second insulating film 23 at the end portions of the plurality of gate structures 15, and exposes the embedded electrode 18 and the embedded insulator 19. The first surface insulating film 53 has a portion positioned in the region between the plurality of gate structures 15, and covers one or both of the body region 10 and the outer well region 45. The first surface insulating film 53 is connected to the second insulating film 23 in both the portion extending in the first direction X and the portion extending in the second direction Y among the end portions of the plurality of gate structures 15.

The first surface insulating film 53 is formed in a region between the end portions of the plurality of gate structures 15 and the plurality of field regions 47, and covers the outer well region 45. The first surface insulating film 53 covers a region closer to the end portion side of the plurality of gate structures 15 than the outer edge portion of the outer well region 45. The first surface insulating film 53 covers a region between the end portions of the plurality of gate structures 15 and the inner edge portion of the outer contact region 46. The first surface insulating film 53 is formed at an interval from the inner edge portion of the outer contact region 46 toward the end portion side of the plurality of gate structures 15.

The first surface insulating film 53 may include at least one of a silicon oxide film, a silicon nitride film, and a silicon oxynitride film. The first surface insulating film 53 may include an insulator that is the same as or different from the first insulating film 22. The first surface insulating film 53 may include an insulator that is the same as or different from the second insulating film 23. The first surface insulating film 53 may include an insulator that is the same as or different from the third insulating film 24.

In this embodiment, the first surface insulating film 53 has a single layer structure consisting of the silicon oxide film. The silicon oxide film may consist of an NSG film, a PSG film, or a BPSG film. The first surface film portion 51 preferably includes an oxide other than the oxide of the chip 2. In this embodiment, the first surface insulating film 53 is consisting of an NSG film.

In this embodiment, the first surface insulating film 53 is consisting of the same insulating film as the second insulating film 23, and is integrally formed with the second insulating film 23. The first surface insulating film 53 is formed as a lead-out portion of the second insulating film 23, and is led out from the trench 16 onto the first main surface 3.

A thickness of the first surface insulating film 53 may be greater than or less than the thickness of the first insulating film 22. The thickness of the first surface insulating film 53 may be greater than or less than the thickness of the second insulating film 23. The thickness of the first surface insulating film 53 may be greater than or less than the thickness of the third insulating film 24.

The thickness of the first surface insulating film 53 may be greater than or less than the first thickness of the first film portion 20 (first insulating film 22). The thickness of the first surface insulating film 53 may be greater than or less than the second thickness of the second film portion 21. In this embodiment, the thickness of the first surface insulating film 53 is substantially equal to the thickness of the second insulating film 23.

The thickness of the first surface insulating film 53 may be not less than 10 nm and not more than 250 nm. The thickness of the first surface insulating film 53 may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

The second surface insulating film 54 directly covers the first surface insulating film 53 in the periphery of the end portions of the plurality of gate structures 15. The second surface insulating film 54 may have a portion extending in a band shape in the first direction X following the extension direction of the first surface insulating film 53 and a portion extending in a band shape in the second direction Y. The second surface insulating film 54 may be formed in a polygonal annular shape (quadrilateral annular shape) surrounding the plurality of gate structures 15 (active region 8) in plan view.

The second surface insulating film 54 is connected to the third insulating film 24 of the insulating film 17 at the end portions of the plurality of gate structures 15, and exposes the embedded electrode 18 and the embedded insulator 19. The second surface insulating film 54 has a portion positioned in the region between the plurality of gate structures 15, and covers one or both of the body region 10 and the outer well region 45 across the first surface insulating film 53. The second surface insulating film 54 is connected to the third insulating film 24 in both the portion extending in the first direction X and the portion extending in the second direction Y among the end portions of the plurality of gate structures 15.

The second surface insulating film 54 is formed in a region between the end portions of the plurality of gate structures 15 and the plurality of field regions 47, and covers the outer well region 45 across the first surface insulating film 53. The second surface insulating film 54 covers a region closer to the inner portion side of the first main surface 3 than the outer edge portion of the outer well region 45.

The second surface insulating film 54 covers a region between the end portions of the plurality of gate structures 15 and the inner edge portion of the outer contact region 46. The second surface insulating film 54 is formed at an interval from the inner edge portion of the outer contact region 46 toward the end portion sides of the plurality of gate structures 15.

The second surface insulating film 54 may include at least one of a silicon oxide film, a silicon nitride film, and a silicon oxynitride film. The second surface insulating film 54 may include an insulator that is the same as or different from the first insulating film 22. The second surface insulating film 54 may include an insulator that is the same as or different from the second insulating film 23. The second surface insulating film 54 may include an insulator that is the same as or different from the third insulating film 24.

The second surface insulating film 54 may include an insulator that is the same as or different from the first surface insulating film 53. In this embodiment, the second surface insulating film 54 has a single layer structure consisting of a silicon oxide film. The silicon oxide film may consist of an NSG film, a PSG film, or a BPSG film. In this embodiment, the second surface insulating film 54 is consisting of an NSG film.

In this embodiment, the second surface insulating film 54 is consisting of the same insulating film as the third insulating film 24, and is integrally formed with the first insulating film 22 and the third insulating film 24. The second surface insulating film 54 is formed as a lead-out portion of the third insulating film 24 (first insulating film 22), and is led out from the trench 16 onto the first main surface 3.

A thickness of the second surface insulating film 54 may be greater than or less than the first thickness of the first film portion 20. The thickness of the second surface insulating film 54 may be greater than or less than the second thickness of the second film portion 21. The thickness of the second surface insulating film 54 may be greater than or less than the thickness of the second insulating film 23. The thickness of the second surface insulating film 54 may be greater than or less than the thickness of the third insulating film 24.

The thickness of the second surface insulating film 54 may be greater than or less than the thickness of the first surface insulating film 53. In this embodiment, the thickness of the second surface insulating film 54 is substantially equal to the thickness of the third insulating film 24.

The thickness of the second surface insulating film 54 may be not less than 10 nm and not more than 250 nm. The thickness of the second surface insulating film 54 may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

A third thickness of the first surface film portion 51 (that is, a total thickness of the first surface insulating film 53 and the second surface insulating film 54) is greater than the first thickness of the first film portion 20. In this embodiment, the third thickness is substantially equal to the second thickness of the second film portion 21. The third thickness may be greater than or less than the second thickness of the second film portion 21.

The third thickness may be not less than 20 nm and not more than 500 nm. The third thickness may have a value belonging to at least one range among not less than 20 nm and not more than 50 nm, not less than 50 nm and not more than 100 nm, not less than 100 nm and not more than 150 nm, not less than 150 nm and not more than 200 nm, not less than 200 nm and not more than 250 nm, not less than 250 nm and not more than 300 nm, not less than 300 nm and not more than 350 nm, not less than 350 nm and not more than 400 nm, not less than 400 nm and not more than 450 nm, and not less than 450 nm and not more than 500 nm.

The second surface film portion 52 has a fourth thickness different from the third thickness, and directly covers the first main surface 3 in the periphery of the first surface film portion 51. The second surface film portion 52 has a width greater than the width of the first surface film portion 51, and covers a region on the peripheral edge side of the first main surface 3 with respect to the first surface film portion 51 in a film shape. A distance between the plurality of gate structures 15 and the second surface film portion 52 corresponds to the width of the first surface film portion 51.

The second surface film portion 52 covers the outer well region 45 and the plurality of field regions 47 across the first surface film portion 51. The second surface film portion 52 may have a portion extending in a band shape in the first direction X and a portion extending in a band shape in the second direction Y.

The second surface film portion 52 may be formed in a polygonal annular shape (quadrilateral annular shape) surrounding the plurality of gate structures 15 (active region 8) in plan view. The second surface film portion 52 is continuous with the first to fourth side surfaces 5A to 5D. The second surface film portion 52 may be formed at an interval inward from the first to fourth side surfaces 5A to 5D, and may expose the peripheral edge portion of the first main surface 3.

The second surface film portion 52 has a laminated structure including a third surface insulating film 55, a fourth surface insulating film 56, and a fifth surface insulating film 57 laminated in this order from the first main surface 3 side in the periphery of the first surface film portion 51.

That is, the second surface film portion 52 has the number of laminated layers different from the number of laminated layers of the first surface film portion 51. The number of laminated second surface film portions 52 is greater than the number of laminated layers of the first surface film portion 51. Also, the number of laminated layers of the second surface film portion 52 is different from the number of laminated layers of the first film portion 20 and the number of laminated layers of the second film portion 21. The number of laminated layers of the second surface film portion 52 is greater than the number of laminated layers of the first film portion 20 and the number of laminated layers of the second film portion 21.

The third surface insulating film 55 directly covers the first main surface 3 in the periphery of the first surface film portion 51. The third surface insulating film 55 covers a region on the peripheral edge side of the first main surface 3 with respect to the first surface film portion 51 in a film shape. The third surface insulating film 55 covers the outer well region 45, the outer contact region 46, and the plurality of field regions 47.

The third surface insulating film 55 may have a portion extending in a band shape in the first direction X and a portion extending in a band shape in the second direction Y. The third surface insulating film 55 may be formed in a polygonal annular shape (quadrilateral annular shape) surrounding the plurality of gate structures 15 (active region 8) in plan view. The second surface film portion 52 is continuous with the first to fourth side surfaces 5A to 5D. The third surface insulating film 55 is continuous with the first to fourth side surfaces 5A to 5D. The third surface insulating film 55 may be formed at an interval inward from the first to fourth side surfaces 5A to 5D, and may expose the peripheral edge portion of the first main surface 3.

The third surface insulating film 55 may include at least one of a silicon oxide film, a silicon nitride film, and a silicon oxynitride film. The third surface insulating film 55 may include an insulator that is the same as or different from the first insulating film 22. The third surface insulating film 55 may include an insulator that is the same as or different from the second insulating film 23. The third surface insulating film 55 may include an insulator that is the same as or different from the third insulating film 24.

The third surface insulating film 55 may include an insulator that is the same as or different from the first surface insulating film 53. The third surface insulating film 55 may include an insulator that is the same as or different from the second surface insulating film 54. In this embodiment, the third surface insulating film 55 has a single layer structure consisting of the silicon oxide film. The silicon oxide film may consist of an NSG film, a PSG film, or a BPSG film. The second surface film portion 52 preferably includes an oxide other than the oxide of the chip 2. In this embodiment, the third surface insulating film 55 is consisting of an NSG film.

A thickness of the third surface insulating film 55 may be greater than or less than the first thickness of the first film portion 20. The thickness of the third surface insulating film 55 may be greater than or less than the second thickness of the second film portion 21. The thickness of the third surface insulating film 55 may be greater than or less than the thickness of the second insulating film 23. The thickness of the third surface insulating film 55 may be greater than or less than the thickness of the third insulating film 24.

The thickness of the third surface insulating film 55 may be greater than or less than the third thickness of the first surface film portion 51. The thickness of the third surface insulating film 55 may be greater than or less than the thickness of the first surface insulating film 53. The thickness of the third surface insulating film 55 may be greater than or less than the thickness of the second surface insulating film 54. In this embodiment, the thickness of the third surface insulating film 55 is greater than the thickness of the first insulating film 22, the thickness of the second insulating film 23, the thickness of the third insulating film 24, the thickness of the first surface insulating film 53, and the thickness of the second surface insulating film 54.

The thickness of the third surface insulating film 55 may be not less than 10 nm and not more than 1000 nm. The thickness of the third surface insulating film 55 may have a value belonging to at least one range among not less than 10 nm and not more than 50 nm, not less than 50 nm and not more than 100 nm, not less than 100 nm and not more than 150 nm, not less than 150 nm and not more than 200 nm, not less than 200 nm and not more than 250 nm, not less than 250 nm and not more than 300 nm, not less than 300 nm and not more than 350 nm, not less than 350 nm and not more than 400 nm, not less than 400 nm and not more than 450 nm, not less than 450 nm and not more than 500 nm, not less than 500 nm and not more than 600 nm, not less than 600 nm and not more than 700 nm, not less than 700 nm and not more than 800 nm, not less than 800 nm and not more than 900 nm, and not less than 900 nm and not more than 1000 nm.

The fourth surface insulating film 56 directly covers the third surface insulating film 55 in the periphery of the first surface film portion 51. The fourth surface insulating film 56 covers the third surface insulating film 55 in a film shape in a region on the peripheral edge side of the first main surface 3 with respect to the first surface film portion 51. The fourth surface insulating film 56 covers the outer well region 45, the outer contact region 46, and the plurality of field regions 47 across the third surface insulating film 55.

The fourth surface insulating film 56 may have a portion extending in a band shape in the first direction X and a portion extending in a band shape in the second direction Y. The fourth surface insulating film 56 may be formed in a polygonal annular shape (quadrilateral annular shape) surrounding the plurality of gate structures 15 (active region 8) in plan view. The fourth surface insulating film 56 is continuous with the first to fourth side surfaces 5A to 5D. The fourth surface insulating film 56 may be formed at an interval inward from the first to fourth side surfaces 5A to 5D, and may expose any one or both of the peripheral edge portion of the first main surface 3 and the third surface insulating film 55.

The fourth surface insulating film 56 may include at least one of a silicon oxide film, a silicon nitride film, and a silicon oxynitride film. The fourth surface insulating film 56 may include an insulator that is the same as or different from the first insulating film 22. The fourth surface insulating film 56 may include an insulator that is the same as or different from the second insulating film 23. The fourth surface insulating film 56 may include an insulator that is the same as or different from the third insulating film 24.

The fourth surface insulating film 56 may include an insulator that is the same as or different from the first surface insulating film 53. The fourth surface insulating film 56 may include an insulator that is the same as or different from the second surface insulating film 54. The fourth surface insulating film 56 may include an insulator that is the same as or different from the third surface insulating film 55.

In this embodiment, the fourth surface insulating film 56 has a single layer structure consisting of a silicon oxide film. The silicon oxide film may consist of an NSG film, a PSG film, or a BPSG film. In this embodiment, the fourth surface insulating film 56 is consisting of an NSG film.

In this embodiment, the fourth surface insulating film 56 is consisting of the same insulating film as the first surface insulating film 53, and is connected to the first surface insulating film 53. That is, the fourth surface insulating film 56 is formed integrally with the second insulating film 23 and the first surface insulating film 53. The fourth surface insulating film 56 is formed as a lead-out portion of the first surface insulating film 53, and is led out from above the first main surface 3 onto the third surface insulating film 55.

A thickness of the fourth surface insulating film 56 may be greater than or less than the first thickness of the first film portion 20. The thickness of the fourth surface insulating film 56 may be greater than or less than the second thickness of the second film portion 21. The thickness of the fourth surface insulating film 56 may be greater than or less than the thickness of the second insulating film 23. The thickness of the fourth surface insulating film 56 may be greater than or less than the thickness of the third insulating film 24.

The thickness of the third surface insulating film 55 may be greater than or less than the third thickness of the first surface film portion 51. The thickness of the fourth surface insulating film 56 may be greater than or less than the thickness of the first surface insulating film 53. The thickness of the fourth surface insulating film 56 may be greater than or less than the thickness of the second surface insulating film 54. The thickness of the fourth surface insulating film 56 may be greater than or less than the thickness of the third surface insulating film 55. In this embodiment, the thickness of the fourth surface insulating film 56 is substantially equal to the thickness of the second insulating film 23 and the thickness of the first surface insulating film 53.

The thickness of the fourth surface insulating film 56 may be not less than 10 nm and not more than 250 nm. The thickness of the fourth surface insulating film 56 may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

The fifth surface insulating film 57 directly covers the fourth surface insulating film 56 in the periphery of the first surface film portion 51. The fifth surface insulating film 57 covers the fourth surface insulating film 56 in a film shape in a region on the peripheral edge side of the first main surface 3 with respect to the first surface film portion 51. The fourth surface insulating film 56 covers the outer well region 45, the outer contact region 46, and the plurality of field regions 47 across the third surface insulating film 55 and the fourth surface insulating film 56.

The fifth surface insulating film 57 is continuous with the first to fourth side surfaces 5A to 5D. The fifth surface insulating film 57 may be formed at an interval inward from the first to fourth side surfaces 5A to 5D, and may expose at least one of the peripheral edge portion of the first main surface 3, the third surface insulating film 55, and the fourth surface insulating film 56.

The fifth surface insulating film 57 may include at least one of a silicon oxide film, a silicon nitride film, and a silicon oxynitride film. The fifth surface insulating film 57 may include an insulator that is the same as or different from the first insulating film 22. The fifth surface insulating film 57 may include an insulator that is the same as or different from the second insulating film 23. The fifth surface insulating film 57 may include an insulator that is the same as or different from the third insulating film 24.

The fifth surface insulating film 57 may include an insulator that is the same as or different from the first surface insulating film 53. The fifth surface insulating film 57 may include an insulator that is the same as or different from the second surface insulating film 54. The fifth surface insulating film 57 may include an insulator that is the same as or different from the third surface insulating film 55. The fifth surface insulating film 57 may include an insulator that is the same as or different from the fourth surface insulating film 56.

In this embodiment, the fifth surface insulating film 57 has a single layer structure consisting of a silicon oxide film. The silicon oxide film may consist of an NSG film, a PSG film, or a BPSG film. In this embodiment, the fifth surface insulating film 57 is consisting of an NSG film.

In this embodiment, the fifth surface insulating film 57 is consisting of the same insulating film as the second surface insulating film 54, and is connected to the second surface insulating film 54. That is, the fifth surface insulating film 57 is formed integrally with the third insulating film 24 and the second surface insulating film 54. The fifth surface insulating film 57 is formed as a lead-out portion of the second surface insulating film 54, and is led out from above the first main surface 3 onto the fourth surface insulating film 56.

A thickness of the fifth surface insulating film 57 may be greater than or less than the first thickness of the first film portion 20. The thickness of the fifth surface insulating film 57 may be greater than or less than the second thickness of the second film portion 21. The thickness of the fifth surface insulating film 57 may be greater than or less than the thickness of the second insulating film 23. The thickness of the fifth surface insulating film 57 may be greater than or less than the thickness of the third insulating film 24.

The thickness of the fifth surface insulating film 57 may be greater than or less than the third thickness of the first surface film portion 51. The thickness of the fifth surface insulating film 57 may be greater than or less than the thickness of the first surface insulating film 53. The thickness of the fifth surface insulating film 57 may be greater than or less than the thickness of the second surface insulating film 54. The thickness of the fifth surface insulating film 57 may be greater than or less than the thickness of the third surface insulating film 55. In this embodiment, the thickness of the fifth surface insulating film 57 is substantially equal to the thickness of the third insulating film 24 and the thickness of the second surface insulating film 54.

The thickness of the fifth surface insulating film 57 may be not less than 10 nm and not more than 250 nm. The thickness of the fifth surface insulating film 57 may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

The fourth thickness (that is, a total thickness of the third surface insulating film 55, the fourth surface insulating film 56, and the fifth surface insulating film 57) of the second surface film portion 52 is greater than the first thickness, the second thickness, and the third thickness. A thickness ratio of the fourth thickness with respect to the third thickness may be greater than 1 and not more than 20. The thickness ratio may have a value belonging to at least one range among greater than 1 and not more than 2.5, not less than 2.5 and not more than 5, not less than 5 and not more than 7.5, not less than 7.5 and not more than 10, not less than 10 and not more than 12.5, not less than 12.5 and not more than 15, not less than 15 and not more than 17.5, and not less than 17.5 and not more than 20.

The fourth thickness may be not less than 30 nm and not more than 1500 nm. The fourth thickness may have a value belonging to at least one range among not less than 30 nm and not more than 50 nm, not less than 50 nm and not more than 100 nm, not less than 100 nm and not more than 150 nm, not less than 150 nm and not more than 200 nm, not less than 200 nm and not more than 250 nm, not less than 250 nm and not more than 300 nm, not less than 300 nm and not more than 350 nm, not less than 350 nm and not more than 400 nm, not less than 400 nm and not more than 450 nm, not less than 450 nm and not more than 500 nm, not less than 500 nm and not more than 600 nm, not less than 600 nm and not more than 700 nm, not less than 700 nm and not more than 800 nm, not less than 800 nm and not more than 900 nm, not less than 900 nm and not more than 1000 nm, not less than 1000 nm and not more than 1100 nm, not less than 1100 nm and not more than 1200 nm, not less than 1200 nm and not more than 1300 nm, not less than 1300 nm and not more than 1400 nm, and not less than 1400 nm and not more than 1500 nm.

With reference to FIGS. 3 and 4, the semiconductor device 1 includes one or more (in this embodiment, one) gate wirings 60 arranged on the first main surface 3 in the outer peripheral region 9. The gate wiring 60 applies a gate potential to the plurality of gate structures 15. The gate wiring 60 may contain either or both of a conductive polysilicon of the p-type and a conductive polysilicon of the n-type. The gate wiring 60 preferably has the same conductivity type as the conductivity type of the embedded electrode 18.

The gate wiring 60 is arranged on the surface insulating film 50. The gate wiring 60 is selectively routed on the surface insulating film 50 at an interval from the peripheral edge of the first main surface 3 toward the plurality of gate structures 15, and opposes the outer well region 45 across the surface insulating film 50.

The gate wiring 60 extends in a band shape along the periphery of the plurality of gate structures 15. The gate wiring 60 has a portion extending in the first direction X and a portion extending in the second direction Y. The gate wiring 60 extends in a band shape to intersect (specifically, is orthogonal to) the end portions (in this embodiment, both end portions) of the plurality of gate structures 15.

In this embodiment, the gate wiring 60 is formed in an endless polygonal annular shape (for example, a quadrilateral annular shape) having four sides parallel to the peripheral edge of the first main surface 3, and surrounds the plurality of gate structures 15 (active region 8). As a matter of course, the gate wiring 60 may be formed in a band shape with ends. The gate wiring 60 may have an edge portion connecting a portion extending in the first direction X and a portion extending in the second direction Y in an arcuate shape (preferably, a quarter arcuate shape) in plan view.

The gate wiring 60 has an inner edge portion on the inner side of the first main surface 3 and an outer edge portion on the peripheral edge side of the first main surface 3. The inner edge portion of the gate wiring 60 is arranged on the first surface film portion 51 and opposes the outer well region 45 across the first surface film portion 51. The inner edge portion of the gate wiring 60 covers the end portions (in this embodiment, both end portions) of the plurality of gate structures 15, and is mechanically and electrically connected to the plurality of gate structures 15.

Specifically, the inner edge portion of the gate wiring 60 is mechanically and electrically connected to the plurality of embedded electrodes 18. In this embodiment, the inner edge portion of the gate wiring 60 is integrally formed with the plurality of embedded electrodes 18. That is, the gate wiring 60 is formed as a lead-out portion of the plurality of embedded electrodes 18, and is led out from the trench 16 onto the first surface film portion 51.

The inner edge portion of the gate wiring 60 has a portion positioned in the regions between the plurality of gate structures 15, and opposes one or both of the body region 10 and the outer well region 45 across the first surface film portion 51 (surface insulating film 50). The inner edge portion of the gate wiring 60 is formed at an interval toward the peripheral edge side of the first main surface 3 from the plurality of source regions 40 and the plurality of contact regions 42 that are arranged on the outermost side.

The outer edge portion of the gate wiring 60 is formed as a lead-out portion led out from above the first surface film portion 51 to above the second surface film portion 52, and is arranged on the second surface film portion 52. The outer edge portion of the gate wiring 60 opposes the outer well region 45 across the second surface film portion 52.

The outer edge portion of the gate wiring 60 is formed at an interval from the plurality of field regions 47 toward the plurality of gate structures 15 side. Specifically, the outer edge portion of the gate wiring 60 is formed at an interval from the outer edge portion of the outer well region 45 toward the plurality of gate structures 15 side. The outer edge portion of the gate wiring 60 is formed at an interval from the inner edge portion of the outer contact region 46 toward the plurality of gate structures 15 side.

An outer hidden area of the gate wiring 60 with respect to the second surface film portion 52 is greater than an inner hidden area of the gate wiring 60 with respect to the first surface film portion 51. An area ratio of the outer hidden area with respect to the inner hidden area may be greater than 1 and not more than 25.

The area ratio may have a value belonging to at least one range among greater than 1 and not more than 2.5, not less than 2.5 and not more than 5, not less than 5 and not more than 7.5, not less than 7.5 and not more than 10, not less than 10 and not more than 12.5, not less than 12.5 and not more than 15, not less than 15 and not more than 17.5, not less than 17.5 and not more than 20, not less than 20 and not more than 22.5, and not less than 22.5 and not more than 25. The area ratio is preferably not less than 5. The area ratio is preferably not more than 15.

The semiconductor device 1 may include the plurality of gate wirings 60. In this case, the plurality of gate wirings 60 may be arranged at least at both end portions of the plurality of gate structures 15. One gate wiring 60 may have a portion extending in a band shape in the first direction X, and may intersect (specifically, be orthogonal to) one end portion of the plurality of gate structures 15. The other gate wiring 60 may have a portion extending in a band shape in the first direction X, and may intersect (specifically, be orthogonal to) the other end portion of the plurality of gate structures 15. As a matter of course, the plurality of gate wirings 60 may have a portion extending in the second direction Y.

The semiconductor device 1 includes a gate pad wiring 61 arranged on the first main surface 3 in the outer peripheral region 9. The gate pad wiring 61 is electrically connected to the gate wiring 60, and applies the gate potential to the gate wiring 60. The gate pad wiring 61 may contain either or both of a conductive polysilicon of the p-type and a conductive polysilicon of the n-type.

The gate pad wiring 61 preferably has the same conductivity type as the conductivity type of the embedded electrodes 18 of the plurality of gate structures 15. The gate pad wiring 61 includes the same conductive material as the conductive material of the gate wiring 60, and has a thickness substantially equal to the thickness of the gate wiring 60.

In this embodiment, the gate pad wiring 61 is arranged in a region on the third side surface 5C side with respect to a central portion of the first main surface 3. In this embodiment, the gate pad wiring 61 is arranged in a portion along the central portion of the third side surface 5C in the first direction X. The gate pad wiring 61 may be arranged in a region along any corner portion of the first main surface 3. In this embodiment, the gate pad wiring 61 is formed in a polygonal shape (in this embodiment, quadrangular shape) having four sides parallel to the peripheral edge of the chip 2 in plan view.

The gate pad wiring 61 is arranged on the surface insulating film 50. In this embodiment, the gate pad wiring 61 is arranged in a region defined by the plurality of gate structures 15 adjacent to each other in the second direction Y in the outer peripheral region 9 in plan view. That is, the gate pad wiring 61 opposes the plurality of gate structures 15 on both sides in the second direction Y, and opposes the plurality of gate structures 15 in the first direction X.

The peripheral edge portion of the gate pad wiring 61 is connected to a portion of the gate wiring 60 extending in the second direction Y on the third side surface 5C side. In this embodiment, the gate pad wiring 61 is arranged on the second surface film portion 52 and opposes the outer well region 45 across the second surface film portion 52. The gate pad wiring 61 may be arranged on the first surface film portion 51 and have a portion opposing the outer well region 45 across the first surface film portion 51.

The gate pad wiring 61 is formed at an interval from the plurality of field regions 47 toward the plurality of gate structures 15 side. Specifically, the gate pad wiring 61 is formed at an interval from the outer edge portion of the outer well region 45 toward the plurality of gate structures 15 side. The gate pad wiring 61 may have a portion led out from the outer edge portion of the outer well region 45 to the peripheral edge side of the first main surface 3 and opposing the second semiconductor layer 7 across the surface insulating film 50.

The peripheral edge portion of the gate pad wiring 61 covers the end portions of the plurality of gate structures 15 adjacent to each other in the second direction Y, and is mechanically and electrically connected to the plurality of gate structures 15. In this embodiment, the peripheral edge portion of the gate pad wiring 61 is integrally formed with the plurality of embedded electrodes 18 as a lead-out portion of the plurality of embedded electrodes 18. That is, the gate pad wiring 61 is consisting of lead-out portions led out from the plurality of embedded electrodes 18 onto the first surface film portion 51.

In this embodiment, the peripheral edge portion of the gate pad wiring 61 is positioned in the region between the plurality of gate structures 15, and opposes one or both of the body region 10 and the outer well region 45 across the first surface film portion 51. The peripheral edge portion of the gate pad wiring 61 is formed at an interval from the plurality of source regions 40 and the plurality of contact regions 42 arranged outermost.

The peripheral edge portion of the gate pad wiring 61 may have a portion opposing the one or more source regions 40. The peripheral edge portion of the gate pad wiring 61 may have a portion opposing the one or more contact regions 42. In this embodiment, the configuration in which the peripheral edge portion of the gate pad wiring 61 is connected to the plurality of gate structures 15 is illustrated. However, the peripheral edge portion of the gate pad wiring 61 may be formed at an interval from the plurality of gate structures 15.

The semiconductor device 1 includes an interlayer film 65 having insulating properties and covering the surface insulating film 50. The interlayer film 65 may be referred to as an "insulating film," an "interlayer insulating film," an "intermediate insulating film," or the like. The interlayer film 65 may include at least one of a silicon oxide film, a silicon nitride film, and a silicon oxynitride film.

The interlayer film 65 may include an insulator that is the same as or different from the first surface insulating film 53. The interlayer film 65 may include an insulator that is the same as or different from the second surface insulating film 54. The interlayer film 65 may include an insulator that is the same as or different from the third surface insulating film 55. The interlayer film 65 may include an insulator that is the same as or different from the fourth surface insulating film 56. The interlayer film 65 may include an insulator that is the same as or different from the fifth surface insulating film 57.

The interlayer film 65 may have a single layer structure consisting of a single silicon oxide film or a laminated structure including a plurality of silicon oxide films. The single or plurality of silicon oxide films may include at least one of an NSG film, a PSG film, and a BPSG film. The interlayer film 65 preferably includes the same type of insulator as the embedded insulator 19.

The interlayer film 65 covers the surface insulating film 50 in a film shape in the outer peripheral region 9. Specifically, the interlayer film 65 directly covers the second surface film portion 52 in a film shape, and opposes the outer well region 45, the outer contact region 46, and the plurality of field regions 47 across the second surface film portion 52.

The interlayer film 65 covers the gate wiring 60 and the gate pad wiring 61. The interlayer film 65 covers the entire region of the gate wiring 60 and the entire region of the gate pad wiring 61. The interlayer film 65 has a portion opposing the first surface film portion 51 across the gate wiring 60 and a portion opposing the second surface film portion 52 across the gate wiring 60. The interlayer film 65 has a portion opposing the outer well region 45 across the gate wiring 60 and a portion opposing the outer well region 45 across the gate pad wiring 61.

The interlayer film 65 has an inner edge portion at the inner side of the first main surface 3 and the outer edge portion on the peripheral edge side of the first main surface 3. The inner edge portion of the interlayer film 65 is arranged in the active region 8. The inner edge portion of the interlayer film 65 is positioned on the inner side of the first main surface 3 with respect to the inner edge portion of the gate wiring 60 and the peripheral edge portion of the gate pad wiring 61, and covers the end portions of the plurality of gate structures 15.

The inner edge portion of the interlayer film 65 covers the embedded electrode 18 at the end portions of the plurality of gate structures 15 and is connected to the embedded insulator 19. In this embodiment, the interlayer film 65 is formed integrally with the embedded insulator 19. A portion of the interlayer film 65 positioned in the trench 16 is formed as the embedded insulator 19. The connection portion of the interlayer film 65 with respect to the embedded insulator 19 may be regarded as a part of the embedded insulator 19 or may be regarded as a part of the interlayer film 65.

The inner edge portion of the interlayer film 65 has a portion positioned in the region between the plurality of gate structures 15. The inner edge portion of the interlayer film 65 covers one or both of the body region 10 and the outer well region 45 across the surface insulating film 50 (first surface film portion 51) in the region between the plurality of gate structures 15.

The outer edge portion of the interlayer film 65 is continuous with the first to fourth side surfaces 5A to 5D. The outer edge portion of the interlayer film 65 may be formed at an interval inward from the first to fourth side surfaces 5A to 5D, and may expose one or both of the peripheral edge portion of the first main surface 3 and the surface insulating film 50. The outer edge portion of the interlayer film 65 may expose at least one of the peripheral edge portion of the first main surface 3, the third surface insulating film 55, the fourth surface insulating film 56, and the fifth surface insulating film 57.

A thickness of the interlayer film 65 may be greater than or less than the first thickness of the first film portion 20. The thickness of the interlayer film 65 may be greater than or less than the second thickness of the second film portion 21. The thickness of the interlayer film 65 may be greater than or less than the thickness of the first insulating film 22. The thickness of the interlayer film 65 may be greater than or less than the thickness of the second insulating film 23. The thickness of the interlayer film 65 may be greater than or less than the thickness of the third insulating film 24.

The thickness of the interlayer film 65 may be greater than or less than the third thickness of the first surface film portion 51. The thickness of the interlayer film 65 may be greater than or less than the fourth thickness of the second surface film portion 52. The thickness of the interlayer film 65 may be greater than or less than the thickness of the first surface insulating film 53. The thickness of the interlayer film 65 may be greater than or less than the thickness of the second surface insulating film 54. The thickness of the interlayer film 65 may be greater than or less than the thickness of the third surface insulating film 55. The thickness of the interlayer film 65 may be greater than or less than the thickness of the fourth surface insulating film 56. The thickness of the interlayer film 65 may be greater than or less than the thickness of the fifth surface insulating film 57.

In this embodiment, the thickness of the interlayer film 65 is greater than the first thickness, the second thickness, the third thickness, and the fourth thickness. The thickness of the interlayer film 65 may be not less than 0.01 µm and not more than 5 µm. The thickness of the interlayer film 65 may be not less than 0.01 µm and not more than 0.1 µm, not less than 0.1 µm and not more than 0.5 µm, not less than 0.5 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The semiconductor device 1 includes one or more (in this embodiment, one) source openings 68 formed in the interlayer film 65. The source opening 68 penetrates the interlayer film 65 in the inner portion of the active region 8, and collectively exposes the plurality of gate structures 15 and the plurality of mesa portions 27. In this embodiment, the source opening 68 is formed in a polygonal shape (in this embodiment, a quadrangular shape having a recess portion recessed along the gate pad wiring 61) having four sides parallel to the peripheral edge of the first main surface 3 in plan view.

The source opening 68 is formed at an interval from the end portions (in this embodiment, both end portions) of the plurality of gate structures 15 toward the inner portion of the first main surface 3, and expose the inner portions of the plurality of gate structures 15 and the inner portions of the plurality of mesa portions 27. Specifically, the source opening 68 exposes the insulating films 17 and the embedded insulators 19 in the inner portion of the plurality of gate structures 15. The source opening 68 exposes at least the first film portion 20 of the insulating film 17. The source opening 68 may expose a part of the second film portion 21 of the insulating film 17.

The semiconductor device 1 includes a source pad electrode 70 arranged on the first main surface 3. The source pad electrode 70 may be referred to as a "first main surface electrode," a "first terminal (electrode)," a "first pad (electrode)," a "source electrode," or the like. The source pad electrode 70 is arranged on the interlayer film 65.

In this embodiment, the source pad electrode 70 includes a first pad portion 70a, a second pad portion 70b, and a third pad portion 70c. The first pad portion 70a has a relatively-large planar area, and forms a main body of the source pad electrode 70. In this embodiment, the first pad portion 70a is formed in a polygonal shape (in this embodiment, a quadrangular shape) having four sides parallel to the peripheral edge of the chip 2 in plan view, and is shifted to the fourth side surface 5D side with respect to the central portion of the first main surface 3.

The second pad portion 70b has a planar area less than the planar area of the first pad portion 70a, and is led out in a band shape (quadrangular shape) from one end portion (the end portion on the first side surface 5A side) of the first pad portion 70a in the second direction Y toward the third side surface 5C. The third pad portion 70c has a planar area less than the planar area of the first pad portion 70a, is led out in a band shape (quadrangular shape) from the other end portion (the end portion on the second side surface 5B side) of the first pad portion 70a in the second direction Y toward the third side surface 5C, and opposes the second pad portion 70b in the second direction Y.

The planar area of the third pad portion 70c may be substantially equal to the planar area of the second pad portion 70b. The planar area of the third pad portion 70c may be greater than or less than the planar area of the second pad portion 70b. Either or both of the second pad portion 70b and the third pad portion 70c may be used as a terminal portion for current monitoring.

The source pad electrode 70 does not necessarily have both the second pad portion 70b and the third pad portion 70c at the same time. The source pad electrode 70 may include only one of the second pad portion 70b and the third pad portion 70c. The source pad electrode 70 may be consisting of only the first pad portion 70a, and does not have to have both the second pad portion 70b and the third pad portion 70c.

The source pad electrode 70 collectively covers a region of the interlayer film 65 where the source opening 68 is formed in a film shape, and enters the source opening 68 from above the interlayer film 65. The source pad electrode 70 has a portion covering the interlayer film 65 in a film shape, a portion covering a wall surface of the source opening 68 in a film shape, and a portion covering the first main surface 3 in a film shape in the source opening 68.

The source pad electrode 70 has a portion covering the plurality of gate structures 15 and a portion covering the plurality of mesa portions 27 in the source opening 68. The source pad electrode 70 directly covers the plurality of embedded insulators 19 in a portion covering the plurality of gate structures 15, and is electrically separated from the plurality of embedded electrodes 18 by the plurality of embedded insulators 19.

In this embodiment, the source pad electrode 70 enters the plurality of trenches 16 from above the first main surface 3, and covers the plurality of embedded insulators 19 in the plurality of trenches 16. The source pad electrode 70 has a portion covering the insulating surfaces of the plurality of embedded insulators 19 in a region on the bottom wall side of the plurality of trenches 16 with respect to the height position of the first main surface 3.

The source pad electrode 70 has a portion covering the side walls and the opening ends of the plurality of trenches 16 in the plurality of trenches 16. The source pad electrode 70 is mechanically and electrically connected to the plurality of source regions 40 and the plurality of contact regions 42 in the portion covering the side walls and the opening ends of the plurality of trenches 16. The source pad electrode 70 is mechanically and electrically connected to the plurality of source regions 40 and the plurality of contact regions 42 in the portion covering the plurality of mesa portions 27.

The source pad electrode 70 has a peripheral edge portion opposing the end portions (both end portions) of the plurality of gate structures 15 across the interlayer film 65. The peripheral edge portion of the source pad electrode 70 is led out from the active region 8 to the outer peripheral region 9, and opposes a part of the gate wiring 60 across the interlayer film 65.

The peripheral edge portion of the source pad electrode 70 has a portion opposing the first surface film portion 51 across the gate wiring 60 and the interlayer film 65, and a portion opposing the second surface film portion 52 across the gate wiring 60 and the interlayer film 65. The peripheral edge portion of the source pad electrode 70 has a portion opposing the outer well region 45 via the gate wiring 60 and the first surface film portion 51 in the lamination direction, and a portion opposing the outer well region 45 via the gate wiring 60 and the second surface film portion 52.

The peripheral edge portion of the source pad electrode 70 is formed at an interval from the plurality of field regions 47 toward the plurality of gate structures 15 side. Specifically, the peripheral edge portion of the source pad electrode 70 is formed at an interval from the outer edge portion of the outer well region 45 toward the plurality of gate structures 15 side. The peripheral edge portion of the source pad electrode 70 is formed at an interval from the inner edge portion of the outer contact region 46 toward the plurality of gate structures 15 side.

The peripheral edge portion of the source pad electrode 70 is formed at an interval from the outer edge portion of the gate wiring 60 toward the inner edge portion side of the gate wiring 60. The peripheral edge portion of the source pad electrode 70 may be formed at an interval from the intermediate portion of the gate wiring 60 toward the inner edge portion side of the gate wiring 60.

The peripheral edge portion of the source pad electrode 70 may be arranged on the inner side of the first main surface 3 with respect to the second surface film portion 52, and may oppose the first surface film portion 51 in the lamination direction. The peripheral edge portion of the source pad electrode 70 may be formed at an interval from the gate wiring 60 toward the inner side of the first main surface 3.

The peripheral edge portion of the source pad electrode 70 may oppose a part of the gate pad wiring 61 across the interlayer film 65. In this embodiment, the peripheral edge portion of the source pad electrode 70 opposes the peripheral edge portion of the gate pad wiring 61 across the interlayer film 65, and exposes the inner portion of the gate pad wiring 61. As a matter of course, the peripheral edge portion of the source pad electrode 70 may be formed at an interval from the gate pad wiring 61.

In this embodiment, the source pad electrode 70 has a laminated structure including a lower electrode film 71 and a main electrode film 72 laminated in this order from the chip 2 side. In this embodiment, the lower electrode film 71 has a laminated structure including a first electrode film 73 and a second electrode film 74.

In this embodiment, the first electrode film 73 includes a Ti film, and the second electrode film 74 includes a TiN film. The lower electrode film 71 is not necessarily required to have a laminated structure, and may have a single layer structure consisting of one of the first electrode film 73 (Ti film) and the second electrode film 74 (TiN film).

The first electrode film 73 has a thickness less than the thickness of the interlayer film 65. The thickness of the first electrode film 73 may be not less than 10 nm and not more than 100 nm. The thickness of the first electrode film 73 may have a value belonging to at least one range among not less than 10 nm and not more than 25 nm, not less than 25 nm and not more than 50 nm, not less than 50 nm and not more than 75 nm, and not less than 75 nm and not more than 100 nm.

The second electrode film 74 has a thickness less than the thickness of the interlayer film 65. The thickness of the second electrode film 74 is preferably greater than the thickness of the first electrode film 73. The thickness of the second electrode film 74 may be not less than 50 nm and not more than 200 nm. The thickness of the second electrode film 74 may have a value belonging to at least one range among not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, and not less than 175 nm and not more than 200 nm.

The first electrode film 73 collectively covers the region of the interlayer film 65 where the source opening 68 is formed in a film shape, and enters the source opening 68 from above the interlayer film 65. The first electrode film 73 has a portion covering the insulating surface of the interlayer film 65 in a film shape, a portion covering the wall surface of the source opening 68 in a film shape, and a portion covering the first main surface 3 in a film shape in the source opening 68.

The first electrode film 73 has a portion covering the plurality of gate structures 15 in the source opening 68 and a portion covering the plurality of mesa portions 27. The first electrode film 73 directly covers the plurality of embedded insulators 19 in a portion covering the plurality of gate structures 15, and is electrically separated from the plurality of embedded electrodes 18 by the plurality of embedded insulators 19.

In this embodiment, the first electrode film 73 enters the plurality of trenches 16 from above the first main surface 3 and covers the plurality of embedded insulators 19 in the plurality of trenches 16. In this embodiment, the first electrode film 73 has a portion covering the insulating surfaces of the plurality of embedded insulators 19 in a region on the bottom wall side of the plurality of trenches 16 with respect to the height position of the first main surface 3.

The first electrode film 73 has a portion covering the side walls and the opening ends of the plurality of trenches 16 in the plurality of trenches 16. The first electrode film 73 is mechanically and electrically connected to the plurality of source regions 40 and the plurality of contact regions 42 in a portion covering the side walls and the opening ends of the plurality of trenches 16. The first electrode film 73 is mechanically and electrically connected to the plurality of source regions 40 and the plurality of contact regions 42 in a portion covering the plurality of mesa portions 27.

The first electrode film 73 has a peripheral edge portion opposing the end portions (both end portions) of the plurality of gate structures 15 across the interlayer film 65. In this embodiment, the peripheral edge portion of the first electrode film 73 is led out from the active region 8 to the outer peripheral region 9, and opposes a part of the gate wiring 60 across the interlayer film 65.

The peripheral edge portion of the first electrode film 73 has a portion opposing the first surface film portion 51 across the gate wiring 60 and the interlayer film 65, and a portion opposing the second surface film portion 52 across the gate wiring 60 and the interlayer film 65. The peripheral edge portion of the first electrode film 73 has a portion opposing the outer well region 45 via the gate wiring 60 and the first surface film portion 51 in the lamination direction, and a portion opposing the outer well region 45 via the gate wiring 60 and the second surface film portion 52.

The peripheral edge portion of the first electrode film 73 is formed at an interval from the plurality of field regions 47 toward the plurality of gate structures 15 side. Specifically, the peripheral edge portion of the first electrode film 73 is formed at an interval from the outer edge portion of the outer well region 45 toward the plurality of gate structures 15 side. The peripheral edge portion of the first electrode film 73 is formed at an interval from the inner edge portion of the outer contact region 46 toward the plurality of gate structures 15 side.

The peripheral edge portion of the first electrode film 73 is formed at an interval from the outer edge portion of the gate wiring 60 toward the inner edge portion side of the gate wiring 60. The peripheral edge portion of the first electrode film 73 may be formed at an interval from the intermediate portion of the gate wiring 60 toward the inner edge portion side of the gate wiring 60.

The peripheral edge portion of the first electrode film 73 may oppose a part of the gate pad wiring 61 across the interlayer film 65. In this embodiment, the peripheral edge portion of the first electrode film 73 opposes the peripheral edge portion of the gate pad wiring 61 across the interlayer film 65, and exposes the inner portion of the gate pad wiring 61. As a matter of course, the peripheral edge portion of the first electrode film 73 may be formed at an interval from the gate pad wiring 61.

The second electrode film 74 directly covers the first electrode film 73. The second electrode film 74 collectively covers the region where the source opening 68 is formed in the interlayer film 65 in a film shape across the first electrode film 73, and enters the source opening 68 from above the interlayer film 65.

The second electrode film 74 has a portion covering the interlayer film 65 in a film shape across the first electrode film 73, a portion covering the wall surfaces of the source opening 68 in a film shape across the first electrode film 73, and a portion covering the first main surface 3 in a film shape across the first electrode film 73 in the source opening 68. The second electrode film 74 has a portion covering the plurality of gate structures 15 across the first electrode film 73 in the source opening 68, and a portion covering the plurality of mesa portions 27 across the first electrode film 73.

The second electrode film 74 covers the plurality of embedded insulators 19 across the first electrode film 73, and is electrically separated from the plurality of embedded electrodes 18. In this embodiment, the second electrode film 74 enters the plurality of trenches 16 from above the first main surface 3, and covers the plurality of embedded insulators 19 across the first electrode film 73 in the plurality of trenches 16.

In this embodiment, the second electrode film 74 covers the first electrode film 73 in a region on the bottom wall side of the plurality of trenches 16 with respect to the height position of the first main surface 3. In this embodiment, the second electrode film 74 has a portion covering the side walls and the opening ends of the plurality of trenches 16 across the first electrode film 73 in the plurality of trenches 16.

The second electrode film 74 is electrically connected to the plurality of source regions 40 and the plurality of contact regions 42 via the first electrode film 73 in a portion covering the side walls and the opening ends of the plurality of trenches 16. The second electrode film 74 may be connected to the first electrode film 73 above the first main surface 3. The second electrode film 74 is electrically connected to the plurality of source regions 40 and the plurality of contact regions 42 via the first electrode film 73 in a portion covering the plurality of mesa portions 27.

The second electrode film 74 has a peripheral edge portion opposing the end portions (both end portions) of the plurality of gate structures 15 across the interlayer film 65 and the first electrode film 73. The peripheral edge portion of the second electrode film 74 is led out from the active region 8 to the outer peripheral region 9, and opposes a part of the gate wiring 60 across the interlayer film 65 and the first electrode film 73.

The peripheral edge portion of the second electrode film 74 has a portion opposing the first surface film portion 51 across the gate wiring 60 and the interlayer film 65, and a portion opposing the second surface film portion 52 across the gate wiring 60 and the interlayer film 65. The peripheral edge portion of the second electrode film 74 has a portion opposing the outer well region 45 via the gate wiring 60 and the first surface film portion 51 in the lamination direction, and a portion opposing the outer well region 45 via the gate wiring 60 and the second surface film portion 52.

The peripheral edge portion of the second electrode film 74 is formed at an interval from the plurality of field regions 47 toward the plurality of gate structures 15 side. Specifically, the peripheral edge portion of the second electrode film 74 is formed at an interval from the outer edge portion of the outer well region 45 toward the plurality of gate structures 15 side. The peripheral edge portion of the second electrode film 74 is formed at an interval from the inner edge portion of the outer contact region 46 toward the plurality of gate structures 15 side.

The peripheral edge portion of the second electrode film 74 is formed at an interval from the outer edge portion of the gate wiring 60 toward the inner edge portion side of the gate wiring 60. The peripheral edge portion of the second electrode film 74 may be formed at an interval from the intermediate portion of the gate wiring 60 toward the inner edge portion side of the gate wiring 60.

The peripheral edge portion of the second electrode film 74 may oppose a part of the gate pad wiring 61 across the interlayer film 65 and the first electrode film 73. In this embodiment, the peripheral edge portion of the second electrode film 74 opposes the peripheral edge portion of the gate pad wiring 61 across the interlayer film 65 and the first electrode film 73, and exposes the inner portion of the gate pad wiring 61. As a matter of course, the peripheral edge portion of the second electrode film 74 may be formed at an interval from the gate pad wiring 61.

The main electrode film 72 includes a metal material different from the metal material of the lower electrode film 71 (the first electrode film 73 and the second electrode film 74). The main electrode film 72 may include at least one of an Al film, an Al alloy film, a Cu film, and a Cu alloy film. The Al alloy film (Cu alloy film) may include at least one of an AlSi alloy film, an AlCu alloy film, and an AlSiCu alloy film. The main electrode film 72 has a thickness greater than the thickness (total thickness) of the lower electrode film 71. The thickness of the main electrode film 72 is preferably greater than the thickness of the interlayer film 65.

The thickness of the main electrode film 72 may be not less than 0.5 µm and not more than 5 µm. The thickness of the main electrode film 72 may have a value belonging to at least one range among not less than 0.5 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The main electrode film 72 directly covers the lower electrode film 71 (second electrode film 74). The main electrode film 72 backfills the source opening 68 and collectively covers the region of the interlayer film 65 where the source opening 68 is formed in a film shape. The main electrode film 72 has a portion covering the interlayer film 65 across the lower electrode film 71, a portion covering the wall surface of the source opening 68 across the lower electrode film 71, and a portion covering the first main surface 3 across the lower electrode film 71.

The main electrode film 72 has a portion covering the plurality of gate structures 15 across the lower electrode film 71 in the source opening 68, and a portion covering the plurality of mesa portions 27 across the lower electrode film 71. The main electrode film 72 covers the plurality of embedded insulators 19 across the lower electrode film 71, and is electrically separated from the plurality of embedded electrodes 18.

The main electrode film 72 may enter the plurality of trenches 16 from above the first main surface 3, and cover the plurality of embedded insulators 19 across the lower electrode film 71 in the plurality of trenches 16. In this case, the main electrode film 72 may have a portion covering the side walls and the opening ends of the plurality of trenches 16 across the lower electrode film 71 in a region on the bottom wall side of the plurality of trenches 16 with respect to the height position of the first main surface 3. The main electrode film 72 may be connected to the lower electrode film 71 above the first main surface 3.

The main electrode film 72 is electrically connected to the plurality of source regions 40 and the plurality of contact regions 42 via the lower electrode film 71 in a portion covering the side walls and the opening ends of the plurality of trenches 16. The main electrode film 72 is electrically connected to the plurality of source regions 40 and the plurality of contact regions 42 via the lower electrode film 71 in a portion covering the plurality of mesa portions 27.

The main electrode film 72 has a peripheral edge portion opposing the end portions (both end portions) of the plurality of gate structures 15 across the interlayer film 65 and the lower electrode film 71. The peripheral edge portion of the main electrode film 72 may be led out from the active region 8 to the outer peripheral region 9, and may oppose a part of the gate wiring 60 across the interlayer film 65 and the lower electrode film 71.

The peripheral edge portion of the main electrode film 72 has a portion opposing the first surface film portion 51 across the gate wiring 60 and the interlayer film 65, and a portion opposing the second surface film portion 52 across the gate wiring 60 and the interlayer film 65. The peripheral edge portion of the main electrode film 72 has a portion opposing the outer well region 45 via the gate wiring 60 and the first surface film portion 51 in the lamination direction, and a portion opposing the outer well region 45 via the gate wiring 60 and the second surface film portion 52.

The peripheral edge portion of the main electrode film 72 is formed at an interval from the plurality of field regions 47 toward the plurality of gate structures 15 side. Specifically, the peripheral edge portion of the main electrode film 72 is formed at an interval from the outer edge portion of the outer well region 45 toward the plurality of gate structures 15 side. The peripheral edge portion of the main electrode film 72 is formed at an interval from the inner edge portion of the outer contact region 46 toward the plurality of gate structures 15 side.

The peripheral edge portion of the main electrode film 72 is formed at an interval from the outer edge portion of the gate wiring 60 toward the inner edge portion side of the gate wiring 60. The peripheral edge portion of the main electrode film 72 may be formed at an interval from the intermediate portion of the gate wiring 60 toward the inner edge portion side of the gate wiring 60.

The peripheral edge portion of the main electrode film 72 may oppose a part of the gate pad wiring 61 across the interlayer film 65 and the lower electrode film 71. In this embodiment, the peripheral edge portion of the main electrode film 72 opposes the peripheral edge portion of the gate pad wiring 61 across the interlayer film 65 and the lower electrode film 71, and exposes the inner portion of the gate pad wiring 61. As a matter of course, the peripheral edge portion of the main electrode film 72 may be formed at an interval from the gate pad wiring 61.

The semiconductor device 1 includes one or more (in this embodiment, a plurality of) gate openings 79 formed in the interlayer film 65. The plurality of gate openings 79 penetrate the interlayer film 65 and selectively expose the gate wiring 60. In this embodiment, the plurality of gate openings 79 extend in a band shape following the extension direction of the gate wiring 60.

The plurality of gate openings 79 may be formed at intervals along the extension direction of the gate wiring 60. The plurality of gate openings 79 may be formed in a polygonal shape or a circular shape in plan view. For example, the plurality of gate structures 15 may be formed in a quadrangular shape or a hexagonal shape in plan view.

The plurality of gate openings 79 may have a portion extending in a band shape in the first direction X and a portion extending in a band shape in the second direction Y in plan view. The plurality of gate openings 79 may have an edge portion connecting a portion extending in the first direction X and a portion extending in the second direction Y in an arcuate shape (preferably, a quarter arcuate shape) in plan view.

The semiconductor device 1 includes a gate pad electrode 80 arranged on the first main surface 3 at an interval from the source pad electrode 70. The gate pad electrode 80 may be referred to as a "second main surface electrode," a "second terminal (electrode)," a "second pad (electrode)," a "gate electrode," or the like. The gate pad electrode 80 is arranged on the interlayer film 65 at an interval from the source pad electrode 70.

In this embodiment, the gate pad electrode 80 is arranged on a portion of the interlayer film 65 covering the gate pad wiring 61, and opposes the gate pad wiring 61 across the interlayer film 65. In this embodiment, the gate pad electrode 80 does not have a direct electrical connection portion with respect to the gate pad wiring 61. As a matter of course, the gate pad electrode 80 may be mechanically and electrically connected to the gate pad wiring 61 via one or more gate openings 79.

The gate pad electrode 80 is arranged in a region on the third side surface 5C side with respect to the first pad portion 70a, and opposes the central portion of the third side surface 5C and the first pad portion 70a in the first direction X. The gate pad electrode 80 is interposed in a region between the second pad portion 70b and the third pad portion 70c, and opposes both the second pad portion 70b and the third pad portion 70c in the second direction Y.

The gate pad electrode 80 is formed in a polygonal shape (in this embodiment, a quadrangular shape) having four sides parallel to the peripheral edges of the chip 2 in plan view. The gate pad electrode 80 has a planar area less than the planar area of the source pad electrode 70. The gate pad electrode 80 has a planar area less than the planar area of the first pad portion 70a. The gate pad electrode 80 may have a planar area less than the planar area of the second pad portion 70b (third pad portion 70c).

The gate pad electrode 80 opposes the outer well region 45 across the interlayer film 65 and the gate pad wiring 61. In this embodiment, the gate pad electrode 80 is formed at an interval from the end portions (both end portions) of the plurality of gate structures 15. That is, the gate pad electrode 80 does not oppose the plurality of gate structures 15 in the lamination direction. As a matter of course, the gate structure 15 may have a portion opposing a part (for example, an end portion) of the gate structure 15 across the interlayer film 65.

Although not illustrated, similarly to the source pad electrode 70, the gate pad electrode 80 includes the lower electrode film 71 and the main electrode film 72 laminated in this order from the interlayer film 65 side. In this embodiment, the lower electrode film 71 has a laminated structure including the first electrode film 73 and the second electrode film 74.

The semiconductor device 1 includes a gate finger electrode 81 led out from the gate pad electrode 80 above the first main surface 3. The gate finger electrode 81 may be referred to as a "gate wiring," a "gate finger," or the like. The gate finger electrode 81 transmits the gate potential applied to the gate pad electrode 80 to another region.

The gate finger electrode 81 is led out from the gate pad electrode 80 onto a portion of the interlayer film 65 covering the gate wiring 60. The gate finger electrode 81 is routed in a band shape to a region between the peripheral edge of the first main surface 3 and the source pad electrode 70. The gate finger electrode 81 has a portion extending in a band shape in the first direction X and a portion extending in a band shape in the second direction Y in plan view.

In this embodiment, the gate finger electrode 81 is formed in a band shape with ends and four sides parallel to the peripheral edge of the first main surface 3, and surrounds the source pad electrode 70. The gate finger electrode 81 is arranged closer to the peripheral edge side of the first main surface 3 than both end portions of the plurality of gate structures 15. The gate finger electrode 81 may have an edge portion connecting a portion extending in the first direction X and a portion extending in the second direction Y in an arcuate shape (preferably, a quarter arcuate shape).

The gate finger electrode 81 enters the plurality of gate openings 79 from above the interlayer film 65, and is mechanically and electrically connected to the gate wiring 60 in the plurality of gate openings 79. As a result, the gate potential applied to the gate pad electrode 80 is applied to the plurality of gate structures 15 via the gate finger electrode 81.

The gate finger electrode 81 has an inner edge portion at the inner side of the first main surface 3 and the outer edge portion at the peripheral edge side of the first main surface 3. The inner edge portion of the gate finger electrode 81 is formed at an interval from the end portions of the plurality of gate structures 15 toward the peripheral edge side of the first main surface 3. That is, the gate finger electrode 81 does not oppose the plurality of gate structures 15 in the lamination direction.

In this embodiment, the peripheral edge portion of the gate finger electrode 81 is arranged at an interval from the first surface film portion 51 toward the peripheral edge side of the first main surface 3, and opposes the second surface film portion 52 in the lamination direction. That is, the gate finger electrode 81 does not oppose the first surface film portion 51 in the lamination direction. The inner edge portion of the gate finger electrode 81 may be arranged on the inner side of the first main surface 3 with respect to the second surface film portion 52, and may oppose the first surface film portion 51 in the lamination direction.

The inner edge portion of the gate finger electrode 81 is arranged on the gate wiring 60. The inner edge portion of the gate finger electrode 81 opposes the peripheral edge portion of the source pad electrode 70 in the horizontal direction on the gate wiring 60. The inner edge portion of the gate finger electrode 81 is formed at an interval from the intermediate portion of the gate wiring 60 toward the peripheral edge side of the first main surface 3.

The outer edge portion of the gate finger electrode 81 is led out from above the gate wiring 60 to the peripheral edge side of the first main surface 3, and is arranged on the interlayer film 65 in a region outside the gate wiring 60. That is, the outer edge portion of the gate finger electrode 81 does not oppose the gate wiring 60 in the lamination direction. The outer edge portion of the gate finger electrode 81 is arranged at an interval from the innermost field region 47 toward the inner side of the first main surface 3.

The outer edge portion of the gate finger electrode 81 is arranged at an interval from the outer edge portion of the outer well region 45 toward the inner side of the first main surface 3, and opposes the outer well region 45 across the surface insulating film 50 and the interlayer film 65. The outer edge portion of the gate finger electrode 81 may be arranged on the peripheral edge side of the first main surface 3 with respect to the outer edge portion of the outer well region 45, and may oppose the second semiconductor layer 7 in the lamination direction.

In this embodiment, similarly to the source pad electrode 70, the gate finger electrode 81 has a laminated structure including the lower electrode film 71 and the main electrode film 72 laminated in this order from the chip 2 side. In this embodiment, the lower electrode film 71 has a laminated structure including the first electrode film 73 and the second electrode film 74.

The first electrode film 73 collectively covers a region of the interlayer film 65 where the plurality of gate openings 79 are formed in a film shape, and enters the plurality of gate openings 79 from above the interlayer film 65. The first electrode film 73 has a portion covering the insulating surface of the interlayer film 65 in a film shape, a portion covering the wall surfaces of the plurality of gate openings 79 in a film shape, and a portion covering the gate wiring 60 in a film shape in the plurality of gate openings 79. The first electrode film 73 is mechanically and electrically connected to the gate wiring 60 in the plurality of gate openings 79.

The second electrode film 74 directly covers the first electrode film 73. The second electrode film 74 collectively covers a region where the plurality of gate openings 79 are formed in the interlayer film 65 in a film shape across the first electrode film 73, and enters the plurality of gate openings 79 from above the interlayer film 65.

The second electrode film 74 has a portion covering the interlayer film 65 in a film shape across the first electrode film 73, a portion covering the wall surfaces of the plurality of gate openings 79 in a film shape across the first electrode film 73, and a portion covering the first main surface 3 in a film shape across the first electrode film 73 in the plurality of gate openings 79. The second electrode film 74 is electrically connected to the gate wiring 60 across the first electrode film 73 in the plurality of gate openings 79.

The main electrode film 72 directly covers the lower electrode film 71 (second electrode film 74). The main electrode film 72 backfills the plurality of gate openings 79 and collectively covers a region of the interlayer film 65 where the plurality of gate openings 79 are formed in a film shape.

The main electrode film 72 has a portion covering the interlayer film 65 across the lower electrode film 71, a portion covering the wall surfaces of the plurality of gate openings 79 across the lower electrode film 71, and a portion covering the first main surface 3 across the lower electrode film 71. The main electrode film 72 is electrically connected to the gate wiring 60 across the lower electrode film 71 in the plurality of gate openings 79.

The semiconductor device 1 includes a first slit portion 82 defined in a region between the source pad electrode 70 and the gate finger electrode 81. The first slit portion 82 exposes the interlayer film 65. The first slit portion 82 is defined in a region between the end portions of the plurality of gate structures 15 and the plurality of field regions 47.

The first slit portion 82 is formed at an interval from the end portions of the plurality of gate structures 15 toward the peripheral edge side of the first main surface 3. The first slit portion 82 is defined at an interval from the outer edge portion of the outer well region 45 toward the inner side of the first main surface 3. The first slit portion 82 is defined at an interval from the inner edge portion of the outer contact region 46 toward the end portion side of the plurality of gate structures 15.

The first slit portion 82 overlaps the first main surface 3 in the lamination direction. The first slit portion 82 is defined at an interval from the end portions (in this embodiment, both end portions) of the plurality of gate structures 15 toward the peripheral edge side of the first main surface 3, and does not overlap the plurality of gate structures 15 in the lamination direction. The first slit portion 82 overlaps the gate wiring 60 across the interlayer film 65 in the lamination direction.

The first slit portion 82 overlaps the second surface film portion 52 across the gate wiring 60 and the interlayer film 65 in the lamination direction. The first slit portion 82 is defined at an interval from the first surface film portion 51 toward the peripheral edge side of the first main surface 3, and does not overlap the first surface film portion 51 in the lamination direction. The first slit portion 82 exposes a flat portion of the interlayer film 65 extending along the horizontal direction.

With reference to FIG. 14, the semiconductor device 1 includes at least one (in this embodiment, one) outer opening 83 formed in the interlayer film 65 in the outer peripheral region 9. The outer opening 83 is formed at an interval from the gate wiring 60 toward the peripheral edge side of the first main surface 3. The outer opening 83 penetrates the surface insulating film 50 and the interlayer film 65 and exposes the outer contact region 46.

The outer opening 83 has a width less than the width of the outer contact region 46, and exposes the inner portion of the outer contact region 46 at an interval from the inner edge portion and the outer edge portion of the outer contact region 46. The outer opening 83 may expose the outer well region 45.

In this embodiment, the outer opening 83 extends in a band shape following the extension direction of the outer contact region 46. In this embodiment, the outer opening 83 is formed in a polygonal annular shape (in this embodiment, a quadrilateral annular shape) having four sides parallel to the peripheral edge of the chip 2 in plan view, and surrounds the plurality of gate structures 15 (active region 8). The outer contact region 46 may have an edge portion connecting a portion extending in the first direction X and a portion extending in the second direction Y in an arcuate shape (preferably, a quarter arcuate shape).

The semiconductor device 1 may have the plurality of outer openings 83. In this case, the plurality of outer openings 83 may be formed at intervals following the extension direction of the outer contact region 46. Also, each of the plurality of outer openings 83 may extend in a band shape along the extension direction of the outer contact region 46.

The semiconductor device 1 includes a source finger electrode 85 led out from the source pad electrode 70 onto the first main surface 3. The source finger electrode 85 may be referred to as a "source wiring," a "source finger," or the like. The source finger electrode 85 transmits the gate potential applied to the source pad electrode 70 to other regions.

The source finger electrode 85 is arranged at an interval from the gate pad electrode 80 and the gate finger electrode 81. The source finger electrode 85 is arranged in a region on the peripheral edge side of the first main surface 3 with respect to both end portions of the plurality of gate structures 15. The source finger electrode 85 is formed at an interval from the first surface film portion 51 toward the peripheral edge side of the first main surface 3, and opposes the second surface film portion 52 in the lamination direction.

The source finger electrode 85 is led out from the source pad electrode 70 onto a portion of the interlayer film 65 covering the outer contact region 46. The source finger electrode 85 is routed in a band shape to a region between the peripheral edge of the first main surface 3 and the source pad electrode 70. The source finger electrode 85 has a portion extending in a band shape in the first direction X and a portion extending in a band shape in the second direction Y in plan view.

In this embodiment, the source finger electrode 85 is formed in a band shape with ends and four sides parallel to the peripheral edge of the first main surface 3, and surrounds the source pad electrode 70 and the gate finger electrode 81. The outer well region 45 may have an edge portion connecting a portion extending in the first direction X and a portion extending in the second direction Y in an arcuate shape (preferably, a quarter arcuate shape).

The source finger electrode 85 enters the plurality of outer openings 83 from above the interlayer film 65, and is mechanically and electrically connected to the outer contact region 46 in the plurality of outer openings 83. As a result, the gate potential applied to the source pad electrode 70 is applied to the plurality of gate structures 15 via the source finger electrode 85.

The source finger electrode 85 has an inner edge portion on the inner side of the first main surface 3 and an outer edge portion on the peripheral edge side of the first main surface 3. The inner edge portion of the source finger electrode 85 is arranged at an interval from the gate finger electrode 81 toward the peripheral edge side of the first main surface 3, and opposes the gate finger electrode 81 in the horizontal direction.

The inner edge portion of the source finger electrode 85 is formed at an interval from the intermediate portion of the outer contact region 46 toward the peripheral edge side of the first main surface 3. The inner edge portion of the source finger electrode 85 may be arranged on the outer well region 45 or may be arranged on the outer contact region 46.

The outer edge portion of the source finger electrode 85 is led out from above the outer contact region 46 to the peripheral edge side of the first main surface 3, and is arranged on the interlayer film 65 in a region outside the outer contact region 46. The outer edge portion of the source finger electrode 85 is arranged at an interval from the innermost field region 47 toward the inner side of the first main surface 3.

The outer edge portion of the source finger electrode 85 is arranged at an interval from the outer edge portion of the outer well region 45 toward the inner side of the first main surface 3, and opposes the outer well region 45 across the second surface film portion 52 and the interlayer film 65. The outer edge portion of the source finger electrode 85 may be led out from the outer edge portion of the outer well region 45 to the peripheral edge side of the first main surface 3, and may oppose the second semiconductor layer 7 across the second surface film portion 52 and the interlayer film 65.

In this embodiment, similarly to the source pad electrode 70, the source finger electrode 85 has a laminated structure including the lower electrode film 71 and the main electrode film 72 laminated in this order from the chip 2 side. In this embodiment, the lower electrode film 71 has a laminated structure including the first electrode film 73 and the second electrode film 74.

The first electrode film 73 collectively covers a region of the interlayer film 65 where the outer opening 83 is formed in a film shape, and enters the outer opening 83 from above the interlayer film 65. The first electrode film 73 has a portion covering the insulating surface of the interlayer film 65 in a film shape, a portion covering the wall surface of the outer opening 83 in a film shape, and a portion covering the first main surface 3 in a film shape in the outer opening 83. The first electrode film 73 is mechanically and electrically connected to the outer contact region 46 in the outer opening 83.

The second electrode film 74 directly covers the first electrode film 73. The second electrode film 74 collectively covers a region of the interlayer film 65 where the outer opening 83 is formed in a film shape across the first electrode film 73, and enters the outer opening 83 from above the interlayer film 65.

The second electrode film 74 has a portion covering the interlayer film 65 in a film shape across the first electrode film 73, a portion covering the wall surface of the outer opening 83 in a film shape across the first electrode film 73, and a portion covering the first main surface 3 in a film shape across the first electrode film 73 in the outer opening 83. The second electrode film 74 is electrically connected to the outer contact region 46 across the first electrode film 73 in the outer opening 83.

The main electrode film 72 directly covers the lower electrode film 71 (second electrode film 74). The main electrode film 72 backfills the outer opening 83 and collectively covers a region of the interlayer film 65 where the outer opening 83 is formed in a film shape.

The main electrode film 72 has a portion covering the interlayer film 65 across the lower electrode film 71, a portion covering the wall surface of the outer opening 83 across the lower electrode film 71, and a portion covering the first main surface 3 across the lower electrode film 71. The main electrode film 72 is electrically connected to the outer contact region 46 across the lower electrode film 71 in the outer opening 83.

The semiconductor device 1 includes a second slit portion 86 defined in a region between the gate finger electrode 81 and the source finger electrode 85. The second slit portion 86 is defined in a region between the outer edge portion of the gate wiring 60 and the outer edge portion of the outer well region 45, and overlaps the first main surface 3 in the lamination direction.

The second slit portion 86 is defined at an interval from the first surface film portion 51 toward the peripheral edge side of the first main surface 3, and overlaps the second surface film portion 52 across the interlayer film 65 in the lamination direction. The second slit portion 86 exposes a flat portion of the interlayer film 65 extending along the horizontal direction.

The semiconductor device 1 includes a drain pad electrode 87 covering the second main surface 4. The drain pad electrode 87 may be referred to as a "third main surface electrode," a "third terminal (electrode)," a "third pad (electrode)," a "drain electrode," or the like. The drain pad electrode 87 is mechanically and electrically connected to the first semiconductor layer 6. The drain pad electrode 87 forms an ohmic contact with the first semiconductor layer 6.

The drain pad electrode 87 may cover the entire region of the second main surface 4 to be continuous with the peripheral edge (first to fourth side surfaces 5A to 5D) of the second main surface 4. The drain pad electrode 87 may partially cover the second main surface 4 to expose the peripheral edge portion of the second main surface 4.

The breakdown voltage that can be applied between the source pad electrode 70 and the drain pad electrode 87 (between the first main surface 3 and the second main surface 4) may be not less than 500 V and not more than 3000 V. The breakdown voltage may have a value belonging to at least one range among not less than 500 V and not more than 750 V, not less than 750 V and not more than 1000 V, not less than 1000 V and not more than 1250 V, not less than 1250 V and not more than 1500 V, not less than 1500 V and not more than 1750 V, not less than 1750 V and not more than 2000 V, not less than 2000 V and not more than 2250 V, not less than 2250 V and not more than 2500 V, and not less than 2500 V and not more than 3000 V.

As described above, the semiconductor device 1 may include the chip 2 and the gate structure 15 of the trench electrode type. The chip 2 has the first main surface 3. The gate structure 15 is formed in the first main surface 3. The gate structure 15 includes the trench 16, the insulating film 17, and the embedded electrode 18.

The trench 16 is formed in the first main surface 3. The insulating film 17 covers the wall surface of the trench 16. The insulating film 17 includes the first film portion 20 covering the wall surface of the inner portion of the trench 16 and the second film portion 21 covering the wall surface of the end portion of the trench 16. The second film portion 21 has the thickness greater than the thickness of the first film portion 20. The embedded electrode 18 is embedded in the trench 16 across the insulating film 17.

According to this arrangement, the semiconductor device 1 having a novel layout is provided. For example, according to the semiconductor device 1, a part of the insulating film 17 is thickened at the end portion of the trench 16. As a result, the dielectric resistance against the electric field in the vicinity of the end portion of the gate structure 15 is improved.

The chip 2 may include SiC. According to this configuration, the semiconductor device 1 as an SiC semiconductor device having a novel layout is provided. According to this semiconductor device 1, the withstand voltage is further improved by the physical properties of SiC. In particular, in the case of the SiC semiconductor device, since the SiC semiconductor device is used under a relatively high voltage environment, the effect of improving the dielectric resistance by the configuration in which a part of the insulating film 17 is thickened at the end portion of the gate structure 15 is effective.

The first film portion 20 may cover the side wall and the bottom wall of the trench 16. The second film portion 21 may cover the side wall and the bottom wall of the trench 16. According to this configuration, the dielectric resistance at the side wall and the bottom wall of the end portion of the trench 16 is improved. The coverage area of the second film portion 21 with respect to the trench 16 may be less than the coverage area of the first film portion 20 with respect to the trench 16. According to this configuration, the dielectric resistance of the end portion of the gate structure 15 is locally improved.

The embedded electrode 18 may be embedded in the trench 16 at an interval from the first main surface 3 toward the bottom wall side of the trench 16. In this case, the gate structure 15 may include the embedded insulator 19 embedded above the embedded electrode 18 in the trench 16. According to this configuration, the dielectric resistance on the opening end side of the trench 16 is improved by the embedded insulator 19.

The embedded insulator 19 may be embedded in the trench 16 at an interval from the first main surface 3 toward the bottom wall side of the trench 16. According to this configuration, since the hidden area of the first main surface 3 caused by the insulating structure with respect to the gate structure 15 is reduced, the electrical contact location with respect to the first main surface 3 can be appropriately secured.

The semiconductor device 1 may include a surface insulating film 50. The surface insulating film 50 may cover the first main surface 3 in the periphery of the end portion of the gate structure 15 and be connected to the insulating film 17. According to this configuration, the dielectric resistance in the periphery of the end portion of the gate structure 15 is improved by the surface insulating film 50.

The surface insulating film 50 may include the first surface film portion 51 and the second surface film portion 52. The first surface film portion 51 covers the periphery of the end portion of the gate structure 15 and may have the thickness greater than the thickness of the first film portion 20 of the insulating film 17.

According to this configuration, the dielectric resistance in the periphery of the end portion of the gate structure 15 is improved by the first surface film portion 51 having the thickness greater than that of the first film portion 20. The second surface film portion 52 covers the periphery of the first surface film portion 51 and may have the thickness greater than the thickness of the second film portion 21 of the insulating film 17. According to this configuration, the dielectric resistance in the periphery of the first surface film portion 51 is improved by the second surface film portion 52 having the thickness greater than that of the second film portion 21.

The semiconductor device 1 may include the second semiconductor layer 7 (semiconductor layer) of the n-type, the gate structure 15, and the outer well region 45 of the p-type. The second semiconductor layer 7 may be formed in the surface layer portion of the first main surface 3. The gate structure 15 may be formed in the first main surface 3 so as to be positioned in the second semiconductor layer 7. The outer well region 45 may be formed in the surface layer portion of the second semiconductor layer 7 in the periphery of the end portion of the gate structure 15.

According to this configuration, the depletion layer spreads from the outer well region 45 as a starting point in the periphery of the end portion of the gate structure 15. Accordingly, the electric field with respect to the end portion of the gate structure 15 is relaxed, and as a result, the dielectric resistance is improved. In this case, the surface insulating film 50 may cover the outer well region 45. According to this configuration, the electric field with respect to the surface insulating film 50 is relaxed, and as a result, the dielectric resistance is improved.

The semiconductor device 1 may include the second semiconductor layer 7 (semiconductor layer) of the n-type, the gate structure 15, and the outer well region 45 of the p-type. The second semiconductor layer 7 may be formed in the surface layer portion of the first main surface 3. The gate structure 15 may be formed in the first main surface 3 so as to be positioned in the second semiconductor layer 7. The outer well region 45 may be formed in the surface layer portion of the second semiconductor layer 7 in the periphery of the end portion of the gate structure 15.

According to this configuration, the depletion layer spreads from the outer well region 45 as a starting point in the periphery of the end portion of the gate structure 15. Accordingly, the electric field with respect to the end portion of the gate structure 15 is relaxed, and as a result, the dielectric resistance is improved. The outer well region 45 may oppose the embedded electrode 18 across the second film portion 21. According to this configuration, the electric field with respect to the second film portion 21 is relaxed, and as a result, the dielectric resistance is improved.

The semiconductor device 1 may include the second semiconductor layer 7 (semiconductor layer) of the n-type, the gate structure 15, and the well region 30 of the p-type. The second semiconductor layer 7 may be formed in the surface layer portion of the first main surface 3. The gate structure 15 may be formed in the first main surface 3 so as to be positioned in the second semiconductor layer 7. The well region 30 may be formed below the gate structure 15 in the second semiconductor layer 7.

According to this configuration, the depletion layer spreads from the well region 30 as a starting point. As a result, the electric field with respect to the gate structure 15 is relaxed, and as a result, the dielectric resistance is improved. The well region 30 may have the portion along the second film portion 21 of the insulating film 17. According to this configuration, the electric field with respect to the bottom wall of the gate structure 15 is relaxed, and as a result, the dielectric resistance is improved.

The semiconductor device 1 includes the body region 10 of the p-type, the gate structure 15, and the contact region 42 of the p-type. The body region 10 is formed in the surface layer portion of the first main surface 3. The gate structure 15 is formed in the first main surface 3 so as to penetrate the body region 10. The contact region 42 extends along the side wall of the gate structure 15 and electrically connects the well region 30 to the body region 10. According to this configuration, the electrical response characteristics of the well region 30 can be appropriately enhanced.

The semiconductor device 1 may include the outer well region 45 of the p-type. The outer well region 45 may be formed in the surface layer portion of the second semiconductor layer 7 in the periphery of the end portion of the gate structure 15. According to this configuration, the depletion layer spreads from the outer well region 45 as a starting point in the periphery of the end portion of the gate structure 15. Accordingly, the electric field with respect to the end portion of the gate structure 15 is relaxed, and as a result, the dielectric resistance is improved.

The semiconductor device 1 may include the gate wiring 60. The gate wiring 60 may be arranged on the first main surface 3 and electrically connected to the embedded electrode 18 at the end portion of the gate structure 15. According to this configuration, the dielectric resistance caused by the electric field with respect to the end portion of the gate structure 15 to which the gate wiring 60 is connected is improved.

The semiconductor device 1 may include the insulating interlayer film 65, the source pad electrode 70, and the gate finger electrode 81. The interlayer film 65 may cover the gate structure 15 and the gate wiring 60. The source pad electrode 70 may be arranged on the portion of the interlayer film 65 covering the gate structure 15. The gate finger electrode 81 may be arranged on the portion of the interlayer film 65 covering the gate wiring 60.

The semiconductor device 1 may include the first slit portion 82. The first slit portion 82 may be defined in the region between the source pad electrode 70 and the gate finger electrode 81, and may overlap the first main surface 3 in the lamination direction. According to this configuration, the first slit portion 82 is formed in a relatively flat portion of the interlayer film 65. As a result, the source pad electrode 70 and the gate finger electrode 81 are appropriately separated by the first slit portion 82.

From another point of view, the semiconductor device 1 includes the chip 2, the trench electrode type gate structure 15, and the surface insulating film 50. The chip 2 has the first main surface 3. The gate structure 15 is formed in the first main surface 3.

The surface insulating film 50 includes the first surface film portion 51 and the second surface film portion 52. The first surface film portion 51 covers the periphery of the gate structure 15 on the first main surface 3. The second surface film portion 52 covers the periphery of the first surface film portion 51 on the first main surface 3 and has the thickness greater than the thickness of the first surface film portion 51.

According to this arrangement, the semiconductor device 1 having a novel layout is provided. For example, according to the semiconductor device 1, the dielectric resistance in the periphery of the end portion of the gate structure 15 is improved by the first surface film portion 51, and the dielectric resistance in the periphery of the first surface film portion 51 is improved by the second surface film portion 52 having the thickness greater than that of the first surface film portion 51. Accordingly, dielectric resistance is improved.

The chip 2 may include SiC. According to this configuration, the semiconductor device 1 as an SiC semiconductor device having a novel layout is provided. According to the semiconductor device 1, the withstand voltage is further improved by the physical properties of SiC. In particular, in the case of the SiC semiconductor device, since the SiC semiconductor device is used under a relatively high voltage environment, the effect of improving the dielectric resistance by the second surface film portion 52 is effective.

The second surface film portion 52 may have the width greater than the width of the first surface film portion 51. According to this configuration, the dielectric resistance by the second surface film portion 52 is appropriately improved.

The semiconductor device 1 may include the gate wiring 60. The gate wiring 60 may be arranged on the first surface film portion 51 and electrically connected to the end portion of the gate structure 15. According to this configuration, the dielectric resistance between the chip 2 and the gate wiring 60 is improved by the first surface film portion 51.

The gate wiring 60 may be arranged on the second surface film portion 52 and have the portion opposing the first main surface 3 across the second surface film portion 52. According to this configuration, the dielectric resistance between the chip 2 and the gate wiring 60 is improved by the second surface film portion 52.

The coverage area of the gate wiring 60 with respect to the second surface film portion 52 is greater than the coverage area of the gate wiring 60 with respect to the first surface film portion 51. According to this configuration, the dielectric resistance between the chip 2 and the gate wiring 60 is appropriately improved by the second surface film portion 52.

The semiconductor device 1 may include the insulating interlayer film 65 and the gate finger electrode 81. The interlayer film 65 may cover the gate structure 15 and the gate wiring 60. The gate finger electrode 81 may be arranged on the portion of the interlayer film 65 covering the gate wiring 60.

The gate finger electrode 81 may be formed at an interval from the gate structure 15 toward the peripheral edge side of the chip 2. The portion of the interlayer film 65 covering the gate wiring 60 can be formed to be relatively flat because restriction of a design rule caused by the gate structure 15 can be avoided. Thus, the film forming property of the gate finger electrode 81 is improved on the interlayer film 65.

In this case, the gate finger electrode 81 may not oppose the gate structure 15 in the lamination direction. According to this configuration, the film forming property of the gate finger electrode 81 is appropriately improved. The gate finger electrode 81 may oppose the surface insulating film 50 across the gate wiring 60 and the interlayer film 65. According to this configuration, the dielectric resistance between the chip 2 and the gate finger electrode 81 is improved by the surface insulating film 50.

The gate finger electrode 81 may oppose the second surface film portion 52. According to this configuration, the dielectric resistance between the chip 2 and the gate finger electrode 81 is improved by the second surface film portion 52. The gate finger electrodes 81 may be formed at an interval from the first surface film portion 51 toward the peripheral edge portion side of the first main surface 3. According to this configuration, the dielectric resistance between the chip 2 and the gate finger electrode 81 is appropriately improved by the second surface film portion 52.

The semiconductor device 1 may include the source pad electrode 70. The source pad electrode 70 may be arranged on the portion of the interlayer film 65 covering the gate structure 15. In this case, the semiconductor device 1 may include the first slit portion 82. The first slit portion 82 may be defined in the region between the source pad electrode 70 and the gate finger electrode 81, and may overlap the first main surface 3 in the lamination direction.

According to this configuration, the first slit portion 82 is formed in a relatively flat portion of the interlayer film 65. As a result, the source pad electrode 70 and the gate finger electrode 81 are appropriately separated by the first slit portion 82.

The semiconductor device 1 may include the second semiconductor layer 7 (semiconductor device 1) of the n-type, the gate structure 15, and the outer well region 45 of the p-type. The second semiconductor layer 7 is formed in the surface layer portion of the first main surface 3. The gate structure 15 is formed in the first main surface 3 so as to be positioned in the second semiconductor layer 7. The outer well region 45 may be formed in the surface layer portion of the second semiconductor layer 7 in the periphery of the end portion of the gate structure 15.

According to this configuration, the depletion layer spreads from the outer well region 45 as a starting point in the periphery of the end portion of the gate structure 15. Accordingly, the electric field with respect to the end portion of the gate structure 15 is relaxed, and as a result, the dielectric resistance is improved. In this case, the surface insulating film 50 may cover the outer well region 45. According to this configuration, the electric field with respect to the surface insulating film 50 is relaxed, and as a result, the dielectric resistance is improved.

The first surface film portion 51 may cover the outer well region 45. According to this configuration, the electric field with respect to the first surface film portion 51 is relaxed, and as a result, the dielectric resistance is improved. The second surface film portion 52 may cover the outer well region 45. According to this configuration, the electric field with respect to the second surface film portion 52 is relaxed, and as a result, the dielectric resistance is improved.

The semiconductor device 1 may include the well region 30 of the p-type. The well region 30 may be formed below the gate structure 15 in the second semiconductor layer 7. According to this configuration, the depletion layer spreads from the well region 30 as a starting point. As a result, the electric field with respect to the gate structure 15 is relaxed, and as a result, the dielectric resistance is improved. The well region 30 may have the portion along the second film portion 21 of the insulating film 17.

The semiconductor device 1 may include the body region 10 of the p-type, the gate structure 15, and the contact region 42 of the p-type. The body region 10 may be formed in the surface layer portion of the first main surface 3. The gate structure 15 may be formed on the first main surface 3 so as to penetrate the body region 10. The contact region 42 may extend along the side wall of the gate structure 15 and electrically connect the well region 30 to the body region 10. According to this configuration, the electrical response characteristics of the well region 30 can be appropriately enhanced.

The semiconductor device 1 includes the chip 2, the trench electrode type gate structure 15, the gate wiring 60, the insulating interlayer film 65, the source pad electrode 70, the gate finger electrode 81, and the first slit portion 82. The chip 2 has the first main surface 3. The gate structure 15 is formed in the first main surface 3. The gate wiring 60 is arranged on the first main surface 3 and electrically connected to the end portion of the gate structure 15. The interlayer film 65 covers the gate structure 15 and the gate wiring 60.

The source pad electrode 70 is arranged on the interlayer film 65 and opposes the gate structure 15 and the gate wiring 60 across the interlayer film 65. The gate finger electrode 81 is arranged on the interlayer film 65 at an interval from the pad electrode, and opposes the gate wiring 60 across the interlayer film 65. The first slit portion 82 is defined in the region between the source pad electrode 70 and the gate finger electrode 81, and overlaps the first main surface 3 in the lamination direction.

According to this arrangement, the semiconductor device 1 having a novel layout is provided. For example, according to the semiconductor device 1, the portion of the interlayer film 65 covering the gate wiring 60 can be formed relatively flat because the restriction of the design rule caused by the gate structure 15 can be avoided. Therefore, the first slit portion 82 can be formed in a relatively flat portion of the interlayer film 65. As a result, the source pad electrode 70 and the gate finger electrode 81 are appropriately electrically separated by the first slit portion 82 on the interlayer film 65.

The chip 2 may include SiC. According to this configuration, the semiconductor device 1 as an SiC semiconductor device having a novel layout is provided. According to the semiconductor device 1, the withstand voltage is further improved by the physical properties of SiC. In particular, in the case of the SiC semiconductor device, since the SiC semiconductor device is used under a relatively high voltage environment, a configuration in which the source pad electrode 70 and the gate finger electrode 81 to which different potentials are applied are appropriately electrically separated by the first slit portion 82 is effective.

The first slit portion 82 may not overlap the gate structure 15 in the lamination direction. According to this configuration, the flat portion of the interlayer film 65 is appropriately exposed from the first slit portion 82. As a result, the source pad electrode 70 and the gate finger electrode 81 are appropriately electrically separated.

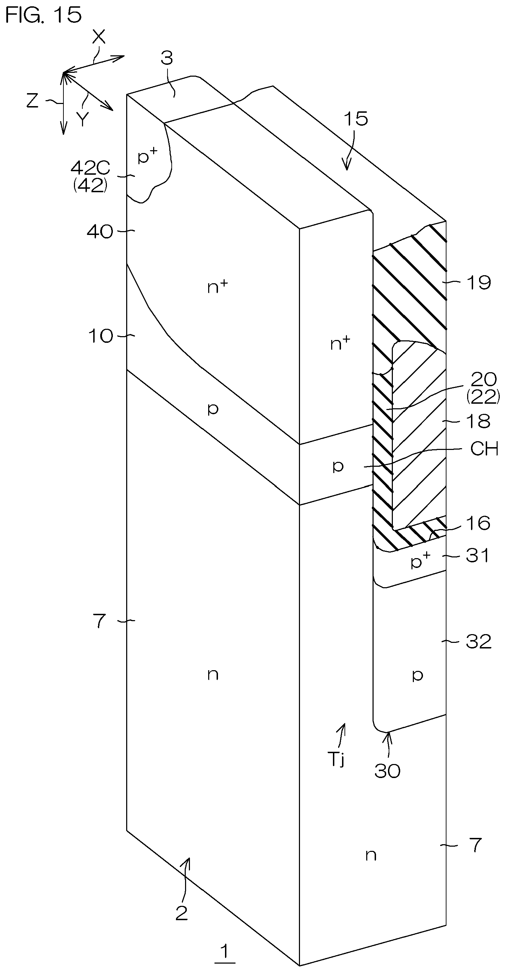

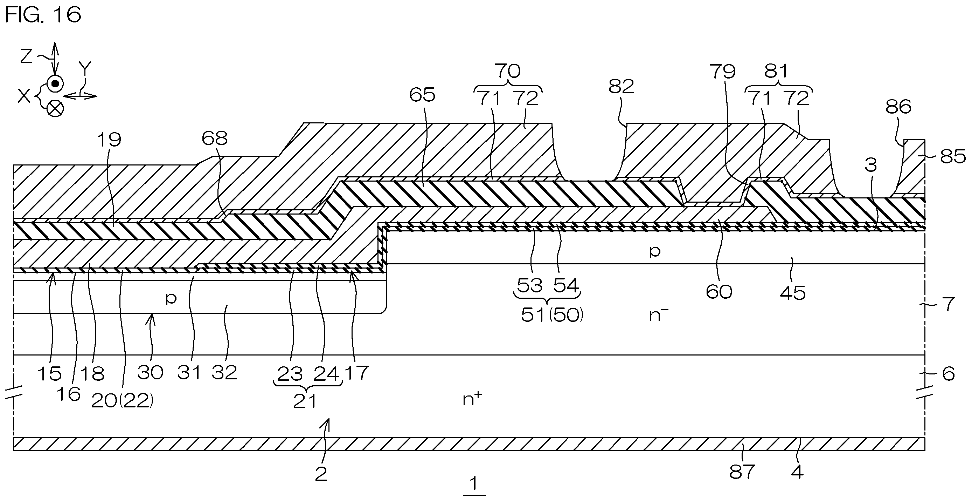

Hereinafter, the modification examples applied to the semiconductor device 1 will be described. FIGS. 15 to 20 are cross-sectional perspective views illustrating the first to sixth modification examples of the semiconductor device 1. FIG. 15 is a cross-sectional perspective view illustrating a first modification example of the semiconductor device 1. FIGS. 16 to 20 are cross-sectional views illustrating the second to sixth modification examples of the semiconductor device 1.

The semiconductor device 1 can include any one of the features of the first to sixth modification examples. The first to sixth modification examples can be appropriately combined therebetween. Therefore, the semiconductor device 1 can simultaneously include at least two of the features of the first to sixth modification examples in the same cross-sectional region or different cross-sectional regions.

With reference to FIG. 15 (first modification example), the semiconductor device 1 may include the insulating film 17 having an upper end portion formed at an interval from the height position of the first main surface 3 to the bottom wall side of the trench 16. The upper end portion of the insulating film 17 may expose the chip 2 from the side wall and the opening end of the trench 16.

The electrode surface of the embedded electrode 18 may project further to the first main surface 3 side than the upper end portion of the insulating film 17. The electrode surface of the embedded electrode 18 may be positioned closer to the bottom wall side of the trench 16 than the upper end portion of the insulating film 17. The embedded insulator 19 may be embedded on the upper end portion of the insulating film 17 and the electrode surface of the embedded electrode 18 in the trench 16.

The embedded insulator 19 may cover the upper end portion of the insulating film 17 and the electrode surface of the embedded electrode 18. The embedded insulator 19 may have a portion directly covering the side wall of the trench 16. The body region 10, the source region 40, and the contact region 42 may each have a portion in direct contact with the embedded insulator 19 in a portion along the gate structure 15.

With reference to FIG. 16 (second modification example), the semiconductor device 1 does not necessarily have the second surface film portion 52. In this case, the surface insulating film 50 may have a laminated structure including the first surface insulating film 53 and the second surface insulating film 54.

The first surface insulating film 53 directly covers the first main surface 3 in the periphery of the end portions of the plurality of gate structures 15. The first surface insulating film 53 is connected to the second insulating film 23 at the end portions of the plurality of gate structures 15, and exposes the embedded electrode 18 and the embedded insulator 19. The first surface insulating film 53 has a portion positioned in the region between the plurality of gate structures 15. The first surface insulating film 53 is connected to the second insulating film 23 in both the portion extending in the first direction X and the portion extending in the second direction Y among the end portions of the plurality of gate structures 15.

The first surface insulating film 53 is formed in a region between the peripheral edge of the first main surface 3 and the end portion of the gate structure 15, and directly covers the outer well region 45 and the plurality of field regions 47 in a film shape. The first surface insulating film 53 is continuous with the first to fourth side surfaces 5A to 5D. The first surface insulating film 53 may be formed at an interval inward from the first to fourth side surfaces 5A to 5D, and may expose the peripheral edge portion of the first main surface 3.

The second surface insulating film 54 directly covers the first surface insulating film 53 in the periphery of the end portions of the plurality of gate structures 15. The second surface insulating film 54 is connected to the third insulating film 24 of the insulating film 17 at the end portions of the plurality of gate structures 15, and exposes the embedded electrode 18 and the embedded insulator 19.

The second surface insulating film 54 has a portion positioned in the region between the plurality of gate structures 15. The second surface insulating film 54 is connected to the third insulating film 24 in both the portion extending in the first direction X and the portion extending in the second direction Y among the end portions of the plurality of gate structures 15.

The second surface insulating film 54 is formed in a region between the peripheral edge of the first main surface 3 and the end portion of the gate structure 15, and covers the outer well region 45 and the plurality of field regions 47 across the first surface insulating film 53.

The second surface insulating film 54 covers the outer well region 45 and the plurality of field regions 47 across the first surface film portion 51. The second surface insulating film 54 is continuous with the first to fourth side surfaces 5A to 5D. The second surface insulating film 54 may be formed at an interval inward from the first to fourth side surfaces 5A to 5D, and may expose any one or both of the peripheral edge portion of the first main surface 3 and the first surface insulating film 53.

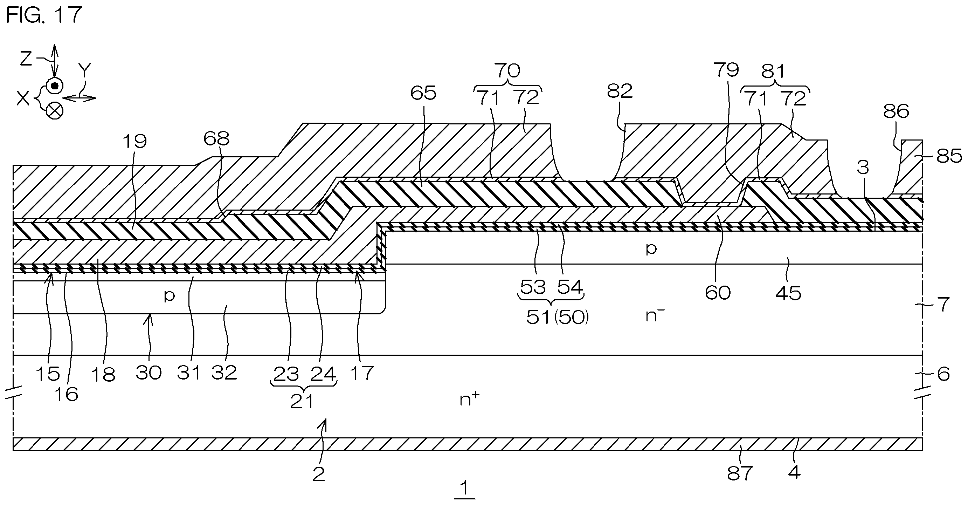

With reference to FIG. 17 (third modification example), the semiconductor device 1 has a layout obtained by modifying the configuration of the insulating film 17 in the second modification example. Specifically, the insulating film 17 has a laminated structure including the second insulating film 23 and the third insulating film 24, and does not have the first insulating film 22.

In this embodiment, the second insulating film 23 covers the side wall and the bottom wall of the trench 16 at the inner portion and the end portion of the gate structure 15. In this embodiment, the third insulating film 24 covers the side wall and the bottom wall of the trench 16 across the second insulating film 23 at the inner portion and the end portion of the gate structure 15.

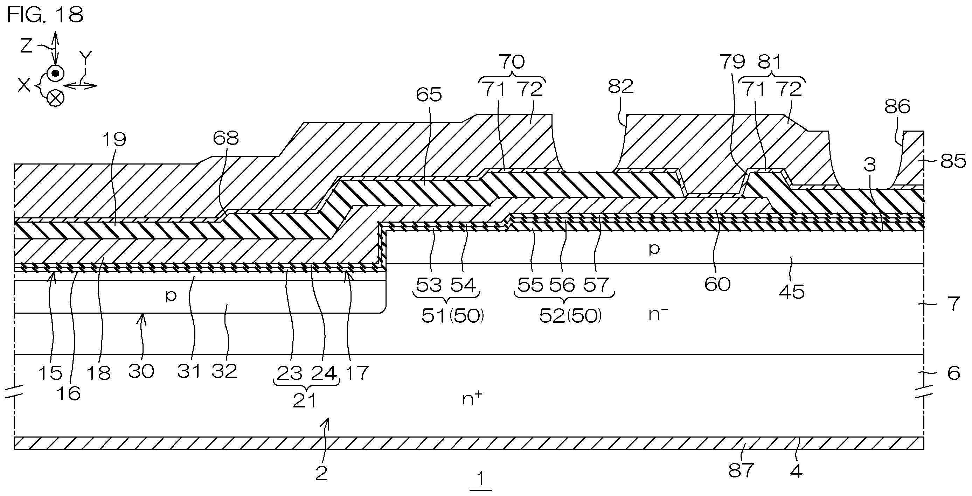

With reference to FIG. 18 (fourth modification example), the semiconductor device 1 does not necessarily have the first film portion 20 of the insulating film 17. In this case, in the semiconductor device 1, the insulating film 17 may include the second film portion 21. That is, the insulating film 17 may have a laminated structure including the second insulating film 23 and the third insulating film 24, and may not have the first insulating film 22.

In this embodiment, the second insulating film 23 covers the side wall and the bottom wall of the trench 16 at the inner portion and the end portion of the gate structure 15. In this embodiment, the third insulating film 24 covers the side wall and the bottom wall of the trench 16 across the second insulating film 23 at the inner portion and the end portion of the gate structure 15.

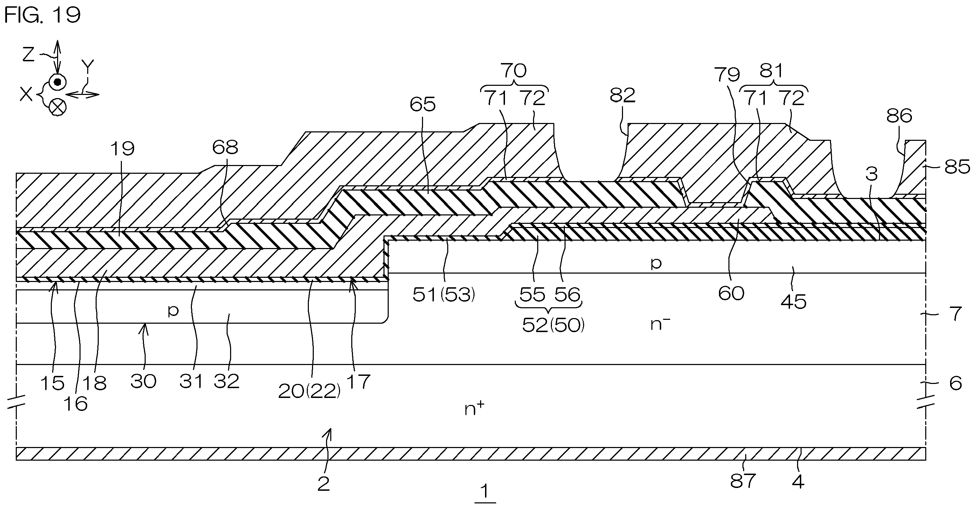

With reference to FIG. 19 (fifth modification example), the semiconductor device 1 does not necessarily have the second film portion 21 of the insulating film 17. In this case, in the semiconductor device 1, the insulating film 17 may have a single layer structure consisting of the first insulating film 22. In this embodiment, the first insulating film 22 covers the side wall and the bottom wall of the trench 16 at the inner portion and the end portion of the gate structure 15.

The surface insulating film 50 includes the first surface film portion 51 and the second surface film portion 52. In this embodiment, the first surface insulating film 53 has a single layer structure consisting of the first surface insulating film 53. The first surface insulating film 53 covers the periphery of the end portion of the gate structure 15 and is connected to the first insulating film 22. That is, the first surface insulating film 53 is formed integrally with the first insulating film 22.

In this embodiment, the second surface film portion 52 has a laminated structure including the third surface insulating film 55 and the fourth surface insulating film 56. The third surface insulating film 55 is formed in a layout similar to that in the above-described embodiment. The fourth surface insulating film 56 directly covers the third surface insulating film 55 and is connected to the first surface insulating film 53. That is, the fourth surface insulating film 56 is formed integrally with the first insulating film 22 and the first surface insulating film 53.

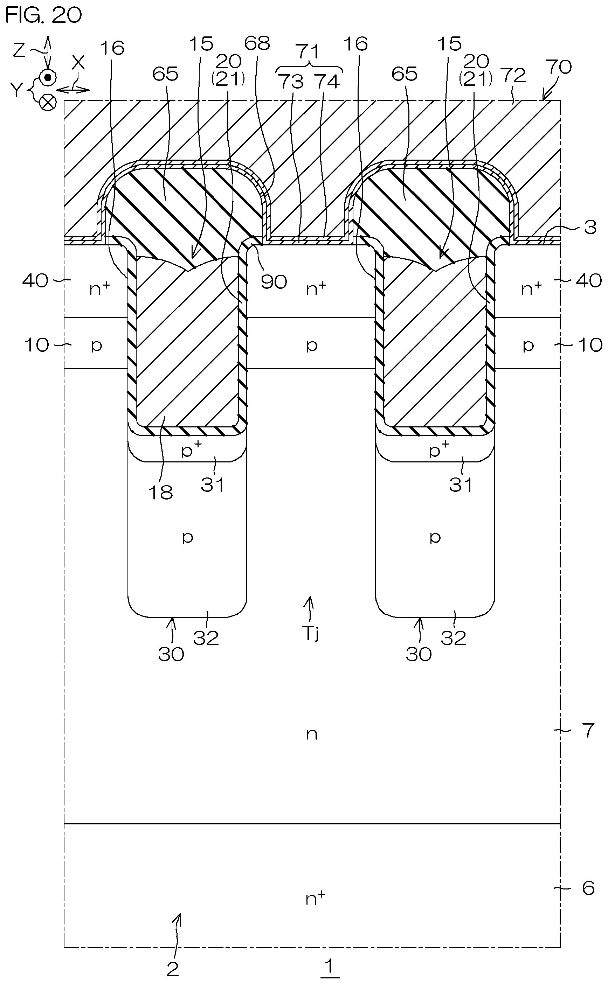

With reference to FIG. 20 (sixth modification example), the semiconductor device 1 does not include the embedded insulator 19 in the plurality of gate structures 15. The surface insulating film 50 includes an active insulating film 90 that selectively covers the first main surface 3 in the active region 8.

The active insulating film 90 may include at least one of a silicon oxide film, a silicon nitride film, and a silicon oxynitride film. The active insulating film 90 may include an insulator that is the same as or different from the first insulating film 22. The active insulating film 90 may include an insulator that is the same as or different from the second insulating film 23. The active insulating film 90 may include an insulator that is the same as or different from the third insulating film 24.

The active insulating film 90 may include an insulator that is the same as or different from the first surface insulating film 53. The active insulating film 90 may include an insulator that is the same as or different from the second surface insulating film 54. The active insulating film 90 may include an insulator that is the same as or different from the third surface insulating film 55. The active insulating film 90 may include an insulator that is the same as or different from the fourth surface insulating film 56. The active insulating film 90 may include an insulator that is the same as or different from the fifth surface insulating film 57.

In this embodiment, the active insulating film 90 has a single layer structure consisting of a silicon oxide film. The silicon oxide film may consist of an NSG film, a PSG film, or a BPSG film. The active insulating film 90 preferably includes an oxide other than the oxide of the chip 2. In this embodiment, the active insulating film 90 is consisting of an NSG film.

The active insulating film 90 directly covers the first main surface 3 (the plurality of mesa portions 27) in the periphery of the inner portions of the plurality of gate structures 15 and is connected to the plurality of insulating films 17. Specifically, the active insulating film 90 is connected to the plurality of first insulating films 22 and exposes the plurality of embedded electrodes 18. The first surface insulating film 53 directly covers the plurality of source regions 40 and the plurality of contact regions 42. The first surface film portion 51 is connected to the third insulating film 24 and the second surface insulating film 54 at the end portions of the plurality of gate structures 15.

In this embodiment, the active insulating film 90 is consisting of the same insulating film as the first insulating film 22, the third insulating film 24, the second surface insulating film 54, and the fourth surface insulating film 56. That is, the active insulating film 90 is formed integrally with the first insulating film 22 and the third insulating film 24, and is formed as a lead-out portion of the first insulating film 22 and the third insulating film 24 led out from the trench 16 onto the first main surface 3.

A thickness of the active insulating film 90 may be greater than or less than the first thickness of the first film portion 20. The thickness of the active insulating film 90 may be greater than or less than the second thickness of the second film portion 21. The thickness of the active insulating film 90 may be less than the thickness of the second insulating film 23. The thickness of the active insulating film 90 may be greater than or less than the thickness of the third insulating film 24.

The thickness of the active insulating film 90 may be greater than or less than the third thickness of the first surface film portion 51. The thickness of the active insulating film 90 may be greater than or less than the fourth thickness of the second surface film portion 52. The thickness of the active insulating film 90 may be greater than or less than the thickness of the first surface insulating film 53. The thickness of the active insulating film 90 may be greater than or less than the thickness of the second surface insulating film 54.

The thickness of the active insulating film 90 may be greater than or less than the thickness of the third surface insulating film 55. The thickness of the active insulating film 90 may be greater than or less than the thickness of the fourth surface insulating film 56. The thickness of the active insulating film 90 may be greater than or less than the thickness of the fifth surface insulating film 57.

The thickness of the active insulating film 90 is substantially equal to the thickness of the first insulating film 22, the thickness of the third insulating film 24, the thickness of the second surface insulating film 54, and the thickness of the fourth surface insulating film 56. The thickness of the active insulating film 90 may be not less than 10 nm and not more than 250 nm. The thickness of the active insulating film 90 may have a value belonging to at least one range among not less than 10 nm and not more than 25 nm, not less than 25 nm and not more than 50 nm, not less than 50 nm and not more than 75 nm, not less than 75 nm and not more than 100 nm, not less than 100 nm and not more than 125 nm, not less than 125 nm and not more than 150 nm, not less than 150 nm and not more than 175 nm, not less than 175 nm and not more than 200 nm, not less than 200 nm and not more than 225 nm, and not less than 225 nm and not more than 250 nm.

In this embodiment, the interlayer film 65 collectively covers the plurality of gate structures 15 in the active region 8.

The interlayer film 65 collectively covers the plurality of gate structures 15 and the active insulating film 90 in a film shape in the active region 8. The interlayer film 65 enters the trench 16 from above the active insulating film 90, and covers the embedded electrode 18, the first insulating film 22, the second insulating film 23, and the third insulating film 24 in the trench 16. The interlayer film 65 has a portion covering the plurality of source regions 40 and the plurality of contact regions 42 across the active insulating film 90.

In this embodiment, the semiconductor device 1 includes a plurality of source openings 68 formed in the interlayer film 65. The plurality of source openings 68 penetrate the interlayer film 65 and the active insulating film 90 and selectively expose the plurality of mesa portions 27. The plurality of source openings 68 may be formed in a one-to-one correspondence with one mesa portion 27.

In this case, the plurality of source openings 68 are formed in a band shape extending in the second direction Y following the extension direction of the corresponding mesa portion 27. The plurality of source openings 68 selectively expose the plurality of source regions 40 and the plurality of contact regions 42 from the corresponding mesa portion 27.

As a matter of course, the plurality of source openings 68 may be formed in a multiple-to-one correspondence with one mesa portion 27. In this case, the plurality of source openings 68 are formed at intervals following the extension direction of the corresponding mesa portion 27.

The plurality of source openings 68 may be formed in a band shape, a quadrangular shape, a circular shape, or the like extending in the second direction Y. The plurality of source openings 68 selectively expose the plurality of source regions 40 and the plurality of contact regions 42 from the corresponding mesa portion 27.

The source pad electrode 70 enters the plurality of source openings 68 from above the interlayer film 65, and is electrically connected to the plurality of source regions 40 and the plurality of contact regions 42 in the plurality of source openings 68.

The source pad electrode 70 includes one or both of the lower electrode film 71 and the main electrode film 72. The lower electrode film 71 has the laminated structure including the first electrode film 73 and the second electrode film 74. As a matter of course, the lower electrode film 71 may have the single layer structure consisting of the first electrode film 73.

The first electrode film 73 collectively covers the region of the interlayer film 65 where the plurality of source openings 68 are formed in a film shape, and enters the plurality of source openings 68 from above the interlayer film 65. The first electrode film 73 has a portion covering the insulating surface of the interlayer film 65 in a film shape, a portion covering the wall surfaces of the plurality of source openings 68 in a film shape, and a portion covering the first main surface 3 in a film shape in the plurality of source openings 68. The first electrode film 73 is mechanically and electrically connected to the plurality of source regions 40 and the plurality of contact regions 42.

The second electrode film 74 directly covers the first electrode film 73. The second electrode film 74 collectively covers the region where the plurality of source openings 68 are formed in the interlayer film 65 in a film shape across the first electrode film 73, and enters the plurality of source openings 68 from above the interlayer film 65.

The second electrode film 74 has a portion covering the insulating surface of the interlayer film 65 in a film shape across the first electrode film 73, a portion covering the wall surfaces of the plurality of source openings 68 in a film shape across the first electrode film 73, and a portion covering the first main surface 3 in a film shape across the first electrode film 73 in the plurality of source openings 68. The second electrode film 74 is electrically connected to the plurality of source regions 40 and the plurality of contact regions 42 via the first electrode film 73 in the source opening 68.

The main electrode film 72 directly covers the lower electrode film 71 (second electrode film 74). The main electrode film 72 collectively covers the region of the interlayer film 65 where the plurality of source openings 68 are formed in a film shape, and backfills the plurality of source openings 68.

The main electrode film 72 has a portion covering the insulating surface of the interlayer film 65 across the lower electrode film 71, a portion covering the wall surfaces of the plurality of source openings 68 across the lower electrode film 71, and a portion covering the first main surface 3 across the lower electrode film 71. The main electrode film 72 is electrically connected to the plurality of source regions 40 and the plurality of contact regions 42 via the lower electrode film 71 in the plurality of source openings 68.

Each of the above-described embodiments (including modification examples) can be implemented in still other embodiments. For example, in each of the embodiments described above, the chip 2 including SiC monocrystal is adopted. However, the chip 2 may include a silicon monocrystal instead. The first semiconductor layer 6 may contain a silicon monocrystal. The second semiconductor layer 7 may contain a silicon monocrystal.

In each of the embodiments described above, a structure in which the conductivity type of a semiconductor region of the "n-type" is inverted to the "p-type" and the conductivity type of a semiconductor region of the "p-type" is inverted to the "n-type" may be adopted. The specific arrangement in this case is obtained by replacing "n-type" with "p-type" and replacing "p-type" with "n-type" at the same time in the above description and attached drawings.

In each of the embodiments described above, a collector region of the p-type may be formed in the surface layer portion of the second main surface 4 of the chip 2. In this case, the transistor structure Tr includes an IGBT (insulated gate bipolar transistor) structure in place of the MISFET structure. The specific arrangement in this case is obtained by replacing the "source" of the MISFET structure with an "emitter" of the IGBT structure and replacing the "drain" of the MISFET structure with a "collector" of the IGBT structure in the above description. In this case, the chip 2 may have a single layer structure consisting of a semiconductor substrate of the n-type.

Hereinafter, examples of features extracted from the present description and the drawings shall be indicated below. Hereinafter, the alphanumeric characters, etc., in parentheses represent the corresponding constituent elements, etc., in the embodiment described above, but are not intended to limit the scope of each clause to the embodiment. The "semiconductor device" in the following clauses may be replaced with an "SiC semiconductor device," a "wide bandgap semiconductor device," a "semiconductor switching device," a "MISFET device," an "IGBT device," a "semiconductor rectifier," and the like, as needed.

[A1] A semiconductor device (1) comprising: a chip (2) having a main surface (3); and a gate structure (15) of a trench electrode type formed in the main surface (3); wherein the gate structure (15) includes: a trench (16) formed in the main surface (3), an insulating film (17) including a first film portion (20) that covers a wall surface of an inner portion of the trench (16), and a second film portion (21) that covers a wall surface of an end portion of the trench (16) and has a thickness greater than a thickness of the first film portion (20), and an embedded electrode (18) embedded in the trench (16) with the insulating film (17) interposed therebetween.

[A2] The semiconductor device (1) according to A1, wherein the chip (2) contains SiC.

[A3] The semiconductor device (1) according to A1 or A2, wherein the second film portion (21) covers a side wall and a bottom wall of the trench (16).

[A4] The semiconductor device (1) according to any one of A1 to A3, wherein a coverage area of the second film portion (21) with respect to the trench (16) is less than a coverage area of the first film portion (20) with respect to the trench (16).

[A5] The semiconductor device (1) according to any one of A1 to A4, wherein the embedded electrode (18) is embedded in the trench (16) at an interval from the main surface (3) toward a bottom wall side of the trench (16).

[A6] The semiconductor device (1) according to A5, wherein the gate structure (15) includes an embedded insulator (19) embedded above the embedded electrode (18) in the trench (16).

[A7] The semiconductor device (1) according to A6, wherein the embedded insulator (19) is embedded in the trench (16) at an interval from the main surface (3) toward the bottom wall side of the trench (16).

[A8] The semiconductor device (1) according to any one of A1 to A7, further comprising: a surface insulating film (50) that covers the main surface (3) in a periphery of the end portion of the gate structure (15) and is connected to the insulating film (17).

[A9] The semiconductor device (1) according to A8, wherein the surface insulating film (50) includes: a first surface film portion (51) that covers a periphery of the end portion of the gate structure (15) and has a thickness greater than a thickness of the first film portion (20) of the insulating film (17), and a second surface film portion (52) that covers a periphery of the first surface film portion (51) and has a thickness greater than a thickness of the second film portion (21) of the insulating film (17).

[A10] The semiconductor device (1) according to A8 or A9, further comprising: a semiconductor layer (7) of a first conductivity type (n-type) formed in a surface layer portion of the main surface (3); the gate structure (15) formed in the main surface (3) so as to be positioned within the semiconductor layer (7); and an outer well region (45) of a second conductivity type (p-type) formed in the surface layer portion of the semiconductor layer (7) in a periphery of the end portion of the gate structure (15); wherein the surface insulating film (50) covers the outer well region (45).

[A11] The semiconductor device (1) according to any one of A1 to A7, further comprising: a semiconductor layer (7) of a first conductivity type (n-type) formed in a surface layer portion of the main surface (3); the gate structure (15) formed in the main surface (3) so as to be positioned within the semiconductor layer (7); and an outer well region (45) of a second conductivity type (p-type) formed in the surface layer portion of the semiconductor layer (7) in a periphery of the end portion of the gate structure (15).

[A12] The semiconductor device (1) according to A11, wherein the outer well region (45) has a portion along the second film portion (21).

[A13] The semiconductor device (1) according to any one of A1 to A7, further comprising: a semiconductor layer (7) of a first conductivity type (n-type) formed in a surface layer portion of the main surface (3); the gate structure (15) formed in the main surface (3) so as to be positioned within the semiconductor layer (7); and a well region (30) of a second conductivity type (p-type) formed below the gate structure (15) in the semiconductor layer (7).

[A14] The semiconductor device (1) according to A13, wherein the well region (30) has a portion along the second film portion (21) of the insulating film (17).

[A15] The semiconductor device (1) according to A13 or A14, further comprising: a body region (10) of the second conductivity type (p-type) formed in a surface layer portion of the main surface (3); the gate structure (15) formed in the main surface (3) so as to penetrate the body region (10); and a contact region (42) of the second conductivity type (p-type) extending along a side wall of the gate structure (15) and electrically connecting the well region (30) to the body region (10).

[A16] The semiconductor device (1) according to any one of A13 to A15, further comprising: an outer well region (45) of the second conductivity type (p-type) formed in a surface layer portion of the semiconductor layer (7) in a periphery of an end portion of the gate structure (15).

[A17] The semiconductor device (1) according to any one of A1 to A7, further comprising: a semiconductor layer (7) of a first conductivity type (n-type) formed in a surface layer portion of the main surface (3); and a high concentration region of the first conductivity type (n-type) formed on a side of the gate structure (15) in the semiconductor layer (7) and having an impurity concentration higher than an impurity concentration of the semiconductor layer (7).

[A18] The semiconductor device (1) according to any one of A1 to A17, further comprising: a gate wiring (60) arranged at a periphery of the end portion of the gate structure (15) on the main surface (3) and electrically connected to the gate structure (15).

[A19] The semiconductor device (1) according to A18, further comprising: an interlayer film (65) having insulating properties and covering the gate structure (15) and the gate wiring (60); a pad electrode (70) arranged on a portion of the interlayer film (65) that covers the gate structure (15); and a gate finger electrode (81) arranged on a portion of the interlayer film (65) that covers the gate wiring (60).

[A20] The semiconductor device (1) according to A19, further comprising: a slit portion (82) that is defined in a region between the pad electrode (70) and the gate finger electrode (81) and overlaps the main surface (3) in a lamination direction.

[B1] A semiconductor device (1) comprising: a chip (2) having a main surface (3); a gate structure (15) of a trench electrode type formed in the main surface (3); and a surface insulating film (50) including a first surface film portion (51) that covers a periphery of the gate structure (15) on the main surface (3), and a second surface film portion (52) that covers a periphery of the first surface film portion (51) on the main surface (3) and has a thickness greater than a thickness of the first surface film portion (51).

[B2] The semiconductor device (1) according to B1, wherein the chip (2) contains SiC.

[B3] The semiconductor device (1) according to B1 or B2, wherein the second surface film portion (52) has a width greater than a width of the first surface film portion (51).

[B4] The semiconductor device (1) according to any one of B1 to B3, further comprising: a gate wiring (60) arranged on the first surface film portion (51) and electrically connected to an end portion of the gate structure (15).

[B5] The semiconductor device (1) according to B4, wherein the gate wiring (60) has a portion opposing the main surface (3) with the second surface film portion (52) interposed therebetween.

[B6] The semiconductor device (1) according to B4 or B5, wherein a coverage area of the gate wiring (60) with respect to the second surface film portion (52) is greater than a coverage area of the gate wiring (60) with respect to the first surface film portion (51).

[B7] The semiconductor device (1) according to any one of B4 to B6, further comprising: an interlayer film (65) having insulating properties and covering the gate structure (15) and the gate wiring (60); and a gate finger electrode (81) arranged on a portion of the interlayer film (65) covering the gate wiring (60).

[B8] The semiconductor device (1) according to B7, wherein the gate finger electrode (81) is formed at an interval from an end portion of the gate structure (15) toward a peripheral edge side of the chip (2).

[B9] The semiconductor device (1) according to B7 or B8, wherein the gate finger electrode (81) does not overlap the gate structure (15) in a lamination direction.

[B10] The semiconductor device (1) according to B7 to B9, wherein the gate finger electrode (81) opposes the surface insulating film (50) with the gate wiring (60) and the interlayer film (65) interposed therebetween.

[B11] The semiconductor device (1) according to B7 to B10, wherein the gate finger electrode (81) opposes the second surface film portion (52).

[B12] The semiconductor device (1) according to B7 to B11, wherein the gate finger electrode (81) is formed at an interval from the first surface film portion (51) toward a peripheral edge portion side of the main surface (3).

[B13] The semiconductor device (1) according to any one of B7 to B12, further comprising: a pad electrode (70) arranged on a portion of the interlayer film (65) covering the gate structure (15).

[B14] The semiconductor device (1) according to B13, further comprising: a slit portion (82) that is defined in a region between the pad electrode (70) and the gate finger electrode (81) and overlaps the main surface (3) in a lamination direction.

[B15] The semiconductor device (1) according to any one of B1 to B14, further comprising: a semiconductor layer (7) of a first conductivity type (n-type) formed in a surface layer portion of the main surface (3); and the gate structure (15) formed in the main surface (3) so as to be positioned within the semiconductor layer (7).

[B16] The semiconductor device (1) according to B15, further comprising: an outer well region (45) of a second conductivity type (p-type) formed in a surface layer portion of the semiconductor layer (7) in a periphery of an end portion of the gate structure (15), wherein the surface insulating film (50) covers the outer well region (45).

[B17] The semiconductor device (1) according to B16, wherein the first surface film portion (51) covers the outer well region (45).

[B18] The semiconductor device (1) according to B16 or B17, wherein the second surface film portion (52) covers the outer well region (45).

[B19] The semiconductor device (1) according to any one of B15 to B18, further comprising: a well region (30) of a second conductivity type (p-type) formed below the gate structure (15) in the semiconductor layer (7).

[B20] The semiconductor device (1) according to B19, further comprising: a body region (10) of the second conductivity type (p-type) formed in a surface layer portion of the main surface (3); the gate structure (15) formed in the main surface (3) so as to penetrate the body region (10); and a contact region (42) of the second conductivity type (p-type) extending along a side wall of the gate structure (15) and electrically connecting the well region (30) to the body region (10).

[C1] A semiconductor device (1) comprising: a chip (2) having a main surface (3); a gate structure (15) of a trench electrode type formed in the main surface (3); a gate wiring (60) electrically connected to an end portion of the gate structure (15) on the main surface (3); an interlayer film (65) having insulating properties and covering the gate structure (15) and the gate wiring (60); a pad electrode (70) arranged on the interlayer film (65) and opposing the gate structure (15) and the gate wiring (60) with the interlayer film (65) interposed therebetween; a gate finger electrode (81) arranged on the interlayer film (65) at an interval from the pad electrode (70) and opposing the gate wiring (60) with the interlayer film (65) interposed therebetween; and a slit portion (82) that is defined in a region between the pad electrode (70) and the gate finger electrode (81) and overlaps the main surface (3) in a lamination direction.

[C2] The semiconductor device (1) according to C1, wherein the chip (2) contains SiC.

[C3] The semiconductor device (1) according to C1 or C2, wherein the slit portion (82) does not overlap the gate structure (15) in the lamination direction.

While a specific embodiment of the present invention has been described in detail above, this is merely a specific example used to clarify the technical contents. The various technical ideas extracted from this Description can be combined as appropriate with each other without being limited by the order of description, the order of configuration examples, the order of modification examples, etc., in this Description.

### Reference Signs List

- 1: Semiconductor device
- 2: Chip
- 3: First main surface (main surface)
- 7: Second semiconductor layer (semiconductor layer)
- 10: Body region
- 15: Gate structure
- 16: Trench
- 17: Insulating film
- 18: Embedded electrode
- 19: Embedded insulator
- 20: First film portion
- 21: Second film portion
- 30: Well region
- 42: Contact region
- 45: Outer well region
- 50: Surface insulating film
- 51: First surface film portion
- 52: Second surface film portion
- 60: Gate wiring
- 65: Interlayer film
- 70: Source pad electrode (pad electrode)
- 81: Gate finger electrode
- 82: First slit portion (slit portion)

## Claims

1. A semiconductor device comprising:
a chip having a main surface; and
a gate structure of a trench electrode type formed in the main surface,
wherein the gate structure includes:
a trench formed in the main surface,
an insulating film including a first film portion that covers a wall surface of an inner portion of the trench, and a second film portion that covers a wall surface of an end portion of the trench and has a thickness greater than a thickness of the first film portion, and
an embedded electrode embedded in the trench across the insulating film.

2. The semiconductor device according to Claim 1,
wherein the chip includes SiC.

3. The semiconductor device according to Claim 1 or 2, further comprising:
a surface insulating film that covers the main surface in the periphery of the end portion of the gate structure and is connected to the insulating film.

4. The semiconductor device according to Claim 3,
wherein the surface insulating film includes:
a first surface film portion that covers a periphery of the end portion of the gate structure and has a thickness greater than a thickness of the first film portion of the insulating film, and
a second surface film portion that covers a periphery of the first surface film portion and has a thickness greater than a thickness of the second film portion of the insulating film.

5. The semiconductor device according to any one of Claims 1 to 4, further comprising:
a semiconductor layer of a first conductivity type formed in a surface layer portion of the main surface;
the gate structure formed in the main surface so as to be positioned within the semiconductor layer; and
an outer well region of a second conductivity type formed in the surface layer portion of the semiconductor layer in a periphery of the end portion of the gate structure.

6. The semiconductor device according to Claim 5,
wherein the outer well region has a portion along the second film portion.

7. The semiconductor device according to any one of Claims 1 to 6, further comprising:
a semiconductor layer of a first conductivity type formed in a surface layer portion of the main surface;
the gate structure formed in the main surface so as to be positioned within the semiconductor layer; and
a well region of a second conductivity type formed below the gate structure in the semiconductor layer.

8. The semiconductor device according to Claim 7,
wherein the well region has a portion along the second film portion of the insulating film.

9. The semiconductor device according to any one of Claims 1 to 8, further comprising:
a gate wiring arranged at a periphery of the end portion of the gate structure on the main surface and electrically connected to the gate structure.

10. The semiconductor device according to Claim 9, further comprising:
an interlayer film having insulating properties and covering the gate structure and the gate wiring;
a pad electrode arranged on a portion of the interlayer film that covers the gate structure;
and
a gate finger electrode arranged on a portion of the interlayer film that covers the gate wiring.

11. The semiconductor device according to Claim 10, further comprising:
a slit portion that is defined in a region between the pad electrode and the gate finger electrode and overlaps the main surface in a lamination direction.

12. A semiconductor device comprising:
a chip having a main surface;
a gate structure of a trench electrode type formed in the main surface; and
a surface insulating film including a first surface film portion that covers a periphery of the gate structure on the main surface, and a second surface film portion that covers a periphery of the first surface film portion on the main surface and has a thickness greater than a thickness of the first surface film portion.

13. The semiconductor device according to Claim 12, further comprising:
a gate wiring that has a portion opposing the main surface across the first surface film portion and is electrically connected to the gate structure.

14. The semiconductor device according to Claim 13,
wherein the gate wiring has a portion opposing the main surface across the second surface film portion.

15. The semiconductor device according to Claim 13 or 14, further comprising:
an interlayer film having insulating properties and covering the gate structure and the gate wiring; and
a gate finger electrode arranged on a portion of the interlayer film that covers the gate wiring.

16. The semiconductor device according to Claim 15, further comprising:
a pad electrode arranged on a portion of the interlayer film that covers the gate structure;
and
a slit portion that is defined in a region between the pad electrode and the gate finger electrode and overlaps the main surface in a lamination direction.

17. The semiconductor device according to any one of Claims 12 to 16, further comprising:
a semiconductor layer of a first conductivity type formed in a surface layer portion of the main surface;
the gate structure formed in the main surface so as to be positioned within the semiconductor layer; and
an outer well region of a second conductivity type formed in the surface layer portion of the semiconductor layer in a periphery of the end portion of the gate structure; and
wherein the surface insulating film covers the outer well region.

18. The semiconductor device according to any one of Claims 12 to 17, further comprising:
a semiconductor layer of a first conductivity type formed in a surface layer portion of the main surface;
the gate structure formed in the main surface so as to be positioned within the semiconductor layer; and
a well region of a second conductivity type formed below the gate structure in the semiconductor layer.

19. The semiconductor device according to Claim 18, further comprising:
a body region of the second conductivity type formed in a surface layer portion of the main surface;
the gate structure formed in the main surface so as to penetrate the body region; and
a contact region of the second conductivity type extending along a side wall of the gate structure and electrically connecting the well region to the body region.

20. A semiconductor device comprising:
a chip having a main surface;
a gate structure of a trench electrode type formed in the main surface;
a gate wiring electrically connected to an end portion of the gate structure on the main surface;
an interlayer film having insulating properties and covering the gate structure and the gate wiring;
a pad electrode arranged on the interlayer film and opposing the gate structure and the gate wiring across the interlayer film;
a gate finger electrode arranged on the interlayer film at an interval from the pad electrode and opposing the gate wiring across the interlayer film; and
a slit portion that is defined in a region between the pad electrode and the gate finger electrode and overlaps the main surface in a lamination direction.
